(19)

**Europäisches Patentamt**
**European Patent Office**
**Office européen des brevets**

(11)  **EP 4 704 494 A1**

(12) **EUROPEAN PATENT APPLICATION**

(43) Date of publication:
  **04.03.2026   Bulletin 2026/10**

(21) Application number: **24197471.6**

(22) Date of filing: **30.08.2024**

(51) International Patent Classification (IPC):
  **H05K 1/02** (2006.01)

(52) Cooperative Patent Classification (CPC):
  **H05K 1/0283;** H05K 2201/0133; H05K 2201/0162;
  H05K 2201/0314; H05K 2203/107;
  H05K 2203/1131; H05K 2203/128

(84) Designated Contracting States:
  **AL AT BE BG CH CY CZ DE DK EE ES FI FR GB**
  **GR HR HU IE IS IT LI LT LU LV MC ME MK MT NL**
  **NO PL PT RO RS SE SI SK SM TR**
  Designated Extension States:
  **BA**
  Designated Validation States:
  **GE KH MA MD TN**

(71) Applicant: **University Of Oulu**
  **90014 University of Oulu (FI)**

(72) Inventors:
  • **Tolvanen, Jarkko**
   **90014 Oulu (FI)**

  • **Albeltagi, Ahmed**
   **90014 Oulu (FI)**
  • **Nelo, Mikko**
   **90014 Oulu (FI)**
  • **Hannu, Jari**
   **90014 Oulu (FI)**
  • **Juuti, Jari**
   **90014 Oulu (FI)**
  • **Jantunen, Heli**
   **90014 Oulu (FI)**

(74) Representative: **Berggren Oy**
  **P.O. Box 16**
  **Fabianinkatu 21**
  **00101 Helsinki (FI)**

(54) **A METHOD FOR PATTERNING A SELF-HEALING ELASTOMER FILM, PATTERNED, LASER SINTERED AND/OR ELECTRICAL CONDUCTIVITY-IMPROVED SELF-HEALING FILM, A MULTILAYER FILM, AN ELECTRICAL DEVICE AND USE OF A PROGRAMMABLE LASER PROCESSING SYSTEM FOR PATTERNING A SELF-HEALING ELASTOMER FILM**

(57)   Disclosed is a method for patterning a self-healing elastomer film, and/or for laser sintering and/or for improving electrical conductivity of a self-healing elastomer film, the method comprising providing a programmable laser processing system, providing a predetermined design model in a program code format for forming one or more patterns to program the laser processing system with the design model, providing a self-healing elastomer film on a substrate, at least partly curing the self-healing elastomer film, providing the at least partly cured film to the laser processing system, treating the at least partly cured film with the laser processing system to partly or completely remove solid elastomeric material from predetermined areas with the laser to form pattern shape(s) defined by the design model to the self-healing elastomer film, and/or to laser sinter and/or to remove oxide layer to improve electrical conductivity of the self-healing elastomer film. Disclosed is also a patterned, laser sintered and/or electrical conductivity-improved self-healing film, a multi-layer film and an electrical device. Disclosed is also use of a programmable laser processing system for patterning a self-healing elastomer film.

Fig. 12

**EP 4 704 494 A1**

## Description

### Field of the application

The present application relates to a method for patterning a self-healing elastomer film, and to patterned, laser sintered and/or electrical conductivity-improved self-healing films. The present application also relates to a multilayer film, and to an electrical device comprising the film or the multilayer film. The present application also relates to use of a programmable laser processing system for patterning a self-healing elastomer film.

### Background

Liquid metals (LMs) refer to metals and metal alloys which are in a liquid form near or below room temperature, depending on the composition of the liquid metal or a mixture comprising thereof. As liquid metals have a high electrical and thermal conductivity, and capability of maintaining the liquid form at relatively low temperatures, they are promising materials, for example, for flexible electronics. However, using liquid metals in products and applications of flexible electronics still challenging as they exhibit several properties which, for example, hamper the processability of materials, and manufacturability of soft and deformable electronics.

The challenges with the use of liquid metals in electronic materials are their limited wettability and high surface tension, which prevent direct application thereof in manufacturing methods of printable electronics and material patterning therein. Liquid metal tends to bead up rather than spread out due to the natural tendency to minimize the surface energy by forming spherical droplets. Therefore, it is difficult to control the deposition of liquid metals to various substrates, to enable precise and scalable patternability at different scales (ranging from nm to mm), and to achieve highly uniform thin films. Also, without oxide shell, they exhibit no elastically restoring effect which would enable the material returning to the original form after deformation driven by the surface tension. Another hindrance is the leakage of liquid metal under localized mechanical stress causing electrical shorting in soft electronics devices, which is partly related to the poor adhesion properties of liquid metal-based materials to other functional materials and boundaries.

Therefore, there is a need to find methods and materials enabling the use of liquid metals in a variety of applications and to overcome drawbacks of prior art. There is also a need to find methods and devices for efficiently post-processing the materials to improve the properties thereof and to obtain products.

### Summary

In the present invention it was found out how to prepare materials and products utilizing liquid metals as functional filler in self-healing elastomers, and to overcome drawbacks of prior art. The liquid metal elastomers (LME) can be used in a variety of products and applications. For example, solution-processable elastomer composites were obtained.

It was found out how to incorporate liquid metals as a functional filler into soft autonomously self-healing elastomers, and how the obtained composites can be further processed to obtain materials, which not only have excellent mechanical and thermal stability, are humidity-resistant, have high electrical conductivity, strain insensitive electrical resistance under tensile strain, are highly deformable and capable of (autonomously) self-healing, but which can be also easily processed, for example printed or deposited onto various substrates by wide range of techniques.

It was also found out how to prepare product, such as multilayer films, which can be used in electrical devices.

The present methods and materials provide soft, stretchable and autonomously self-healing liquid metal elastomers which can restore, or even improving, their pristine tensile and electrical properties, and electrical conductivity under tensile strain after mechanical damage.

The present disclosure provides a method for patterning a self-healing elastomer film, and/or for laser sintering and/or for improving electrical conductivity of a self-healing elastomer film, the method comprising

- providing a programmable laser processing system,
- providing a predetermined design model in a program code format for forming one or more patterns and/or treatments, to program the laser processing system with the design model to cause the laser system to form the one or more patterns, sintering(s) and/or surface treatment(s) to an object when operated,
- providing a self-healing elastomer film on a substrate,
- at least partly curing, such as heating and/or cross-linking, the self-healing elastomer film, before processing with the laser, to obtain at least partly cured film,
- providing the at least partly cured film to the laser processing system as the object,
- treating the at least partly cured film with the laser processing system to partly or completely remove, such as evaporate and/or sublimate, solid elastomeric material from predetermined areas with the laser to form patterns, sintering(s) and/or surface treatment(s) defined by the design model to the self-healing elastomer film, and/or to laser sinter and/or to remove oxide layer from a surface of the film to improve electrical conductivity of the self-healing elastomer film.

The present disclosure also provides a patterned, laser sintered and/or electrical conductivity-improved self-healing film obtained with the method of any of preceding claims, such as a laser sintered and/or an electrical conductivity-improved self-healing liquid metal elastomer composite film.

The present disclosure also provides a multi-layer film comprising one or more of the patterned, laser sintered and/or electrical conductivity-improved self-healing elastomer films.

The present disclosure also provides an electrical device comprising one or more of the patterned, laser sintered and/or electrical conductivity-improved self-healing liquid metal elastomer films or one or more of the multi-layer films.

The present disclosure also provides se of a programmable laser processing system for patterning a self-healing elastomer film, for laser sintering a self-healing elastomer film and/or for improving electrical conductivity of a self-healing elastomer film with the method.

The main embodiments are characterized in the independent claims. Various embodiments are disclosed in the dependent claims. The embodiments and examples disclosed herein are mutually freely combinable unless otherwise explicitly stated.

ble unless otherwise explicitly stated.

The tensile, electrical and dielectric properties of the liquid metal elastomer composite films and microstructural formation thereof can be controlled with the present preparation method and composition.

The present method enables providing a variety of self-healing LME composites that maintain their enhanced mechanical properties over time, including ability to recover, even after very extensive stretching, to the original size and form with the original or even better electrical properties.

The different self-healing elastomers, blends thereof, and composites based on the same base polymer backbone can be accurately patterned after cross-linking. The patterned self-healing films can be transfer printed from a donor substrate, with weaker adhesion, to other materials or surfaces, with stronger adhesion, or to self-healing substrate or material structures via reversible cross-links capable of establishing chemical bonds between the layers. The first method is widely applicable for wide range of materials, considering adhesion at the interfaces is controlled by the choice of donor and acceptor material, whereas the latter only requires that the used self-healing materials are compatible with each other, for example, based on the same polymer matrix.

Patternability of the self-healing material by laser enables forming patterned films at high precision, after cross-linking and/or curing, without permanently damaging the materials that can be otherwise vulnerable to formation of microstructural damages, thus propagation of fractures/defects under mechanical deformation, especially if the possible self-healing is neglected. Methods for patterning of soft functional materials are especially essential for fabricating small and reliable soft electronics devices and circuits.

## Brief description of the figures

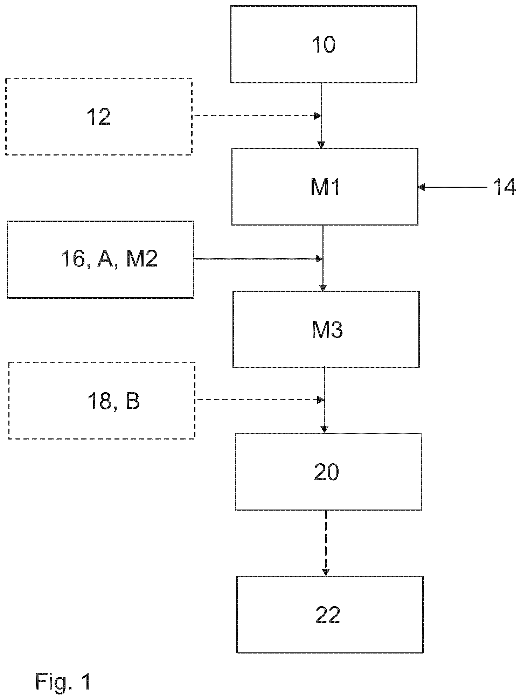

Figure 1 shows a flowchart of the method. Optional ingredients and/or steps are presented with dashed lines.

Figure 2 shows a flowchart of one embodiment of the method, which is preferred for preparing electrically insulative liquid metal elastomers that can be used as dielectrics. Optional ingredients are presented with dashed lines.

Figure 3 shows a flowchart of another embodiment of the method, which is preferred for preparing electrically conductive liquid metal elastomers. Optional ingredients are presented with dashed lines.

Figure 4 shows a flowchart of another embodiment of the method, which is preferred for preparing electrically conductive liquid metal elastomers. Optional ingredients are presented with dashed lines.

Figure 5 shows a flowchart of another embodiment of the method, which is preferred for preparing electrically conductive liquid metal elastomers. Optional ingredients are presented with dashed lines.

Figure 6 shows a SEM image of liquid metal microparticles (LMMPs) obtained by ultrasound treatment.

Figure 7 shows a SEM image of a surface of a film made by using a mixture of liquid metal particles and carbon nanotubes, where the amount of liquid metal was 60 vol.%.

Figure 8 shows a SEM image of a surface of a film made by using a mixture of liquid metal particles, where the amount of liquid metal was 60 vol.%.

Figure 9 shows a SEM image of a surface of a film made by using mixture of liquid metal particles and hydroxypropyl cellulose, where the amount of LM was 50 vol.%.

Figure 10 shows an EDS image of a liquid metal elastomer conductor printed on a self-healing elastomer substrate. The scale bars are 1000 $\mu$m.

Figure 11 shows photographs of different liquid metal elastomer composition made by using carbon nanotubes, carbon nanotubes and hydroxypropyl cellulose mixed with water, and carbon nanotubes and hydroxypropyl cellulose mixed with toluene. The printed conductors on Dragon Skin™ elastomer are under uniaxial stretching.

Figure 12 shows an example of laser processing of the self-healing elastomer composite films.

Figure 13 shows an example of a three-dimensionally patterned self-healing elastomer composite film (EC7, with small amount of graphite powder) with 240 pixels. The sizes of individual pixels are 1.5 x 1.5 x 0.2 in mm (length x width x depth).

Figure 14 shows power of the laser as a function of A) laser frequency and B) measured cured film thickness as a function of number of repetitions required to complete cut through the film. The logarithmic fit shows the approximation on the basis of experimental data.

Figure 15 shows (A-C) schematic illustration of A) the use of hatching tool and B) a Hatching grid, where the spacing and angle can be adjusted. C) Schematic illustration of the film processing with the hatching tool when some areas of the film are completely removed.

Figure 16 shows a photograph of a two-dimensional patterning of a self-healing elastomer composite film with a cutting-tool. The cut marks are visible as light grey on the surface of the film. The film from the right side is peeled-off along the cuts leaving the only the patterns on the carrier substrate.

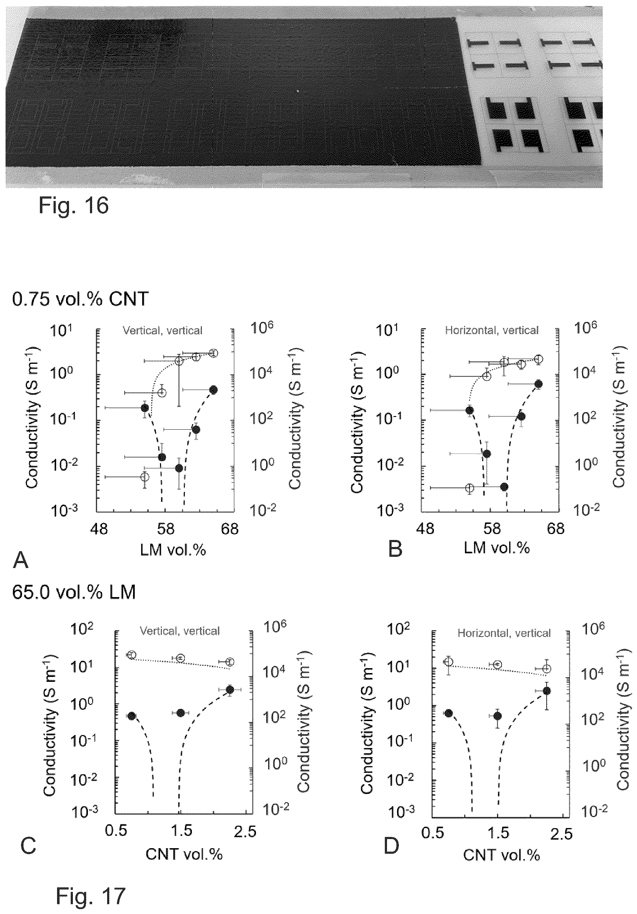

Figure 17 shows electrical conductivities of the liquid metal elastomers printed on Dragon Skin™-elastomer (A-D). The electrical conductivities are plotted as a function of liquid metal (LM) loading before and after the lasering (filled spheres = before, the left y-axis; non-filled spheres = after, the right y-axis) (top row) (the amount of carbon nanotubes (CNTs) was fixed to 0.75 vol.%), and as a function of CNT loading (bottom row) (when amount of LM was fixed to 65 vol.%) for vertical printing and vertical lasering, and for horizontal printing and vertical lasering. The loading level is expressed as volume percentage (vol. %). The values are expressed as mean +/- STD; the error bars indicate the STD (=standard error). (sample size, n = 10). The dotted lines show the polynomial fitting line on the basis of the experimental results.

Figure 18 shows photographs (A, B) of liquid metal elastomer patterns printed onto a self-healing substrate with a shadow mask.

Figure 19 shows SEM images of printed liquid metal conductors on self-healing elastomers when uniaxially stretched from 0% to over 125% tensile strain.

Figure 20 shows relative change in resistance ($\Delta R/R_0$) as a function of time when the sample has been cut repeatedly 12 times. $\Delta R$ is $R-R_0$, wherein R is the resistance of the conductor and $R_0$ is the original resistance of a pristine conductor (before measurement).

Figure 21 shows average $R/R_0$ measured as a function of time at A) a room temperature (RT) and B) at 70°C after the lasering the liquid metal elastomers. The liquid metal elastomers were printed onto a self-healing elastomer substrate. The shadowed area shows the standard deviation, and the black dots show the average (n=4).

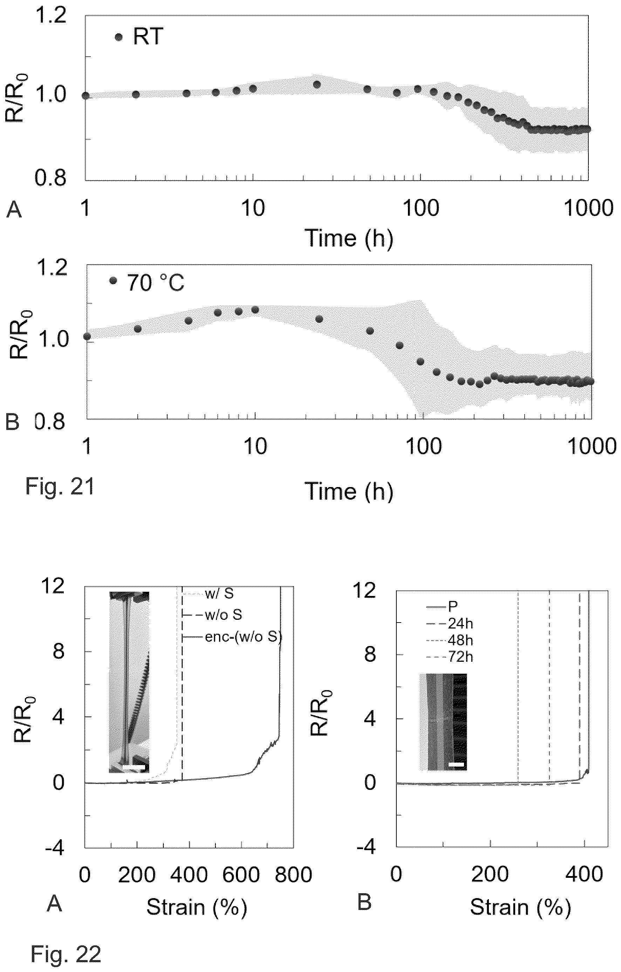

Figure 22 shows $R/R_0$ measured as a function of uniaxial stretching. The printed conductors are denoted as follows: in a) w/ S = with a surfactant, w/o S = without a surfactant, enc-(w/o S) = encapsulated and without a surfactant, and in B) P=pristine and the times 24/48/72 h refer to the self-healing time from the point of time where the sample was completely cut through on specific location. The photos show pristine sample under stretching (the left, scale bar 25 mm) and self-healed sample which has been cut and then healed (right, scale bar= 0.3 mm). The liquid metal elastomers were printed onto a self-healing elastomer substrate.

Figure 23 shows $R/R_0$ measured as a function of time (>200 000 s), when the sample was initially stretched from 0% to 100%, then cycled between 57% and 100% uniaxial tensile strain for 20 000 repetitions, and finally as the stretching was released. The sample comprises a liquid metal elastomer printed onto a self-healing elastomer substrate.

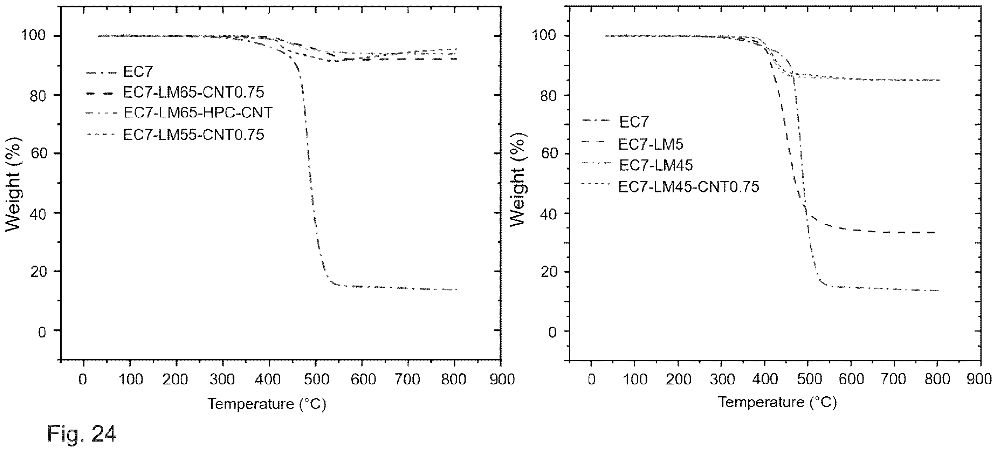

Figure 24 shows thermogravimetric analyses of liquid metal elastomers measured with NETZSCH STA 449F3 Jupiter over temperature range of 30-900°C in nitrogen atmosphere with heating rate of 10 °C min-1. The data was collected on the second heating process after eliminating the thermal history. The compositions are denoted as follows: EC7 = elastomer (without any fillers). EC7-LM65-CNT0.75 = liquid metal elastomer with 65 vol.% liquid metal and 0.75 wt.% MWCNT-COOH. EC7-LM65-HPC-CNT = liquid metal elastomer with 65 vol.% liquid metal, when 20 wt.% HPC in deionized water mixed with small amount of MWCNT-COOH is also added. EC7-LM55-CNT0.75 = same as above, but 55 vol.% liquid metal EC7-LM5, LM45, LM45-CNT0.75 = 5 vol.% liquid metal, 45 vol.% liquid metal, and 45 vol.% liquid metal with 0.75 wt.% MWCNT-COOH.

Figure 25 shows dielectric properties of liquid metal elastomers. Relative permittivity and loss tangent measured at frequency of 1 MHz when plotted as a function of liquid metal and CNT volume loading.

The amount of liquid metal was fixed to 25 vol.% when the amount of CNT was varied.

Figure 26 shows particle size analysis. The particle size distribution measured with Zetasizer Nano ZS diluted liquid metal mixture.

Figure 27 shows resistance measurements of liquid metal elastomers in the environmental chamber. $R/R_0$ plotted as a function of time for encapsulated and non-encapsulated EC7-LM65-CNT0.75 conductors on EC7 self-healing elastomer substrate (65 vol.% liquid metal and 0.75 wt.% of MWCNT-COOH):

- when first cooled from RT (25°C) to -50°C, then heated to 180°C, and finally cooled back to 30°C.
- when the temperature and relative humidity was first increased to 85°C and 85%, respectively, and then kept for 24 hours
- when temperature was kept at RT, and the relative humidity was increased from 0 to 90%

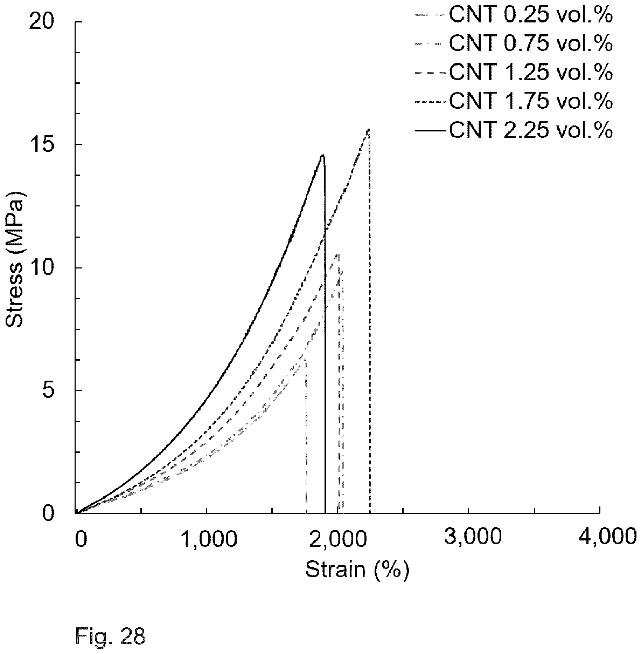

Figure 28 shows tensile properties of liquid metal elastomers. Stress-strain curves for pristine EC7-LM45-CNT elastomers (45 vol.% liquid metal) when the amount of MWCNT-COOH was varied from 0.25 to 2.25 vol.%.

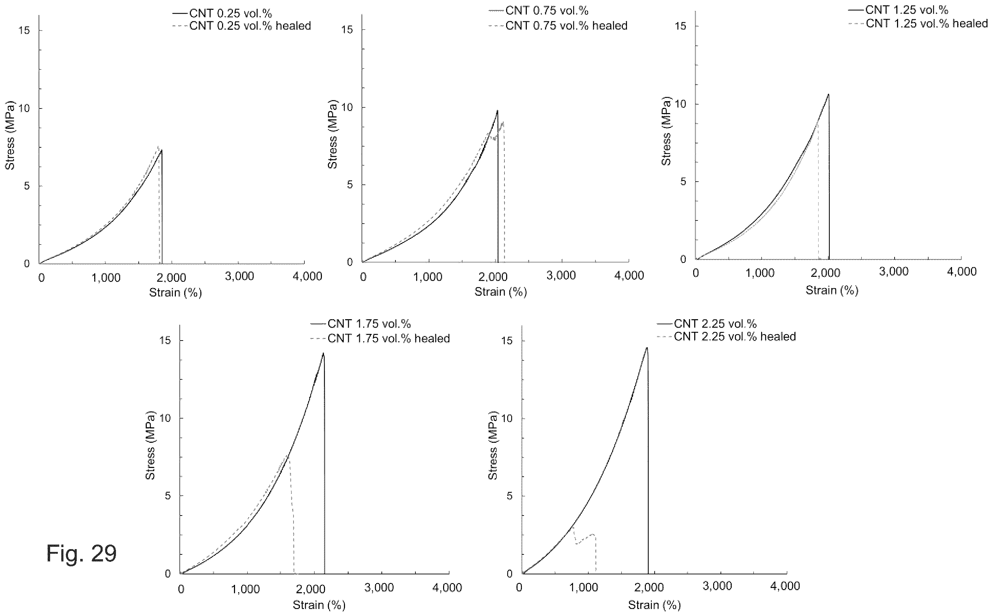

Figure 29 shows tensile properties of liquid metal elastomers. Stress-strain curves for pristine and self-healed EC7-LM45-CNT elastomers (45 vol.% liquid metal) when the amount of CNT was varied from 0.25 to 2.25 vol.%.

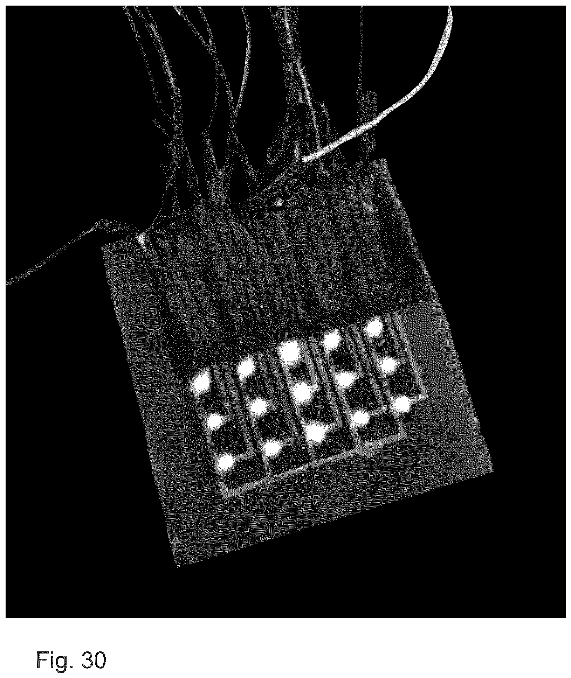

Figure 30 shows a self-healing display made with surface mountable light emitting diodes.

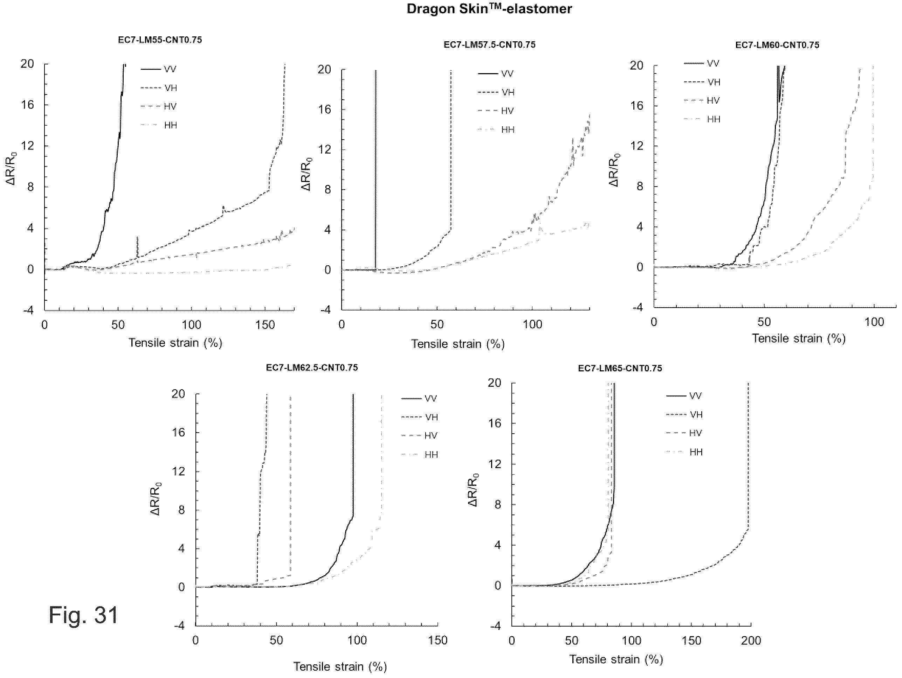

Figure 31 shows $\Delta R/R_0$ measured as a function of uniaxial tensile strain for EC7-LM-CNT elastomer composites as the volume of liquid metal was increased from 55 to 65 vol.%. The printing and lasering directions are indicated with the abbreviations W, VH, HV, HH, where V indicates vertical, and H indicates horizontal. The first letter indicates the printing direction.

## Detailed description

In this specification, percentage values, unless specifically indicated otherwise, are based on weight (w/w, by weight, or wt%). In specific examples the embodiments and examples specified with the open term "comprise" may be further limited with a closed term "consisting of".

The diameters disclosed herein, unless specifically indicated otherwise, may refer to the smallest diameter, and may be presented as average or number-average diameter. The diameter may be also presented as equivalent spherical diameter. The diameter may be determined microscopically or by other optical methods, which may comprise using a camera, and/or by sieve analysis. More particularly, the disclosed dimensions or other features may be measured by image analysis of microscope images, such as images from a light microscope, a field emission scanning electron microscope (FE-SEM), a transmission electron microscope (TEM), such as a cryogenic transmission electron microscope (CRYO-TEM), or an atomic force microscope (AFM). Suitable imaging and/or analysis software may be used to determine the dimensions and/or the other features.

Disclosed is a method for manufacturing a self-healing elastomer composite, which may be electrically conducting or dielectric. The present disclosure also provides the self-healing electrically conducting or dielectric elastomer composite, which is based on combination of liquid metal(s) with electrically insulative polymer/elastomer matrix. The electrical and dielectric properties of the elastomer composite can be controlled with the volume of liquid metal(s) in the composite.

Disclosed is a method for manufacturing a self-healing electrically conducting or dielectric elastomer composite, the method comprising

- providing a mixture comprising liquid metals with gallium (Ga) as main phase, preferably in an organic solvent,
- treating the mixture comprising the liquid metals with ultrasound to form a first mixture (M1) comprising liquid metal microparticles and optionally functional fillers,
- providing one or more components contributing as a polymer matrix of the elastomer composite,
- adding the one or more components to the first mixture (M1), optionally providing the one or more components as a second mixture (M2) and adding the second mixture (M2) to the first mixture (M1), to obtain a third mixture (M3),
- allowing reaction to take place in the third mixture (M3) to cure the third mixture to obtain a self-healing electrically conducting or dielectric elastomer composite comprising
- an elastomer matrix, preferably comprising a polymer blend with one or more electrically insulating phase(s) having a phase-separated structure with localized heterogeneity, and
- 5-90% by volume of liquid metal microparticles comprising gallium as main phase.

Disclosed is a self-healing electrically conducting elastomer composite film, such as a multiphase film, comprising:

- a polymer matrix, preferably comprising a polymer blend with one or more electrically insulating phase(s) having a phase-separated structure with localized heterogeneity, and
- 55% or more by volume of liquid metals comprising gallium as main phase.

Disclosed is a self-healing electrically insulating elastomer composite film, such as a multiphase film, comprising:

- an elastomer matrix, preferably comprising a polymer blend with one or more electrically insulating phase(s) having a phase-separated structure with localized heterogeneity, and
- 45% or less by volume of liquid metals comprising gallium as main phase.

Disclosed is the self-healing electrically conducting or electrically insulating elastomer composite obtained with the method.

Disclosed is an electronic device comprising the self-healing electrically conducting or dielectric elastomer film.

In general, addition of liquid metals provides several advantageous properties for soft matter, such as increased Young's modulus, improved toughness, notch-insensitivity, increased relative permittivity, increased dielectric breakdown voltage, increased thermal and/or electrical conductivity, electrical self-healing due to presence of oxide shell, capability of acting as hermetic barrier, such as to provide elastomers highly permeable to gases, for example water vapor, and a possibility for magnetic field control.

In the field of soft electronics, the term "liquid metal" is commonly understood as a metal, or metal alloy, i.e. mixture of two or more metals, that is liquid near, at, or below the room temperature, such as at 20-30°C. There are wide range of metals with higher melting points than room temperature, such as more than 40°C, but these are usually not considered as liquid metal. These metals are also known as "post-transition metals" (i.e., chemically weak metals or poor metals) as their crystalline structures tend to show covalent / directional bonding effects. The present mixture/alloy of liquid metals may comprise one or more liquid metals, including combinations of one or more liquid metals with one or more post-transition metals.

Examples of pure metals with known low melting points include Mercury (Hg; number 80) -38.83°C (toxic), Cesium (Cs; number 55) 28.5°C (toxic), Gallium (Ga; number 31) 29.8°C (low toxicity), Rubidium (Rb; number 37) 39°C (not safe for skin contact), Francium (Fr; number 87) 29°C (radioactive), Copernicium (Cn; number 112) $10 \pm 11°C$ (predicted value) (radioactive), and Flerovium (Fl; 114) $11 \pm 50°C$ (predicted value) (radioactive).

Because the other metals with low melting point are either toxic and/or highly radioactive, the only good option for forming the majority phase in liquid metal alloy is Ga. Especially if used in applications, such as soft electronics devices, that are in interfaced with the human body, living organisms or environment the challenges relating to application of gallium in products must be overcome.

The present method comprises providing one or more liquid metals comprising gallium as main phase 10, such as a mixture comprising one or more liquid metals comprising gallium as main phase, in a solvent, such as in an organic solvent, in aqueous medium/water or a combination thereof. Gallium is a first liquid metal, and the mixture/alloy comprises one or more further metals including second (liquid) metal and optionally third (or further) (liquid) metal(s).

The liquid metal(s), or a mixture thereof, 10 contribute(s) to electric (electrically conducting) or dielectric phase of the elastomer composite. The electrical conductivity of the final elastomer composite can be controlled and/or adjusted by selecting suitable portion of the liquid metals in the final elastomer composite. A lower volume loading of liquid metals provides a dielectric composite, and a higher amount, such as more than 45% by volume, preferably 50% or more by volume, or more preferably 55% or more by volume, can provide an electrically conducting composite.

The organic solvent may be alcohol, such as isopropanol (IPA), or hydrocarbon, such as toluene.

When gallium is used as the main phase of the liquid metal alloy it can provide effects such as high electrical conductivity in the range of $(3.0-3.9) \times 10^4$ S cm$^{-1}$, high thermal conductivity of 19.2-29.5 W m$^{-1}$ K$^{-1}$, low viscosity in the range of $(1.37-2.40) \times 10^{-3}$ Pa s, high surface tension in the range of 533-718 N m$^{-1}$, low toxicity, negligible vapor pressure of less than $10^{-6}$ at 500°C, extremely wide temperature range from ~15°C to 2400°C (the latter is the evaporation temperature), and negligible solubility in water.

In the present methods and products, liquid metals may be provided in eutectic form or mixture. The term "eutectic" refers to a mixture of metals, i.e. metal alloy, that is not only homogenous but has a melting point lower than those of the constituents. For example, gallium (Ga) has a melting point of 29.76°C, while indium (In) has a melting point of 156.6°C. The mixture of Ga and In (75.5:24.5) forms a eutectic metal with a melting point close to 15°C.

In one embodiment the liquid metals are provided as eutectic gallium-indium alloy comprising gallium and indium in a Ga:In ratio by weight of 68.3-99.0:1.0-31.7, preferably 73.0-78.0:27.0-22.0, such as 74.0-77.0:26.0-23.0, for example about 75.5:24.5.

Eutectic metals can transform from solid to liquid, and *vice versa,* at specific temperature that is then dependent on the composition, or mixture of metals. Generally, the melting point of metal is known to be dependent, for example, on the number of electrons, degree of ionization/delocalization, impurities, and/or crystal structure when in its solid phase.

In one embodiment the liquid metals comprise gallium and indium and are provided as a eutectic gallium-indium mixture/alloy. The abbreviation "eGaIn" as used herein refers to eutectic gallium-indium, which is an alloy of at least gallium and indium. Optionally one or more further liquid metals may be included.

In one embodiment the method comprises

- providing gallium as a first liquid metal,
- providing indium as a second liquid metal,
- optionally providing one or more other liquid metal(s), such as tin,
- mixing the liquid metals to obtain a mixture comprising liquid metal alloy comprising gallium and indium and/or wherein the liquid metals are provided as eutectic gallium-indium alloy comprising gallium and indium in a Ga:In ratio by weight of 68.3-99.0:1.0-31.7, such as 73.0-78.0:27.0-22.0, for example about 75.5:24.5.

In an example of liquid metal (LM) mixture/alloy, tin (Sn) is added to Ga-In system to form liquid metal in many cases referred as "Galinstan" (a registered trademark of Geratherm Medical AG). The addition of Sn lowers the melting point of the eGaIn. Ga, In and Sn are highly soluble together and can form monophasic alloy, where the term "monophasic" refers to a single phase (i.e., homogenous mixture). The Ga is capable of slowly dissolving the indium and/or tin even without additional heating. The time that the process takes can be made extremely fast, such as completed within few minutes, by heating the mixture above the melting point of the element having the highest melting point. For example, in Ga-In-based system this would be 156.6°C. Similarly, this would be applicable also to other metal alloys or liquid metal-based systems. However, a commonly known drawback of heating at higher temperatures is the formation of surface oxide layer. In the literature, it is known that this could be mitigated if the mixing by heating was done under inert atmosphere or with the use of chemical fluxes. Especially, the chemical fluxes are needed if higher melting point metals forms the majority phase in the metal alloy. However, any metal with a higher melting point than 40°C is often not applicable for soft electronics or self-healing electronics, due to limited temperature range when its liquid form.

However, in some applications it is not desired to include tin in the liquid metals, as tin lowers the melting point and may soften the LM alloy too much. Thus, using gallium and indium was found to be more suitable for providing elastomer composites for a wide variety of uses and applications.

As can be derived from experimentally derived phase diagrams for Ga-In system, the experimental melting point of Ga-In systems is between 15.7°C to 30°C when the amount of In is between 1.0-31.7% by weight.

All these compositions are possible for mixing purposes with the present autonomously self-healing elastomers. In general, for the present purposes it is preferred to have a melting point of the liquid metal alloy of 30°C or less, such as in the range of 5-30°C, for example in the range of 10-26°C.

Below are melting points (m.p.) of certain Ga-based metal alloys (given by weight ratios):

- $Ga_{95}In_5$ 25°C
- $Ga_{91.7}Sn_{8.3}$ 21°C
- $Ga_{97.6}Al_{2.4}$ 25.9°C
- $Ga_{96.1}Zn_{3.9}$ 24.7°C
- $Ga_{98}Hg_{2.0}$ 27°C
- $Ga_{96.4}Ag_{3.6}$ 26°C
- $Ga_{79}In_{21}$ 15.7°C
- $Ga_{62.5}In_{21.5}Sn_{16}$ 17°C
- $Ga_{66.5}In_{20.5}Sn_{13}$ 11°C
- $Ga_{78.3}In_{14.9}Sn_{6.8}$ 13.2°C
- $Ga_{61}In_{25}Sn_{13}Zn_1$ 8°C

Oxide formation

A non-desired property of liquid metals and materials comprising thereof is the oxide layer formed on the surface of the liquid metal. Atomically thin oxide layers are formed nearly instantaneously in liquid metals even at ppm concentrations of oxygen by the oxide that results in the largest reduction in the "Gibbs free energy" ($\Delta G$) (*i.e.,* thermodynamic potential). The oxidation process is thermodynamically spontaneous reaction (*i.e., -$\Delta G$*) which forms a core-shell structure of liquid metal. The composition on the surface oxide of metal alloy is known to differ from that of the inner core. During the growth of the oxide layer, the kinetics are known to be dominated by the ion transport through the oxide. Eventually the oxide layer achieves a critical thickness (typically of few Å to several nm). The rate of the oxide growth is diffusion-limited meaning oxygen ions must diffuse through the lattice of the oxide material by hopping from lattice site to another. The mechanism is known to be driven by thermodynamic forces and concentration gradients. The growth rate of the oxide is also known to be influenced also by the oxygen and water vapor concentrations. By minimizing the $\Delta G$, the metal alloys tend to form oxide compounds that are the most thermodynamically stable (also have stronger metal-oxygen bond). These are often stoichiometric compounds with well-defined crystal structures, where the ratio of metal atoms to oxygen atoms is fixed. These compounds are considered more thermodynamically stable than any non-stoichiometric compounds or mixed-metal oxides. However, in the formation of oxides, additional consideration must be given to entropy changes. For example, oxide compounds with higher degrees of disorder, and/or greater configurational entropy can be thermodynamically favored for the process even in expense of less favorable enthalpy changes.

At the critical thickness of the formed oxide layer, further oxidation and thickening of the layer is prevented. The thickness of the oxide layer is known to differ between metals, e.g., depending on their work function, solubility of the metal and oxygen ions in the oxide, and so forth. For example, the work function of metal influences the rate of the oxidation as this affects the energy barrier for the oxygen atoms to absorb onto surface of metal, and then react with the metal atoms to form the oxide. Higher work function metals have lower reactivity towards oxygen and slower oxidation kinetics which favors formation of thinner oxide layers. The major drawback of the formed oxide, with tightly bound oxygen atoms, is that it can also act as an electrical barrier that inhibits movement of electrons. It has been also shown that in presence of moisture, the surface oxide can also change, e.g., from gallium oxide to gallium monohydroxide that is also mechanically weaker.

Surface tension

Bulk liquid metals are known for their poor wettability and high surface tension ($\gamma$). Thus, the liquid metal tends to bead up rather than spread out, i.e., it has natural tendency to minimize the surface energy by forming spherical droplets. Therefore, it is difficult to control the deposition of liquid metals to various substrates, to enable precise and scalable patternability at different scales (ranging from mm to nm), and to achieve highly uniform thin films. For better understanding, $\gamma$ is a measure of cohesive force between the molecules at the surface of liquid. When liquid droplet forms, the molecules on the surface experiences net inward force due to imbalance of cohesive force resulting in tendency to minimize the surface area. This can be ascribed with Laplace equation for liquid droplet showing relationship between surface tension, pressure, and curvature on the interface:

$$\Delta P = \gamma (r_1^{-1} + r_2^{-1})$$

where $\Delta P$ is pressure difference across the interface, $r_1$ and $r_2$ are radii of curvature of the droplet along two orthogonal directions (i.e., perpendicular). In the case of spherical droplet (i.e., minimized surface area in liquid metal), $r_1 = r_2$, and $\Delta P = 2\gamma/r$. Because the liquid droplet volume is known to influence the contact angle at the substrate (dependent also on the density of the liquid), and surface tension has direct relationship to droplet volume (i.e., the surface tension decreases with the droplet volume decreasing), it is necessary to reduce the physical size of the bulk LM to enable better processability with solution processing, wet film deposition, and/or additive or subtractive techniques commonly used in the manufacturing of soft, functional electronics devices and circuits.

Another important aspect is that the surface-to-volume ratio increases rapidly as the physical size of the bulk LM decreases. For example, the surface-to-volume of a sphere is given as $(4\pi r^2)/(4\pi r^3/3) = 3/r$. Thus, a radius (r) of the sphere is inversely proportional to the surface-to-volume ratio. The increase of surface-to-volume ratio holds true also for any other geometrical shapes of particles. The large surface-to-volume ratio enables, e.g., increased reactivity for chemical reactions, enhanced adsorption/absorption, wide range of opportunities for any kind of surface modification and/or functionalization by attachment of functional groups, nanoparticles or even biomolecules to further tailor the material properties for various purposes, which are not only limited to electronics.

The present methods and materials comprise autonomously self-healing elastomers which can be used for example in soft and printed electronics as substrates and as a base material for a wide variety of soft and/or flexible and/or stretchable electronic components, e.g. actuators, energy harvesters, sensors, capacitors, conductors, resistors, insulators, encryption devices, etc. Autonomous self-healing material can also be used in mechanical applications as sealants, moisture insulation, rubber spring/dampers, coatings, etc. It is possible to obtain completely autonomously self-healing components and devices based on the material.

Method for microparticle (MP) formation

It was found necessary to provide the liquid metal in the form of liquid metal microparticles (LMMPs), which term may include particles having a size in the micrometer and/or nanometer range. The method comprises forming the microparticles by using a suitable method.

To form micro and/or nano-sized particles (MP), the bulk LM is broken down, and the reforming of interfacial oxides is used for separating the individual LM droplets from each other. The thin oxide layer in MP can be considered as an advantage when, e.g., mixed with polymers as the van der Waals and Coulomb forces enable improved wetting, and anchoring to the polymer phases at their vicinity. The smaller LM droplets also enable better processability (discussed above) which is particularly important for enabling fabrication of soft electronics or alike.

Ultrasonication

The microparticles may be obtained by treating the bulk liquid metal alloy/mixture with suitable disintegrating method 14, such as by using ultrasound. The microparticles may be formed and are present in a suitable solvent. The microparticles may refer to micro and/or nanoscale particles, and they may have an average particle diameter of 100 $\mu$m or less, such as 50 $\mu$m or less, for example in the range of 100 nm - 100 $\mu$m. In one embodiment the formed microparticles have an average particle diameter in the range of 100 nm - 50 $\mu$m, such as

in the range of 100 nm - 30 $\mu$m.

The method may comprise treating the mixture comprising the liquid metals with ultrasound 14, i.e. ultrasonicating the mixture, to form a first mixture (M1) comprising microparticles containing liquid metals, microparticles consisting of liquid metals, and/or liquid metal microparticles. The first mixture may comprise one or more (functional) fillers 12, which may be dispersed in a solvent, such as in an organic solvent, in aqueous medium or combination thereof, or one or more fillers may be added to the first mixture. The fillers 12 may be added to the liquid metals 10, to the first mixture (M1), and/or to any further mixture and/or at a further method step.

Ultrasonication was found to be an extremely effective strategy to decrease the MP size from hundreds of micrometers to few micrometers, or even less than that, such as down to tens of nanometers, especially if coupled with laser irradiation. In this method, the liquid metal is completely immersed in a liquid medium, which may comprise or consist of a suitable solvent, such as organic solvent and/or aqueous medium. High-frequency ultrasound is used to agitate and disperse the particles in the liquid medium. The choice of the solvent in the liquid medium /solution, or used aqueous medium, is important for achieving a stable mixture over longer period, and to avoid excessive "precipitation", such as wherein insoluble solid emerges from liquid solution/medium. However, precipitation over time to some degree can be beneficial for reducing the amount of solvent in the mixture before adding the polymer components. This can enable controlling the viscosity of the solution for further processing. The excess solvent can be removed from the surface of the mixture, for example with a pipette after the precipitation.

A probe ultrasonication applies alternating cycles of compression and rarefaction, thus achieving a balanced droplet breakup and coalesce of the cores of the LM (i.e., the oxide shell ruptures faster than its reformed). During the rarefaction phase, pressure drop leads to formation of tiny cavitation bubbles which grow in cycles until reaching a critical size and then collapsing. The collapsing of the cavitation bubbles creates strong, localized forces and shear stresses in the surrounding liquid medium. This results in microstreaming and conversion of mechanical energy into thermal energy, while resulting in intense turbulence and agitation. The turbulent flow of the liquid breaks apart any agglomerates and disperses particles by promoting mixing within the liquid medium. The size of the MPs reduces with longer sonication time, and/or power until equilibrium is achieved. However, longer sonication is likely to lead to excessive heat that needs to be taken care of to avoid, e.g., excessive oxidation, dealloying, or unwanted shape distortion of the MPs.

The LM can be also functionalized in the process, e.g., with the use of "ligands", such as with an ion, or a molecule with functional group that forms coordination complex with the central metal atom, for example to modify the functionality of the LM for sensing purposes. The ligands can absorb the surface of the LMs. Typically, ligands comprise or consist of anchoring groups, such as carboxylic and phosphonic acids, amine moieties) that are binding to the surface, and a tail group, such as unbranched hydrocarbon chains or phenyl group, that self-assemble into well-ordered phases and form a barrier layer. In addition, reducing the size of MP has been shown to reduce the freezing and melting point of the LM core. During the ultrasonic processing, it is possible to use small concentrations of acids or bases to reduce formation of surface oxide in LMMP (liquid metal microparticle), or to eliminate it completely in the process. In addition, surfactants are known to be effective in preventing excessive coalescence of MPs during sonication, which can be beneficial in some cases.

The probe ultrasonication can produce LMMPs with high yield and uniformity, such as narrow size distribution. Particularly, the precise control the particle size and size distribution are important in achieving the best possible properties with autonomously self-healing elastomer composites having well-connected, electrically percolated networks. In comparison to the probe ultrasonication, an ultrasonic bath is less effective as the method is known to result in a high "polydispersity" of MPs, i.e. large heterogeneity of the particle sizes.

Other methods for forming the liquid metal microparticles include shear mixing, microfluidic droplet formation, dropping of hot liquid metal to water bath and molding.

In shear mixing, the bulk LM is broken down by applying a shear stress, e.g., in a chosen solvent. The shear stress elongates the droplets until they break up when reaching the Rayleigh-Plateau length limit in order to minimize the surface area and reduces the surface tension energy. This length limit is not constant value, but a characteristic length scale arising from fluid mechanics. The length limit depends on the factors such as surface tension, density, and viscosity of the liquid (that are not necessarily constant), and the surrounding medium. The theoretical prediction of the length scale is derived from the stability analyses of the equilibrium shape of the liquid columns and expressed through capillary length $(l_c = \sqrt{(\gamma/(pg))},$ where p is the density of the liquid and g is the gravitational acceleration).

Theoretical predictions give that the Rayleigh-Plateau length limit for the droplet breakup is 2.8 times $l_c$. With shear mixing, the achievable size of the LMMPs has been shown to be typically in the range of 20 to 140 $\mu$m depending on the viscosities of the liquid phases, their volume ratios, rotation speed of the mixer, and duration of the shear mixing. However, further decrease of the size of LMMP is usually not possible as sufficient shear stress cannot be applied.

Another viable method to produce LMMPs is microfluidic droplet formation. The method can produce highly "monodisperse", i.e., uniform size, LMMPs above several micrometers in size. In the method, microfluidic channels are used for producing droplets one by one when fluid is pumped through orifice. For example, the droplets can be then extruded into a reservoir for further use. In the method, viscous aqueous solution is used in the microchannels to shear the LMMPs as they pass through the orifice. However, the method is more time consuming and less cost effective compared to ultrasonication as the microfluidic channel templates must be made. In addition to ultrasonication, shear mixing and microfluidic droplet formation, other less common methods are also possible, such dropping of hot liquid metal to water bath or molding bulk LM. However, these methods are less frequently utilized due to their obvious limitations.

The method comprises providing and/or forming an elastomer matrix for the liquid metal elastomer composite. The matrix may be called, and/or it may act, as an electrically insulating phase of the elastomer composite. The matrix may be bimodal.

The method comprises providing one or more components 16, 18, A, B contributing to an electrically insulating phase and/or an elastomer matrix of the elastomer composite. In one embodiment the method comprises separately providing two or more components contributing to the elastomer matrix and/or to the electrically insulating phase of the elastomer composite. This may be the case for example if one or more matrix components are provided as a two-component system, or as a system comprising more components, for example Components A and B used in the examples. The elastomer matrix may be also called a matrix and/or a polymer matrix. The components may comprise one or more compounds and/or a mixture or a combination of two or more compounds.

The matrix may comprise an interpenetrating (elastomer/polymer) network. The terms "interpenetrating network" or "interpenetrating polymer network" or the like as used herein refers to materials comprising two or more networks which are at least partially interlaced on a polymer scale but not covalently bonded to each other. The network cannot be separated unless chemical bonds are broken. In the final product the elastomers/polymers in the matrix may form a phase-separated structure with localized heterogeneity.

The terms "intrinsic self-healing" or "intrinsically self-healing" or the like, which are properties of the present materials, refer to the build-in, inherent self-healing ability of a material. Usually, reversible chemical bonds are involved within the material.

The terms "autonomous self-healing" or "autonomously self-healing" or the like, which are properties of the present materials, refer to the ability to initiate the self-healing process without external intervention. External intervention may be a temperature change to higher than the room temperature, such as 30°C or more, and/or other stimuli such as pressure, chemicals, humidity, moisture, etc. External intervention may also be a force to be applied to initiate self-healing, e.g. when aligning cut/fractured surfaces, regardless of temperature. Thus, an autonomous self-healing material can heal without intervention at any given room temperature, such as. 0-30°C.

The term "universal self-healing" or the like, which is a property of the present materials, refers to the self-healing ability in not only ambient conditions, but also various other conditions, such as at frozen, even temperatures down to -140°C, underwater, and/or the like.

The method comprises adding the one or more components (16, A, 18, B) to the first mixture (M1) to obtain a third mixture (M3).

In one embodiment the method the one or more components (16, A) contributing to the electrically insulating phase and/or the matrix of the elastomer composite are provided as a second mixture (M2). The second mixture (M2) may be combined with the first mixture (M1), such as added to the first mixture, and preferably mixed, to obtain a third mixture (M3)

The method comprises allowing reaction(s) to take place in the third mixture (M3) to set/cure the third mixture to obtain the self-healing electrically conducting or dielectric elastomer composite. The method may comprise adding one or more components including a crosslinking agent (18, B) to the third mixture (M3).

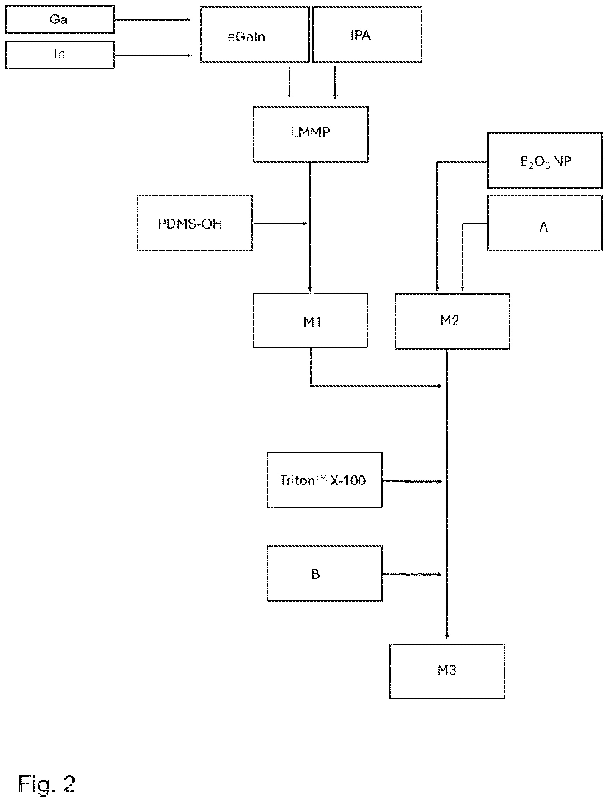

There are several methods suitable for making the dielectric and electrically conductive liquid metal elastomers (denoted as DLME, ECLME). Such methods are explained for example Figures 2-5, which disclose flowcharts presenting examples of Methods 1-4. The methods may include the following steps.

Step 1 - Choosing the elastomer matrix for the liquid metal elastomer composites

The tensile, adhesive, and self-healing properties of the DLME and ECLME are ultimately defined by the choice of the elastomer matrix to which other additives such as functional fillers 12 may be added.

The elastomer matrix may comprise a first phase, such as a soft (softer) phase, and a second phase, such as a hard (harder) phase, and they may be bimodal, and have interpenetrated structure. Thus, the first phase may be physically softer (i.e., having a lower Young's modulus) than the second phase. The elastomer can also exhibit a phase-separate structure with localized heterogeneity.

One preferred option is to use polysiloxane-based elastomers in the matrix, which were found advantageous for providing autonomously self-healing elastomer composite materials. The elastomer may be supplemented with boron dioxide, preferably in form of nanoparticles.

Such self-healing elastomers have a unique structure formed by the interpenetrating networks, cross-links and a unique composition, that contribute unprecedented mechanical properties. The self-healing elastomer is capable of being stretched more than 20 times of its length and return the original size and form with the original or even better mechanical properties. The present elastomers show enhanced polymer chain flexibility at a very wide range. Further, the self-healing elastomer possesses all in one excellent elasticity, autonomous self-healing efficiency, moisture barrier ability, and transparency, which properties are difficult to achieve simultaneously in the known single material of the prior art.

In one example the composition of a non-conductive, interpenetrated, bimodal poly(dimethylsiloxane)-based self-healing elastomer may be defined by one or more of:

- amount of hydroxyl-terminated polydimethylsiloxane (PDMS-OH)
- boron trioxide nanoparticles ($B_2O_3$ NPs)
  and forming the soft phase in the bimodal elastomer;
- amount of polysiloxane precursors comprising siloxane base and crosslinker in relation to one other and forming the hard phase in the bimodal elastomer;
- amount of soft phase in relation to the hard phase.

The PDMS-OH may have a kinematic viscosity in the range of 850-25000 cSt, preferably 18000-22000 cSt, at 25°C. A rheometer, such as Haake Mars 40, complying measurement standard ASTM D2196-20, can be used for determining the kinematic viscosity. It was found that using PDMS-OH having a lower kinematic viscosity, i.e. PDMS-OH having low molecular weight, such as 850-1150 cSt, results a softer final elastomer regardless of the other processing conditions. By increasing the kinematic viscosity of PDMS-OH used, it was found out that the elastomer becomes increasingly more robust as elastic modulus (E) and stress at break ($\delta_{break}$) increase by over 10-fold. As the molecular weight of the precursor increased, both the stress at break and strain at break significantly increased due to the number of entanglements increasing. Regardless of the processing conditions or composition, the polymer strength and extensibility should increase with viscosity of PDMS-OH.

The amount of PDMS-OH used has an impact to the self-healing ability of the final product, i.e. the self-healing elastomer. To achieve sufficient self-healing ability while maintaining good mechanical properties of the self-healing elastomer, the amount of PDMS-OH used may be 65-90 wt.% of the final product.

The method utilizes a multiphase strategy, where the idea is to take advantage of the soft and hard phases in the elastomer matrix. In this case, the soft phase allows intrinsic self-healing, i.e. dynamic interactions, while the hard phase adds material rigidity and mechanical strength, as well as allows viscoelastic nature of material and material conversion to elastomer (due to entropy-driven elasticity). The first composition (A) and the second composition (B) disclosed herein contribute to the hard phase after curing, so the hard phase in general may be a reaction product of polysiloxane precursor and a crosslinking agent. The soft phase may be a reaction product of $B_2O_3$ and PDMS-OH. The multiphase elastomer matrix, which may represent an electrically insulating phase, thus preferably comprises a soft phase and a hard phase, and a phase-separated structure with localized heterogeneity.

In one embodiment the one or more components 16, 18 comprise hydroxyl-terminated polydimethylsiloxane (PDMS-OH), boron trioxide ($B_2O_3$), and polysiloxane precursors comprising a siloxane base (A) (first composition (A)) and a crosslinking agent (B) (second composition (B)), and

- adding the hydroxyl-terminated polydimethylsiloxane (PDMS-OH) to the first mixture (M1),
- providing the boron trioxide ($B_2O_3$) and the siloxane base (A) as a second mixture (M2),
- combining the first mixture (M1) and the second mixture (M2), and preferably mixing,
- adding the crosslinking agent (B). A third mixture (M3) is formed. As the crosslinking proceeds, the third mixture is crosslinked, cured and/or set, and the elastomer composite 20 is formed.

The crosslinking agent (18, B) may be also called as a curing agent. "A" and "B" in the present description and in figures refer to Component A (first composition A) and to Component B (second composition B, crosslinking agent), or a mixture or composition comprising thereof, which components may be added in the method. Component A comprise one or more polymer bases, such as a silicone-based polymer, for example a siloxane base. Component B comprises one or more curing or crosslinking agents, preferably compatible with Component A, such as a siloxane crosslinker. Examples of Components A and B can be obtained commercially as Sylgard™ 184 silicone elastomer kit. When the liquid components are thoroughly mixed, the mixture cures to a flexible elastomer, for example polydimethylsiloxane (PDMS), which may be vinyl-terminated in the case of Sylgard™ 184. The ratio by weight of Component A and Component B may be in the range of 1:1-50:1.

Morphological changes in the elastomer matrix were experimentally confirmed from AFM phase images the, for example, degree of phase separation, upon the change of the added crosslinking agent (B) in the hard phase. The vertical phase-separation is important for the entropic recovery of properties due to increasing free volume as the phase separation increases. The phase-separation increases with the increase of added crosslinking agent (B) in the hard phase.

The boron trioxide may be provided and/or be present as, or in the form of, boron trioxide nanoparticles ($B_2O_3$ NP). The nanoparticles have an average diameter at a nanoscale range, such as an average diameter of 500 nm or less, such as 200 nm or less, for example in the range of 1-500 nm, such as 50-200 nm, preferably 80-100 nm, measured microscopically, for example by using electron microscopy, such as SEM.

In example the $B_2O_3$ is provided or is present in an amount of 0.40-3.00 wt.%, preferably 0.65-1.90 wt.%, and more preferably 0.75-1.40 wt.%, for example about 0.85 wt.%.

It was found out that the presence of $B_2O_3$ nanoparticles provides a large contacting area for the reaction and thus contributing to the reaction efficiency significantly, when compared with non-nanoparticles of $B_2O_3$. Thus, in the case of using $B_2O_3$ nanoparticles, less $B_2O_3$ is needed. It was also found out that the amount of $B_2O_3$ used affects the mechanical properties in the product, i.e. the resulting self-healing elastomer. Thus, by adjusting the amount of $B_2O_3$ a variety of products having different mechanical properties according to the practical applications can be achieved. Increasing amount of $B_2O_3$ can be beneficial to a certain extent in the multiphase elastomer as the number of cross-links can be increased, because there is $B_2O_3$ nanoparticle residue left in the final product.

The intermediate product produced by reacting $B_2O_3$ and PDMS-OH has a surprisingly large amount of dynamic bonds, or dipole-dipole interactions, that contribute to the intrinsic self-healing ability. The supramolecular dynamic bonds, such as hydrogen bonds and dative bonds between boron and the oxygen in the Si-O groups, allow self-healing ability to be maintained without deterioration over time.

The boron trioxide nanoparticles are present in the final product, i.e. the boron trioxide nanoparticles are not solved or otherwise disintegrated below detection level and can be detected microscopically. The products prepared by the present methods can be identified by simple optical methods, such as under optical microscopy or using UV-vis NIR spectroscopy.

However, the properties of the elastomer matrix used for DLME and ECLME can be further adjusted and controlled by adding one or more of surfactant(s), and amount of the surfactant(s) in relation to the elastomer components, and/or so-called one-dimensional fillers, such as any type of nanotubes, nanofibers, nanowires, nanorods, and/or nanofilaments. "One-dimensional" in general refer to fillers that have one of their dimensions less than 100 nm, such as less than 50 nm or 10 nm. As used herein they may refer also to materials having elongated structure, wherein the (average) thickness or diameter of the material is at nanoscale range, such as in the range of few nanometers, for example 0.5-5.0 nm, or 0.5-2.0 nm.

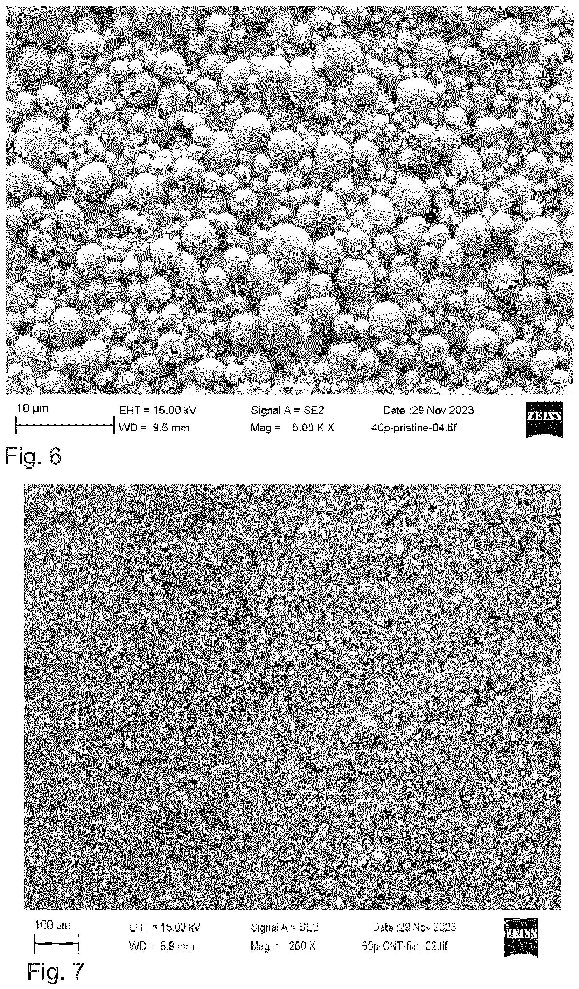

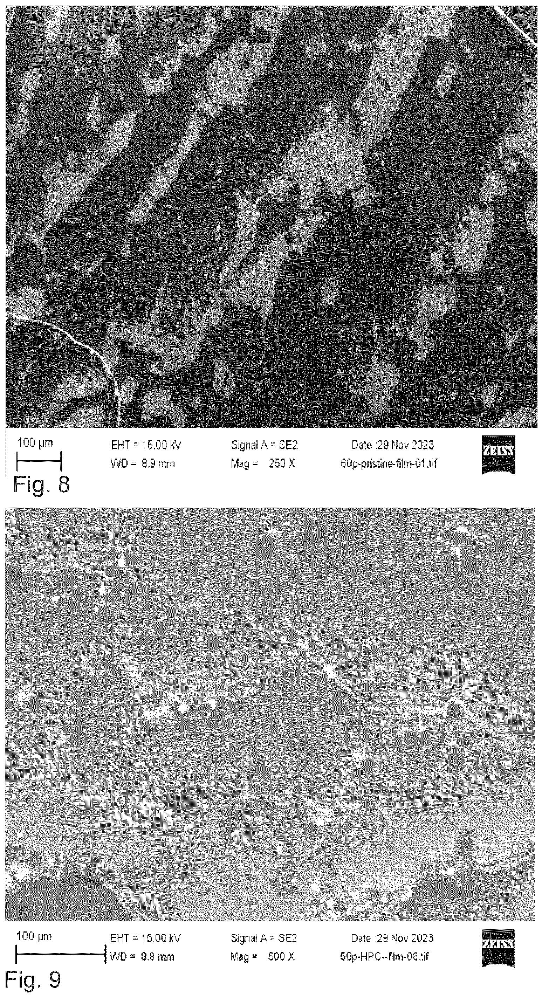

Especially when the amount of the liquid metal increases, such as in the case of electrically conductive elastomer composites, the homogeneity of the composite can be greatly improved by using fillers, such as carbon nanotubes. As can be seen in the SEM images of Figures 7 and 8, the addition of carbon nanotubes prevents the agglomeration of liquid metal particles when present in a large portion, and also enables even distribution of the particles in the composite. This is important when it is desired to obtain homogenous materials. However, the carbon nanotubes also have an impact to the electrical and dielectric properties of the elastomer composite even at small volume, which has to be taken into account.

Carbon nanotubes may be provided in the range of 0.5-5.0% by weight of the total elastomer composite. However, smaller amounts may be preferred to avoid decrease of electrical conductivity and more limited stretching range, such as in the range of 0.5-2.0% by weight, 0.5-1.5% by weight or preferably 0.5-1% by weight, even 0.5-0.9% by weight.

One or more surfactants and/or fillers may be added or included. The addition of surfactants and/or one-dimensional nanofillers will influence the final properties of the liquid metal elastomer, such as stretchability, Young's modulus, toughness, resilience, rate and efficiency of self-healing, long-term structural stability. Generally, surfactants have plasticizing effect to the elastomer, thus, e.g., the material becomes softer and polymer chain mobility increases leading to better self-healing (but in some cases at the expense of mechanical properties and dimensional stability of the material). Addition of one-dimensional nanofillers have opposite effect for the bimodal self-healing elastomer. They not only increase the strength and Young's modulus, but the material becomes more dimensional stable (i.e., better creep resistance) and elastic.

The present self-healing elastomer composites 20 can be prepared and provided without additional fillers or with additional fillers 12.

A self-healing elastomer composite without additional fillers

In one embodiment the method comprises providing the one or more components (16, 18) by providing separately the following components, the percentages referring to the total weight of the elastomer matrix (electrically insulating phase):

· 0.1-5 wt.% of boron trioxide ($B_2O_3$), preferably as nanoparticles having a number-average diameter in the range of 50-200 nm, preferably 80-100 nm, measured microscopically, for example by using electron microscopy, such as SEM, and

. 65-90 wt.% of hydroxyl-terminated polydimethylsiloxane (PDMS-OH)

. 5-30 wt.% of polysiloxane precursors comprising

- a first composition/component (A) comprising a siloxane base, and
- a second composition/component (B) comprising a siloxane crosslinker, preferably wherein the ratio by weight of the first composition/component (A) to the second composition/component (B) is 1:1 to 50:1,

- combining the $B_2O_3$, the hydroxyl-terminated polydimethylsiloxane, optionally one or more surfactants (S1), the polysiloxane precursors and the first mixture (M1), thereby obtaining the third mixture (M3),
- reacting, such as allowing reaction to take place in, the third mixture (M3) to set/cure the third mixture, preferably at an elevated temperature in a range of 50°C -150°C, to obtain the self-healing elastomer composite (20).

One example provides a method for manufacturing a self-healing elastomer composite, comprising providing

·0.1-5 wt.% of boron trioxide (($B_2O_3$), preferably as nanoparticles
· 65-90% of hydroxyl-terminated polydimethylsiloxane (PDMS-OH)
·5-30 wt.%, when measured in combined, of polysiloxane precursors, being

- first composition/component (A) comprising a siloxane base, preferably a polymer containing at least one ethylenically unsaturated group, and preferably also a branched siloxane-based polymer, and optionally a surface modifier which preferably contains at least one ethylenically unsaturated group; and
- a second composition/component (B) comprising a siloxane crosslinker,

where the ratio by weight of the first composition and the second composition is 1:1 to 50:1;

- combining, such as homogeneously mixing, $B_2O_3$, PDMS-OH, and the first composition, thereby obtaining a mixture,
- reacting the mixture and the second composition at an elevated temperature in a range of 60-150°C, to obtain the self-healing elastomer composite (20).

Polymer chain length has an effect to the properties of the matrix and the elastomer composite. The effective amount of net/junction points (or "cross-links") increases as the length of the polymer chains increases as the strands occupy "larger" three-dimensional space in a state of the highest conformational entropy (that is without stress).

As the molecular weight of the precursor is increased, both the stress at break and strain at break of the elastomer matrix significantly increased due to the number of entanglements increasing.

By increasing the proportion of the second composition (B), the cross-linking structure of the elastomer matrix increases, thus leading initially at larger phase separation, for example when ratio changes from 10:1 to 5:1.

Step 2 - LM and alloying process:

The used Ga-based liquid metal can be any of those described herein. If the material needs to function at low temperatures, then the used LM should have the lowest possible melting point. For example, $Ga_{61}In_{25}Sn_{13}Zn_1$ has a melting point of 8°C.

In one example for Ga-In systems the preferred compositions are therefore $Ga_{99}In_1$ - $Ga_{68.3}In_{31.7}$. More preferably in the range $Ga_{79.5}In_{20.5}$ - $Ga_{71.5}In_{28.5}$, and the most preferably $Ga_{75.5}In_{24.5}$.

In one example for Ga-In-Sn systems the preferred compositions are between $Ga_{60}In_{22}Sn_{18}$ - $Ga_{80}In_{14}Sn_6$, more preferably in the range $Ga_{65}In_{22}Sn_{13}$ - $Ga_{72}In_{18}Sn_{10}$, and the most preferably $Ga_{68}In_{22}Sn_{10}$.

Ideally, for alloying, the purity of the metals is 99%-99.999% by weight, preferably 99.9-99.999% by weight, and more preferably 99.99-99.999% by weight. A higher purity is preferred, but this can increase the cost of the elements. With lower purity metals (< 99%), the small amount of trace elements (1%) can lead to change in the chemical and physical properties of the metal alloy. Thus, the purity of metals used to form the LM can also affect the final properties of the DLME and ECLME.

Ideally, during metal alloying, the heating of the mixture of metals is done close to the melting point of the element with the highest melting point. The mixture chosen of metals can be further mechanically mixed during heating to improve the alloying process. This step needs to be done before the ultrasonication.

It is also possible to use commercial liquid metals that are already mixed at a specific ratio. However, the purity of the material is important in any case.

Step 3 - Descriptions of mixing method(s)

Four suitable mixing methods are presented for the preparation of the dielectric liquid metal elastomer composites (DLME) and the electrically conductive liquid metal elastomer composites (ECLME) (Figures 2-5 corresponding to methods 1-4). Four of them are applicable for the DLME (methods 1-4), and three of them for the ECLME (methods 2-4).

In these methods, the first step is to prepare a liquid metal microparticle (LMMP) paste that can be mixed together with the elastomer components.

In Method 1 (Figure 2), the LMMP (from the chosen metal alloy (step 2)) are made without any additional fillers (also referred as "$\mu LM$") by probe ultrasonication in a solvent. In principle, this method is only applicable for the DLME. The amount of LM needed for the mixture is calculated in relation to the amount of the elastomer components (step 1).

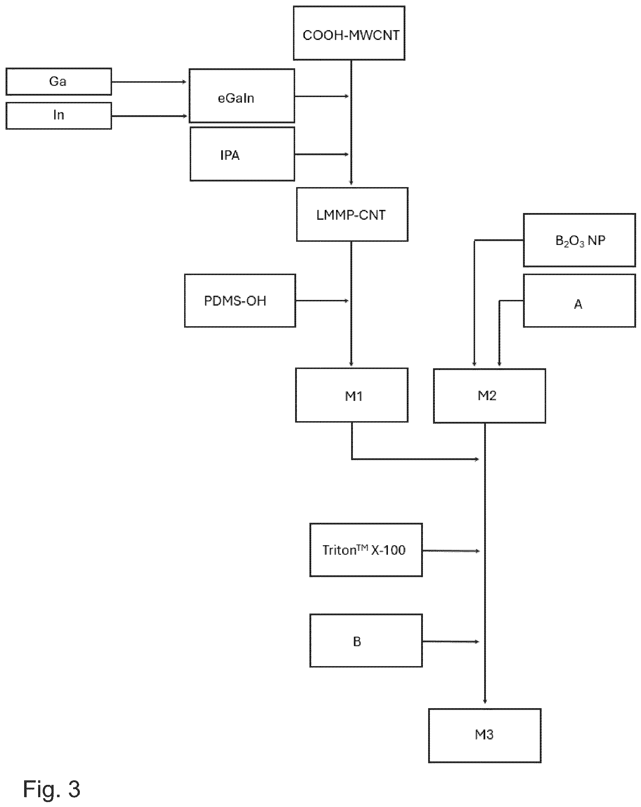

In Method 2 (Figure 3), specific amount of carbon nanotubes, such as carboxylic acid (COOH-) functionalized multiwalled carbon nanotubes (MWCNT-COOH), are added together with the LM and the solvent for the probe ultrasonication. When CNTs are used to form the LMMP with CNT (also referred as "*μLM-CNT*"), isopropanol alcohol/isopropanol/2-propanol (IPA) was found to be a good solvent.

LM-CNT refers to liquid metal interconnected carbon nanotubes. LM-HPC refers to liquid metal (LM) interconnected hydroxypropyl cellulose (HPC). μLMMP-CNT refers to microparticles of the liquid metal intercon-nected carbon nanotubes. μLMMP-HPC refers to micro-particles of the liquid metal interconnected hydroxypropyl cellulose. μLMMP-CNT-HPC refers to microparticles of the liquid metal interconnected carbon nanotubes and hydroxypropyl cellulose.

For the DLME, the amount of liquid metal shall be 45% by volume or less, such as in the range of 0.1-45% by volume. The amount of CNTs may be in the range of 0-2.25% by volume, or it may be more than 0 vol.%, such as in the range of 0.01-2.25% by volume.

In one embodiment the elastomer composite is electrically insulating elastomer composite comprising 45% or less by volume, such as 40% or less by volume, 5-45% by volume, 35-45% by volume, for example 5-40% by volume, of an electrically insulating phase comprising gallium as main phase.

For the ECLME, the amount of LM needs to be above 45% by volume, such as 50% or more by volume, preferably 55% or more by volume, such as in the range of 45-90% by volume, in the range of 50-85% by volume or in the range of 55-80% by volume.

In one embodiment the elastomer composite is electrically conducting elastomer composite comprising 55% or more by volume, such as 55-85% by volume, for example 60-80% by volume or 60-75% by volume, of an electrically conducting phase comprising gallium as main phase.

The amount of CNTs may be more than 0% by volume, such as in the range of 0.01-2.25% by volume, for example 0.1-1.50% by volume or 0.1-1.0% by volume.

It was experimentally shown that the added functionalized CNTs can stabilize the dispersion and prevent excessive precipitation after settling for a longer period of time. Also, the addition of the functionalized CNTs can improve adhesion of the LMMP to the elastomer matrix and to the substrate.

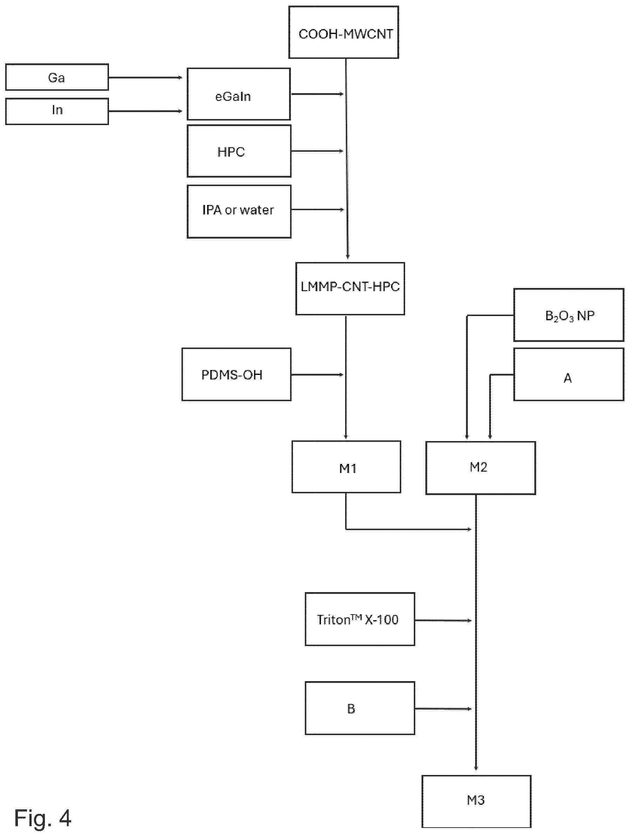

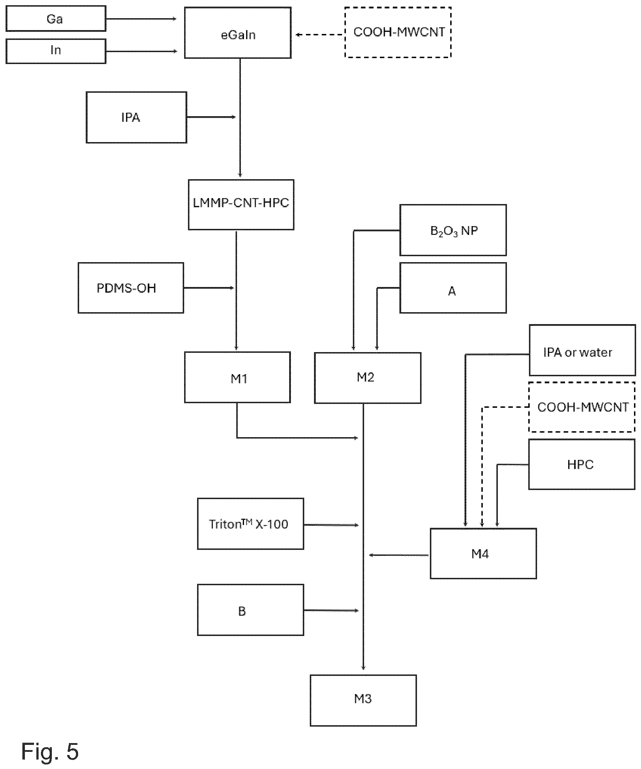

In the Methods 3 and 4 (Figures 4 and 5), specific amount of functionalized carbon nanotubes, such as COOH-functionalized multiwalled carbon nanotubes (MWCNT-COOH), and cellulose, such as hydroxypropyl cellulose (HPC), are added together with LM and the solvent for the probe ultrasonication.

The major difference between the methods is that in Method 3, all additional fillers are mixed with the probe ultrasonication at the start to prepare the LMMP with CNT and HPC (also referred as "μLM-CNT-HPC", or "LMMP-CNT-HPC").

Also, in Method 4, HPC is not added at the start

and μLM-CNT (or LMMP-CNT) is formed. HPC is mixed with solvent, and additionally CNTs can be added as well. However, the addition of CNT is optional in this method. If CNTs are added, they can be added at the start (to form μLM-CNT), to form M3, or in two parts when preparing both μLM-CNT and M3.

Step 4 - Mixing the LMMP paste with the elastomer components

The LMMP paste may comprise or consist of solvent and LM with either CNT, cellulose, or both CNT and cellulose, and can be denoted as μLM-CNT, μLM-HPC, μLM-CNT-HPC (or as LMMP-CNT, LMMP-HPC, LMMP-CNT-HPC).

The mixing process comprises the following in the methods 1-3:

1. After preparation of LMMP paste with the probe ultrasonication, the PDMS-OH component can be added to a glass vial, such as where the LMMP paste is mixed, such as mechanically mixed, for example with a lab spatula, to form a homogenous mixture 1 (M1). This step can be carried out in all the methods 1-4.

2. Boron trioxide nanoparticles ($B_2O_3$ NPs) are mixed with component A, for example by grinding in mortar with pestle, to form mixture 2 (M2). The mixing is continued until homogenous paste with uniform color is formed.

3. M1 is added to M2, and the mixture is mixed, such as grinded in mortar with pestle, to form homogenous paste.

4. If needed, an amphiphilic surfactant, such as Triton™ X-100, can be added to the mixture and mixing is continued. The amount of the amphiphilic surfactant is calculated in relation to the amount of elastomer components (step 1), and it may be in the range of 0.1-13% by weight. More preferably it may be in the range of 0.1-6% by weight, and most preferably it may be in the range of 0.1-2.5% by weight.

The mixing process comprises the following in the Method 4:

1. After preparation of LMMP paste with the probe ultrasonication, the PDMS-OH component can be added to a glass vial, such as where the LMMP paste was mixed, and mechanically mixed, such as with a lab spatula, to form a homogenous mixture 1 (M1).

2. Boron trioxide nanoparticles ($B_2O_3$ NPs) are mixed with component A, for example by grinding in mortar with pestle, to form mixture 2 (M2). The mixing is continued until homogenous paste with uniform color is formed.

3. M1 is added to M2, and the mixture is mixed, such as grinded in mortar with pestle, to form homogenous paste.

4. Mixture 3 (M3) is formed by ultrasonicating, such as by probe ultrasonicating, solvent and HPC, and additionally CNT. After ultrasonication, M3 can be added to the mixture made of M1 and M2.

5. If needed the amphiphilic surfactant, such as Triton™ X-100, can be added to the mixture and the mixing is continued. The amount of the amphiphilic surfactant is calculated in relation to the amount of elastomer components (step 1), and it may be in the range of 0.1-13% by weight. More preferably it may be in the range of 0.1-6% by weight, and most preferably it may be in the range of 0.1-2.5% by weight.

6. Component B (a crosslinker) is added to the mixture and the mixing is continued. The final mixture is referred to as mixture 4 (M4).

One embodiment comprises providing carbon nanotubes and/or cellulose as functional fillers and adding the carbon nanotubes and/or the cellulose to a mixture comprising the liquid metals, such as to the mixture of liquid metals, to the first mixture (M1), to the third mixture (M3), to a fourth mixture (M4) and/or to two or more thereof, preferably before applying ultrasound and/or adding the curing agent (B).

Outcome of Methods 1, 2, 3 or 4 is a homogenous elastomer composite paste, that can be further used for example in additive manufacturing or film formation or in any other suitable method used for forming the shape or form of the product (in Step 5).

The rheological properties of the composite paste must be controlled to fit the chosen method by adjusting the composition and amount of solvent(s). For example, the viscosity is easier to control precisely with compositions that also include either carbon nanotubes or cellulose, or both carbon nanotubes and cellulose as a part of composite. With the use of these components, increasing the viscosity of the composite paste is also possible. Thus, the method may comprise providing one or more of the additives or fillers as a rheology modifying agent and/or in an amount capable of adjusting rheology, such as viscosity. The rheology may be adjusted and/or controlled to a suitable range and/or value, so that the obtained compositing/composite is suitable for the intended use, such as for use as or in any application disclosed herein, for example as a depositable, printable and/or spreadable paste or mixture, such as a paste, ink, solution, or other composition or form suitable for additive manufacturing, thin film depositions and/or other applicable use.

## Step 5. Forming a product, and/or forming the shape and/or form of the product

The elastomer composite in the suitable form may be formed into a product, which may be an intermediate product or a final product. An intermediate product may need further processing, such as surface processing. In most cases the elastomer is formed into a film and/or into a coating on the surface. The term "film" used herein may also refer to a coating. The film or the coating may have a thickness in a broad range, such as in the range of 50 nm to 1000 micrometers, such as 50-1000 nm, 100-10000 nm, or 200-2000 nm, depending on the preparation method, composition of the elastomer composite, intended application and/or the like. The examples and embodiments referring to films may be also applied to other forms of the elastomer composites, such as to coatings which are not completely freestanding layers and/or planar, for example formed onto substrates with non-planar surface. Patterns of other shapes deposited onto surfaces, substrates and/or other target materials, such as by additive manufacturing, printing or other methods, may be considered films or may represent other forms of the (final) products.

Thin film deposition and additive manufacturing are examples of suitable methods for forming the product, shape and/or part thereof, for example for forming a film and/or a coating.

One embodiment provides the self-healing electrically conducting or dielectric elastomer composite printed, attached and/or deposited onto a substrate or other target material, such as a final product or part thereof. The elastomer may be patterned, wherein the patterning may be obtained later with the degradative methods disclosed herein.

One embodiment provides an electronic device comprising the self-healing electrically conducting or dielectric elastomer composite printed, attached and/or deposited onto a substrate or other target material, such as a final product or part thereof.

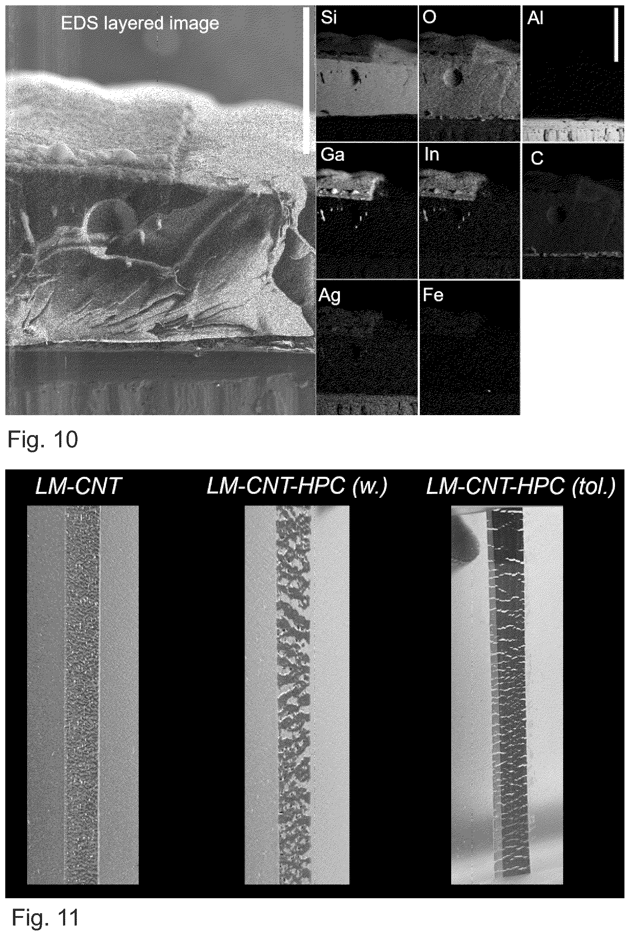

The substrate may be any suitable substrate, such as disclosed herein. Examples of substrates include films, and fabrics, which may be polymeric, or also made of glass or metal, or any other suitable substrate. However, the substrate is preferably soft and flexible, in which case the present self-healing elastomer composites can exhibit their advantageous properties. One example of a substrate comprises a polyethylene terephthalate (PET) film, such as a non-silicone coated polyethylene terephthalate film. Further examples of substrates comprise elastomer films, for example silicone rubbers or urethane rubbers, such as ones commercially available, for example Reynolds Dragon Skin™ or Vytaflex™. The substrate may be a self-healing elastomer. Figure 10 shows an example of liquid metal elastomer printed on a self-healing elastomer substrate, wherein also the elements of the structure are shown separately. Figure 11 shows different liquid metal elastomer compositions (LM-CNT, LM-CNT-HPC (water), LM-CNT-HPC (toluene)), printed on the Dragon Skin elastomer. If necessary to increase the electrical conductivity of the composite, such as by the laser processing, it may be desired to include an additional (non-conductive) self-healing polymer/elastomer as intermediate layer, or second substrate between the (first) substrate and the self-healing elastomer film. This was found advantageous for some soft substrate materials, such as rubbers, for example silicone rubbers.

Examples of suitable film preparation and patterning processes are described herein. All the methods are applicable for the DLME and ECLME elastomers.

In one embodiment the method comprises

- providing the self-healing elastomer composite as a paste or as a printing ink,
- providing a substrate, and
- applying, such as printing, the paste or the printing ink onto the substrate.

In one embodiment the method comprises

- providing the self-healing elastomer composite as a paste or as a flowable liquid,
- providing a substrate, and
- applying, such as casting or coating, the paste or the flowable liquid onto the substrate, preferably to obtain a coating on the substrate.

For directly printing into desired shapes, various printing and/or additive manufacturing methods can be used, e.g., direct ink writing (DIW), stencil or screen printing, microcontact printing (μCP), gravure or flexography printing, or even inkjet printing. Generally, methods that are more suitable for viscous pastes/inks/solutions are directly more suitable for the DLME/ECLME elastomers without additional rheological modifications needed to adjust to the viscosity.

For preparation of uniform thin films of DLME/ECLME elastomers, there are various methods that are available. For example, tape casting, blade coating, slot-die coating, bar coating, or even spin or spray coating. Some of these methods allow patterning *in-situ,* and continuous films can be further patterned with laser ablation after casting.

In one embodiment the method comprises

- forming the self-healing, electrically conducting or dielectric elastomer into a continuous layer, which may be a film, such as by tape casting,
- at least partly curing the layer, such as by heating and/or crosslinking the layer/film,
- treating the heated and/or crosslinked layer/film with laser to remove, such as evaporate and/or sublimate, solid elastomeric material from predetermined areas to form pattern(s) and/or to enhance electrical conductivity.

Direct patterning of functional materials can be carried out with a variety of methods.

Printing and additive manufacturing methods include direct ink writing (DIW), stencil printing, screen printing, microcontact printing (μCP), gravure printing, flexography and inkjet printing.

The direct patterning DLME and ECLME is possible, but not limited to, for example, direct ink writing (DIW), stencil or screen printing, microcontact printing, gravure or flexography printing, and inkjet printing. However, certain methods further comprise modifying the rheological properties of the elastomer composites of DLME/ECLME to achieve a good printing quality. For example, methods that require low viscosity are generally more difficult to directly apply as the base viscosity of the elastomer composite is relatively high, and to decrease the viscosity, the composition of the composite may need to be adjusted, especially the amount of solvent in the system. Methods that use thick paste or slurry are generally more applicable as the viscosity of the DLME and ECLME is often directly suitable without any major adjustments.

DIW is a micro-scale, computer-controlled, 3D printing technique where a viscous slurry is deposited to substrate, e.g., through a syringe with pneumatic pressure. The printing head and/or the platform can move in x-, y-, and z-directions enabling formation of two- and three-dimensional shapes. Generally, the printing thickness is influence by several factors, such as by viscosity, typically ranging from 10-1 to $10^3$ Pa·s, or $10^3$ - $10^6$ cP, and shape retention ability of the slurry, deposition rate, surface energy and roughness of the substrate, i.e., thickness of deposited material increases proportionally. The DIW enables fabrication of complex three-dimensional structures that are built layer-by-layer, while multiple printing heads can be also combined to deposit various functional materials simultaneously enabling multimaterial printing for rapid prototyping and fabrication of soft electronics devices. Because in most 3D printing methods the printed layers need to be self-supporting, there will be limitations to composition of the composite, printing dimensions and speed. The overall printing resolution of DIW is usually more than several tens of micrometers.

The viscosity of the DLME/ECLME elastomer pastes/inks can be controlled easiest by selecting a solvent to be used with CNTs. For example, IPA produces thicker paste with CNT than toluene. Also, the amount of CNTs, and the amount of solvent can be controlled and/or adjusted. The solvent can be also added, e.g., to PDMS-OH before mixing them with another components; the solvent should have good compatibility with the elastomer components. IPA and toluene were found to work well.

The elastomer composition and the amount of liquid metal is in many cases fixed, so there are not many other options to adjust the composition without influencing the properties of the composite. Adding surfactant is one possibility.

Stencil and screen printing are one of the most widely used printing techniques for electronics manufacturing on soft substrates due to versatility and cost-effectiveness of the methods for rapid prototyping. In the methods, functional paste/ink is transferred onto substrate through either a fine mesh or mask template, such as shadow mask. For screen printing, the mesh count defines the printing resolution, thus, the minimum printing resolution is above tens of micrometers (with mesh counts in the range of 20-320). In screen printing, the dispersed particles in the functional material must be smaller than the used mesh opening. For stencil printing this does not matter as there is no mesh when using a mask with only the openings. The fine mesh is strained to a solid frame, and the mesh apertures transfer the functional paste/ink to the substrate when the squeegee is moved and pressed against the mesh. Depending on the mesh count, the viscosities of the functional paste/inks are in the range of $10^{-1}$ to $10^1$ Pa·s which are obviously lower than for DIW printing. The deposited thickness of the functional material is then dependent, e.g., on the mesh thickness (i.e., holds more paste/ink), mesh tension and applied pressure as it affects the contact to the substrate, and the number of passes. In comparison, for stencil printing, the main deciding factor for the thickness of the deposited functional material is mask thickness and viscosity of the solution. With screen printing, fine features and high-resolution patterns are cumbersome to achieve as the resolution is limited by the mesh count. Stencil printing can achieve finer features and better resolution as there is no mesh, and the masks can be made, e.g., with chemical etching, photolithography, or laser ablation. However, because the thickness of the deposited layer is mostly dependent on the mask thickness, deposition of thin layers can be difficult. In general, the mask should be rigid and made of material with high Young's modulus to avoid any mechanical deformation during the printing to achieve a good quality (especially when printing onto soft matter).

µCP is high resolution, sub-micron scale printing technique where functional material is deposited onto patterned stamp, or master mold, which is then used to transfer the pattern to target material. The method is especially advantageous if functional materials need to be directly patterned on complex, non-planar 3D surfaces made of soft and elastic materials. The thickness of the deposited functional material is dependent on, e.g., pattern dimensions on the stamp, applied pressure when transferring the pattern to substrate. In addition, soft and elastic stamps are usually preferred with µCP as they conform better to the shape of the substrate resulting in more uniform deposition. The stamps are commonly made of poly(dimethylsiloxane) (PDMS) that can be patterned by, e.g., over-molding a photolithography-patterned silicon wafer, or by laser ablation. The first method allows extremely fine details for the PDMS-stamp. However, controlling the printing quality with the method is generally more difficult, e.g., as the adhesion between the elastomeric stamp, functional material, and the substrate needs to be considered and properly tuned to successfully transfer the functional material. Also, during transferring the functional material onto substrate, the deformation substrate and applied pressure may need additional considerations if the used substrate has low Young's modulus (less than 1 MPa), and the substrate is also very thin (only several hundreds of micrometers or less than that).

Gravure and flexography printing are high-volume throughput printing processes used by the industry for printed electronics manufacturing. While they share similarities in the roll-to-roll operation, in gravure printing the patterns are simply engraved to a cylinder that is partially submerged in the functional ink. After removal of the excessive material, the ink is left to the engraved recesses and can be transferred onto the substrate. In comparison, flexography printing uses flexible relief plates mounted on rotating cylinders. The ink is applied to the recesses on the plates when they are raised, which then transfers the ink to the substrate. Typical minimum resolution with these contact printing methods is close to the 10 µm with the viscosity of the functional inks being in the range of $5 \cdot 10^0$ - $5 \cdot 10^2$ Pa s. Similarly to stencil printing, the resolution in flexography printing is known to be limited by Young's modulus of materials from which the rolls are fabricated. This is because the fine features can be compressed during printing of the functional material leading to reduced pattern fidelity. In contact printing techniques, the capillary number (Ca) is important, and how it influences the flow and spearing of the ink. The Ca is dimensional quantity used in fluids dynamics to describe the relative effect of viscous forces to the surface tension forces (Ca = $\mu$V/$\gamma$, where $\mu$ is dynamic viscosity and V is characteristics velocity (e.g., printing speed)). For example, if the Ca is too large it can result in viscous forces dominating the flow of the ink leading to dripping and spreading beyond the desired boundaries. If Ca is too small, the surface tension dominates resulting in both poor wetting and spreading. Thus, the printing process for autonomously self-healing elastomers, composites and blends thereof can be optimized through by balancing the viscous and surface tension forces by Ca and understanding the process parameters (which are especially important in gravure and flexography printing due to their more complex operating principles).

In inkjet printing, the functional elastomeric inks are deposited by small nozzle that ejects droplets to the substrate, e.g. by using piezoelectric crystal. In the method, the droplet volume partly determines the thickness and resolution of the printed layer. While viscosity of the fluid affects the droplet formation, spreading and dying behavior. Thus, optimizing viscosity of the elastomeric ink is important and enabling proper wetting with low contact angle. In many cases the printing resolution of functional materials used for electronics manufacturing is around 360 - 720 dots per inch (dpi). The viscosities used in the method are generally lower than in other methods, e.g., in the range of $10^{-3}$ - $10^{-1}$ Pa·s, or $10°$ - $10^2$ cP. This level of viscosity requires rheological modifications to the used autonomously self-healing polymers, polymer composites and blends.

The viscosities disclosed herein may be determined by using a rheometer or a rotational viscometer, by using the measurement standards ISO 3219:1993 and/or ASTM D2196-20. Also, the following standards may be used: ASTM D445-24: Standard test method for kinematic viscosity of transparent and opaque liquids (and calculation of dynamic viscosity); ASTM D1824-16: Standard test method for apparent viscosity of plastisols and organosols at low shear rates; and/or ASTM D2196-20. Standard Test Methods for Rheological Properties of Non-Newtonian Materials by Rotational Viscometer.

Subtractive manufacturing methods: Laser ablation

The product, or the intermediate product may be further processed with degrading methods, which can remove material, for example from the surface and/or to form patterns or the like shapes. At this step subtractive manufacturing methods, such as laser ablation, can be used, for example to form patterns to DLME. These methods may be also used at a later point.

In short, these methods can be used to selective remove a material from the thin films and creating both two- and/or three-dimensional microstructures with high resolution. For example, a state-of-the-art laser system uses scanner-guided laser beam with wavelength close to 350 $\mu$m, as this is the most suitable for many different classes of materials.

This technique is explained in a more detailed manner in Step 7.

Thin film deposition methods for preparation of films

Thin film manufacturing enables versatile, scalable, and cost-effective deposition of functional materials onto various substrates. The methods involve deposition of thin films from solution-based precursors. The film can be deposited with tape casting, blade coating, bar coating, slot-die coating, spin coating and/or dip coating.

However, similarly to additive manufacturing methods, spin coating and spray coating are more difficult to directly apply as the rheological properties needs to be further adjusted for the purposes. When using DLME/ECLME composite paste/inks, the LMMPs can be easily oriented during film casting. The orientation needs to be considered in soft electronics applications, such as in sensing applications or when used for wiring or interconnecting the soft electronics circuits. The film formation and microstructure can be largely dependent on the evaporation of the solvent. In the case that the solvent evaporates, it needs to be close to the air interface and have sufficient energetic drive force to leave the film. With the evaporation, the film becomes more concentrated until film solidifies.

In tape or blade casting is a high-throughput method for fabrication of uniform thin films. The viscous solution (often called slurry) is spread across the surface with a casting blade to form uniform layer with controlled thickness. The gap between the casting blade and substrate defines the thickness of the layer before drying. Also, the viscosity of the solution, and coating speed play a role in determining the thickness of the layer. During drying, the thickness of the film further reduces due to evaporation of the solvent(s). The coating thickness (h) with blade coating before drying can be calculated as: $h = Q/vw$, where Q is volumetric flow rate of coating material ($m^3$ $min^{-1}$), v is the coating speed (m $s^{-2}$), and w is the width (m) of the coating blade. To know the coating thickness after drying, the solid content in the solution is necessary to know. The thickness of the dried film is then approximated by $h_d = h_w \cdot$ (solid content(%)/100%), where $h_d$ and $h_w$ are the thicknesses of the dried and wet film, respectively. The experimental measurements follow closely these equations.

Bar coating is similar to tape or blade casting, but instead of the casting blade, a cylinder bar with spiral wires is used for spreading the solution to the surface. The film thickness is mainly dependent on the gaps between the wires and substrate that control how much solution passes through to the surface of the substrate. In addition, applied pressure to the bar, coating speed, and viscosity of the solution influences the film thickness. More complex cylinder rod bars can be used for controlling the properties of the films without any compositional or chemical modifications of the material by simply controlling the orientation of functional fillers during printing. Generally, the minimum thickness of the film achievable with tape or blade casting, and bar coating is about ten micrometers.

Slot-die coating is roll-to-roll compatible thin film fabrication method that uses a narrow slot die head which is positioned close to the surface to deposit the functional material as the substrate moves. The solution flow rate from the reservoir to the slot die head is controlled precisely, e.g., with peristaltic (e.g., syringe pump) or rotary displacements (rotating elements transfer the solution). The slot die head is the most important design consideration in the system as it controls the distribution of the solution. The slot die head comprises parts such as inlet, manifold, shim, slot, and land which all can be adjusted to further control the meniscus. The method is generally considered more complicated than tape/blade casting or bar coating. For example, Poiseuille flow equation is generally used to describe the laminar flow of the Newtonian liquid as it passes through the narrow gap in the slot die head:

$$Q = (\Delta P \pi r^4)/(8\eta L),$$

where Q is the volumetric flow rate of fluid, $\Delta P$ is pressure

drop across slot die, r is the radius of the slot die, $\eta$ is the viscosity of the fluid and L is the length of the slot die. This equation is relevant in the process as it helps to determine the flow rate and pressure needed to achieve uniform and precise coating at desired thickness. The advantages of the method are in thickness of the films achieved (up to nanometer range) and the uniformity of the films as they are considerable better if the process is controlled in adequate manner, while two-dimensional patterning is also possible due to movement of the substrate.

Spin coating is well-adopted laboratory-scale method for research and development purposes for fabrication of thin films by spearing a solution across a surface when the substrate is rotated at high speeds (typically above 1000 rounds per minute (rpm)). The diameter of the substrate is generally limited in comparison to other methods. Another drawback of the method is that the solution waste is high (> 90%) as most of the material outflows during the spinning. At the start, the fluid spins at different speeds to substrate but will eventually match the as drag balances rotational accelerations. When fluid level becomes level, the solution begins to thin due to the viscous forces. The evaporation of solvent dominates the thinning after the fluid outflow stops. There are various of method to approximate the film thickness (h); the simplest is given by $h \propto 1/\sqrt{w}$, where w is the spin speed. However, the equation is generally not very accurate in practice as the solution deposition thickness depends on various factors, e.g., concentration, solvent evaporation rate, etc. The method is generally difficult to apply for the autonomously self-healing elastomers as they are non-Newtonian materials (i.e., their viscosity increases significantly with the shear rate). The non-Newtonian behaviour and viscous solutions can lead to complex flow patterns, variations of the coating thickness across the surface, and poor quality in the final films. Optimizing the composition and spin coating parameters can be difficult if at the same time control of the viscosity of the solution is limited due to specific composition requirements. The spin coating is generally more applicable to elastomers that do not contain water as part of the solution.

In dip coating, the substrate is immersed in the elastomeric coating solution, and the solution wets the substrate during the immersion. The method can achieve extremely uniform films with thickness in nanometers. The minimum film thickness can be approximated through Landau-Levich equation as $h_{min} = (\eta U L)/(pg(cos(\theta)))$ , where $\eta$ is the viscosity of the solution, $U$ is the withdrawal speed, $L$ is the width of the coating, $p$ is the density of the fluid, g is gravitational acceleration, and $\theta$ is the constant angle between the fluid and substrate. Thus, the coating thickness is influenced by the viscosity of the solution, withdrawal speed, width of the coating, density of the fluid, and contact angle. The film quality and uniformity are dependent on, e.g., consistency in the withdrawal speed and good wetting. Similarly to spin-coating method, the solution waste in the method is high in comparison to other film coating methods, and the substrate size is also limited.

In overall, tape casting, blade or bar coating, and slot-die coating are the preferred methods for film fabrication for the autonomously self-healing polymers, composites, and blends (including DLME/ECLME) over the spin coating or dip coating. The rheological properties of the elastomers are also more suitable for these methods without significant compositional modifications.

### Step 6. Curing

After forming the shape, such as by additive manufacturing or film deposition (Step 5), the DLME or ECLME will be cured and cross-linked at elevated temperature. The temperature is decided by the self-healing elastomer matrix composition (step 1). For example, for EC7, the processing temperature is set to 70°C. Lower processing temperatures are also possible (e.g., even at room temperature), but this might influence the final properties of the liquid metal elastomers. In the case that the printing or film deposition system also contains a heating plate, the additional curing step may be unnecessary. In that case, the temperature on the heating plate is set to the required temperature of the elastomer composition/used elastomer composition in the ink.

### Step 7. Laser processing

This step is required if the patterning of a dielectric liquid metal elastomer was not done in the step 5, or if electrically conductive liquid metal elastomer is made.

During laser processing, the polymer phases are vaporized from the surface with some of the LMMPs (due to Gaussian beam). As the excitation rate by laser is not large enough to cause photochemical reactions in the LM, a photothermal process occurs where the absorbed energy from the laser beam is instantly transformed into heat. Heating of the LMMP cores leads to inhomogeneous thermal expansion coalescing LMMP cores as the metal oxide shell is ruptured during the laser ablation. Densification also occurs due to thermal diffusion causing temperature in the ECLME film(s) to increase. The LMMPs underneath the coalesced regions show coarsening and fusing effects which leads to further increase in the electrical conductivity (total increase of $10^5$-$10^7$ orders of the magnitude). The colour of the ECLME films typically transforms from light to dark grey after the laser sintering. The effect of laser-induced temperature increase to the growth of oxide layer can be neglected, e.g., due to coalescing of LMMPs that results in continuous electrical pathways in the ECLME films. The surface roughness of the polymer substrate films (to which the LM is deposited to) largely influences the outcome of the laser sintering. For example, too small MPs (d50 < 1 $\mu$m; d50 = mean particle size) can create discontinuous electrical pathways in the ECLME films on a substrate that has high surface roughness, thus poor electrical conductivity in the laser sintered ECLME films.

Applicability of the method for self-healing polymers, composites, and blends:

Sintering methods for LM inks and composites without self-healing polymers as a matrix have been found effective for achieving the breakage of the surface oxide skin and achieving formation of well-connected electrical pathways in the coalesced and fused regions of LM throughout the film. In mechanical sintering the stress needed to break the surface oxide layer can be adjusted by the size of LMMP. However, the common sintering methods have not been yet shown to work for LM-based elastomer composites, where a self-healing polymer matrix is used. Thus, the achievable level of electrical conductivity has been very limited with the mechanically and electrically self-healing elastomer composites proposed in the state-of-the-art.

For example, in many cases the mechanical sintering method does not work for autonomously self-healing materials when, e.g., extremely large compressive (> 1 MPa) or tensile stress (>100%) is applied in order the rupture the surface oxide due to viscous nature of the materials. The conductive LMMPs are easily electrically insulated again by the surrounding polymer matrix.

Moreover, many autonomously self-healing materials cannot withstand the large stresses (which are needed to mechanically sinter the materials) without experiencing a permanent deformation due to viscous flow and polymer chain slippage as the materials are stressed over their elastic limit. Similar also occurs over time, in a relaxed state, resulting in loss of properties over time. In other words, lack of high resilience and poor creep resistance are some of the reasons why the typical sintering methods do not often work for autonomously self-healing composites. Another consideration is that autonomous self-healing polymers do not necessarily have a fixed or permanent shape which results in limited dimensional stability for the long-term, and especially when repeatedly deformed or damaged.

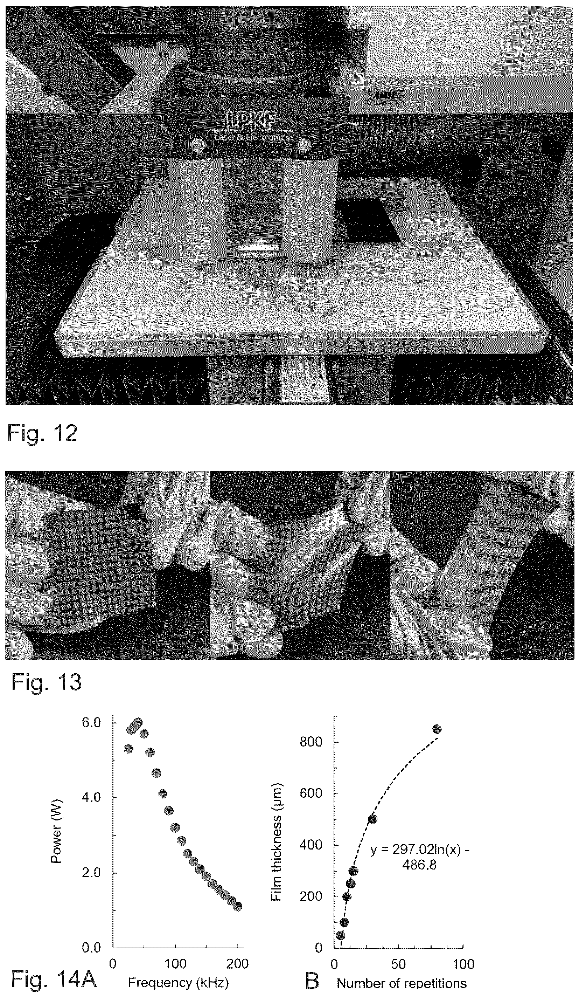

In the case of laser-sintering, the photothermal process (i.e., absorbed energy is instantly transformed into heat) results in a localized heating in the polymer film. Due to provided thermal energy, the molecular chains have more kinetic energy (i.e., absorbed photons interact with the atoms/molecules in the polymer leading to excited electrons) increasing the flexibility and mobility of the polymer chains, thus resulting in breakage of dynamic reversible bonds and intrinsic flow in the polymer network, if melting and decomposition can be avoided. Therefore, a higher temperature generally promotes faster self-healing rate and makes the patterning more difficult with the laser ablation for self-healing materials where the chemical bonds are sensitive to temperature changes. Because the autonomous self-healing polymers in a form of films are often thick, highly viscous, and the flexibility and mobility of polymers is increasing with the temperature, it can be cumbersome to permanently pattern such materials with fine features, and good pattern fidelity. Moreover, a lack of long-term structural stability and poor creep resistance of the self-healing polymers can pose issues in maintaining the fine features over time if made of single polymer network due to gradual movement of the polymer chains resulting in creep. Also, generally, thicker autonomous self-healing polymer films are more difficult to completely cut through as the ratio of the depth of the cut to the thickness of the film is small. Therefore, the polymer film has time to self-heal at the cut regions before fully cut through (especially in the case also where the beam moves randomly around the patterning region/areas). Because the laser beam width is relatively small (tens of micrometers or less), and it only partially cuts the polymer network, the highly mobile polymer chains are wetting easily at the bottom of the damaged surfaces also as there is no misalignment at the cut-surfaces. This mechanism significantly reduces the effectiveness of the laser processing depending on the polymer material system, laser processing method and laser processing parameters. Figure 12 shows an example of laser processing of the elastomer composite film.

Laser ablation for the developed self-healing elastomer composites

In the present invention it was found out and demonstrated that the laser ablation is a feasible method for the autonomously self-healing polymers, composites and blends (including even the ones that are optically transparent at the visible spectrum (380 nm to 700 nm)) when the laser processing parameters are carefully controlled. However, using the laser ablation for the autonomously self-healing elastomers with high optical transparency may either require modifying the optical properties with small amount fillers, and/or needs a laser system that operates at UV range. The excellent patternability with the proposed materials with the laser ablation enables fabrication of complex two- and three-dimensional functional elastomeric structures with fine features and high patterning fidelity limited only by width of the laser beam. Figure 13 shows an example of a three-dimensionally patterned self-healing elastomer composite film. The individual patterned film layers can be self-bonded together via self-healing enabling seamless integration of different functional materials together and building soft material-integrated electronics with the ultimate compatibility, as all materials are also based on the same base polymer/polymer system. After self-bonding the layers together, the layers cannot be separated without breaking the structure completely, making the soft polymer electronics devices ultraresilient, robust and reliable.

The key for achieving the patternability with the autonomously self-healing elastomers is based on the unique chemical and physical properties of base material, e.g., (i) having a fixed and permanent shape after cross-linking (due to the double network structure with combination of soft and hard chain segments), (ii) high resilience, (iii) good thermal stability, and (iiii) reversible dynamic bonds that respond to the increase of temperature by reducing the flexibility and mobility of polymer chains.

It can be noted that (i) these double-network elastomers can achieve a fixed shape after complete cross-linking which means they are also capable of maintaining their original three-dimensional shape in long-term even after repeatedly deformed or broken apart. The long-term dimensional stability is also important for maintaining shape of the elastomer after being patterned two- or three-dimensionally with fine features.

(ii-iii) The strong entropic elasticity resulting in high resilience is associated with the microphase-separated interfacial regions capable of providing stable junction points in the double-network even under large stress. The high resilience is important for maintaining the desired patterns when the patterned film, for example, transferred to other functional layers in the process of fabricating film-based, material-integrated soft electronics with the ultimate compatibility. The elastomers show high thermal stability up to temperatures about 300-500°C, or exceeding, which is particularly important for the laser processing. The high thermal stability reduces the possibility of thermal damage during laser ablation and allows more process control in terms of the used lasering parameters, and layer transfer/bonding. Figure 14 shows power of the laser as a function of A) laser frequency and B) measured cured film thickness as a function of number of repetitions required to complete cut through the film.

(iv) The dynamic reversible bonds in the soft phase are known to be highly sensitive to presence of water molecules due to reversible hydrolysis /condensation which increases the supramolecular interactions of Si:O-B bonds as additional free groups may appear. During heating the chemical and network structure of the elastomer changes due to the dehydration resulting in condensation of boranol groups into boroxane linkages that reduces the flexibility and mobility of the polymer chains in the soft phase. The boranol groups ($-B(OH)_2$) at the polymer chain ends undergo a condensation reaction within the elastomer network leading to formation of boraxane (-B-O-B-) linkages. In other words, the removal of water from the boranol groups leads to formation of these linkages which results in more interconnected and cross-linked rubbery-like boroxane elastomer that further promotes the elasticity of the network. Thus, condensation of ($-B(OH)_2$) improves the laser ablation by also reducing the self-healing speed of the polymer during the photothermal process. The dehydration typically occurs near the low cross-linking temperature of the double-network elastomer. The dehydration of the elastomer network is also beneficial as the water vapor can absorb the laser energy which affects the distribution and intensity of the laser beam during the processing. Thus, dehydration can result in more effective laser ablation. Because the elastomer network is in hydrated state before the laser processing, it can be advantageous for few other reasons. The water vapor on the surface can reduce the scattering of laser beam by providing a homogenous medium with similar refractive index to the polymer, thus leading to better penetration of the laser beam. Moreover, the water vapor can act as thin thermal barrier layer preventing the localized overheating by distributing the heat more evenly and help in mitigating the thermal stress by cooling the surrounding area, thus reducing thermal gradients within the elastomer, and further reducing the risk of thermal damages.

Film requirements for laser processing (and layer transfer)

In Step 5, the autonomously self-healing elastomers, composites and/or blends are deposited to chosen substrates. The substrates can be either donor or acceptor films, that both are used for building material-integrated electronics layer-by-layer. The deposited, specific functional layers on the substrate, or within material structure, can also have either a single layer or comprise or consist of multiple layers made of the same material, or a similar material with adjusted composition. The individual layers can be made either a single material or multiple different materials (dielectric, conductive, and/or semiconductive) with specifically adjusted composition.

In the case that the films are continuous and made with the film deposition methods, the film(s) on the substrate can be two- and/or three-dimensionally patterned with the lasering.

In the case that the films are patterned with the additive manufacturing methods, the printing method defines the resolution limit for the patterning because the laser ablation resolution limit is lower than achievable with any of the printing methods. The three-dimensional patterning with the laser can be then used to further modify the surface of the patterned film(s) or used for laser sintering in the case that there is printed ECLME film layer.

The ECLME film layer can be either non-patterned, or pre-patterned with the printing method. In the case that the ECLME layer is not patterned, the laser sintering can be used to both pattern and sinter the film simultaneously. In the case that the ECLME film is pre-patterned, the patterned regions can be laser sintered. A sintering may be considered as a pattern.

Generally, the thickness of the film to be patterned, such as autonomously self-healing polymer, elastomer film, composite and/or blend layers may be in the range of 1-1000 $\mu$m, preferably in the range 1-200 $\mu$m, and more preferable in the range of 5-100 $\mu$m or

20-100 $\mu$m. Film thickness in the range of 20-50 $\mu$m, such as 25-40 $\mu$m, was found preferable to produce high quality printed films. However, the layers can be thinner than 1 $\mu$m, if possible, with the film fabrication method, down to nanometers range, such as with slot-die coating. In such cases the thickness of the film may range from for example 100 nm, or from 500 nm, up to the micrometer ranges discussed herein, such 100 nm to 1000 $\mu$m, for example 500 nm to 1000 $\mu$m or 500 nm to 200 $\mu$m. Generally, thinner films are preferred for both two- and three-dimensional patterning to reduce the probability of thermal damage, and possible material residue on the surface of the patterned films. In the case that thick films are used, the cutting or engraving depth should be minimized. When using thick films, deep engraving or total removal of the films is not often advisable due to possible residue and debris that can be generated on the substrate/film which is then difficult to completely clean.

For ECLME films and other conductive layers comprising and/or made of autonomously self-healing polymers, elastomer films, composites or blends the thickness is most preferably in the range of 5-100 $\mu$m. Generally, the thickness of conductive film layers, or conductive parts in material-integrated soft electronics design should be closer to tens of micrometers to avoid unnecessary increase of resistance, if the feature size is also small. This is because the resistance is inversely proportional to the cross-sectional.

The color of the autonomously self-healing polymers, elastomer films, composites, and blends can be adjusted for the laser processing beforehand if needed in order to reduce laser beam scattering with materials having high optical transparency.

Disclosed is a method for patterning a self-healing film, and/or for laser sintering a self-healing film and/or for improving/enhancing electrical conductivity of a self-healing elastomer film. The method for improving/enhancing electrical conductivity of a self-healing elastomer film may be a method for surface-treating the film. The method may comprise

- providing a programmable laser processing system,
- providing a predetermined design model in a program code format for forming one or more patterns, for forming one or more sintering(s) and/or for treating a surface of an object, to program the laser processing system with the design model to cause the laser processing system to form the one or more patterns, sintering(s) and/or surface treatment(s) to an object when operated,
- providing a self-healing elastomer film on a substrate,
- at least partly curing, such as heating and/or cross-linking, the self-healing elastomer film, before processing with the laser, to obtain at least partly cured film,
- providing the at least partly cured self-healing elastomer film to the laser processing system as the object,
- treating the at least partly cured film with the laser processing system to partly or completely remove, such as evaporate and/or sublimate, solid elastomeric material from predetermined areas with the laser to form patterns, such as pattern shape(s), sintering(s) and/or surface treatment(s) defined by the design model to the self-healing elastomer film, to laser sinter the self-healing elastomer film and/or to remove oxide layer from a surface of the film to improve electrical conductivity of the self-healing elastomer film. A laser-treated film is obtained. A surface treatment, such as the removal of an oxide layer, may comprise and/or be carried out as a pattern, which may cover a part of the film or the whole area of the film.

One example provides a method for laser sintering a self-healing liquid metal elastomer composite film and/or for improving/enhancing electrical conductivity of a self-healing liquid metal elastomer composite film, the method comprising

- providing a programmable laser processing system,
- providing a predetermined design model in a program code format for forming one or more patterns and/or treatments (to an object) to program the laser processing system with the design model to cause the laser system to form the one or more patterns to an object when operated,
- providing a self-healing liquid metal elastomer composite film on a substrate,
- at least partly curing the self-healing liquid metal elastomer composite film, before processing with the laser, to obtain at least partly cured film,
- providing the at least partly cured film to the laser processing system as the object,
- treating the at least partly cured film with the laser processing system to partly or completely remove, such as evaporate and/or sublimate, solid elastomeric material from predetermined areas with the laser to remove oxide layer to improve electrical conductivity of the self-healing elastomer film. A laser-sintered and/or an electrical conductivity-improved/enhanced film is/are obtained. The terms improve and enhance may be used interchangeably.

The object refers to the object of the laser treatment, which may be the films discussed herein. The laser treatment may be any of the treatment disclosed herein, such as patterning, sintering, surface treatment, removal of oxide layer and/or improvement/enhancement of conductivity. It was found out that not only the presently disclosed liquid metal composite films benefit from the laser processing methods, but also other elastomeric films and/or composites and/or products may be applied as objects as well. The self-healing films discussed herein may comprise an elastomer, an elastomer composite, and/or elastomer blend, or combination thereof. The film may consist of a single film or layer, or it may comprise or consist of two or more films or layers, which may be layered or laminated together. However, when such film is patterned, all the layers are patterned at the same time. In the case of sintering liquid metal composite films there is always two or more layers, because such film cannot be transferred from a donor substrate, but it must be prepared directly onto another layer of the final product.

The self-healing elastomer film may be any suitable self-healing elastomer film, which can be patterned and/or sintered by laser. The self-healing elastomer film may be autonomously self-healing elastomer film. The self-healing elastomer film may be a composite film, i.e. a composite in the form of a film, or other suitable substantially planar or sheet-like structure, which can be patterned or otherwise treated with the present method.

The self-healing elastomer film may comprise an elastomeric matrix comprising a polyborosiloxane-based polymer and a polydimethylsiloxane-based polymer, such as disclosed herein.

The self-healing elastomer film provided for laser treatment, patterning/sintering/treatment may be on a substrate. If necessary to increase the conductivity obtained by the laser processing or other properties required in the process, a non-conductive self-healing polymer/elastomer may be provided as intermediate layer between the substrate and the self-healing elastomer film. The intermediate layer may also be electrically conductive.

In the patterning method it is desired that the patterned film must be able to be transferred from one substrate to another. The self-healing elastomer film is provided on a substrate, which may be a first substrate. It may be prepared onto the substrate as a layer of material, a coating and/or a film. The type and material of the substrate is selected according to the use and purpose of the substrate, and according to the target wherein the treated film is to be transferred and/or applied. The substrate may be a donor substrate or an acceptor substrate.

Preferably the substrate does not permanently adhere to the materials/films to facilitate treatment when treated films are cleaned afterwards, and/or released and transferred to another substrate or to a product from the substrate. This is especially desired in the case of a donor substrate.

Preferably the donor substrate does not comprise a self-healing elastomer, unless the self-healing properties are weakened, such as via modification of chemical composition, to avoid too strong adhesion of the laser-treated film to the surface of the donor substrate. The donor substrate may be or comprise glass, silicon wafer, metal film and/or polymers other than self-healing polymers, preferably hard polymers, such as polyimide and/or polyethylene terephthalate. The surface of the silicon wafer and glass (sheet) have very high surface smoothness, so it may be necessary to prepare the materials onto these substrates.

In one embodiment the acceptor substrate comprises a self-healing elastomer. The acceptor substrate may be a final substrate, such as a part, a substrate or an encapsulating layer of the final product.

The elastomer, composite and blend film/layer/-coating shall be solid enough to be processable with the method. Therefore, a self-healing elastomer film is partly or fully cured before processing with the laser. Usually, it is preferred that the film is partly cured, and it may be fully cured at a later phase, such as after transferring to another material, such as to an acceptor substrate. The film may be cured by crosslinking and/or by heating. Self-healing materials, especially the materials and matrices discussed herein, may be usually partly cured by heating to about 70°C for 10-60 minutes. The (partly) curing facilitates the lasering accuracy and efficiency.

The self-healing elastomer film provided for laser treatment may be non-patterned or it may be pre-patterned by printing, such as by a printing method disclosed herein.

Two-dimensional patterning may be carried out with hatching, cutting, and/or drilling tool(s).

The thickness of the self-healing elastomer film provided for laser treatment is in the range of 0.1-1000 $\mu$m, such as in the range of 1-1000 $\mu$m, 1-500 $\mu$m, 1-200 $\mu$m or in the range of 5-100 $\mu$m, or any other range disclosed herein.

The method may comprise removing unnecessary portions from the laser-processed material. This can be done during the laser treatment and/or after the laser treatment, for example, by mechanically removing the unnecessary portions. Mechanical removal requires solid enough film, and that the cut-through of the material was successful. Preferably the film shall not be too thick.

The donor substrate may be a release substrate, or the film is releasable from the donor substrate, for releasing and transferring the processed film to another substrate and/or a final product. The donor substrate is selected according to the used material in the film, and according to the purpose of the laser-treated film. The film is to be released from the donor substrate, transferred and/or placed to a desired target, which may be another substrate, such as a second donor substrate, an acceptor substrate or another target, such as a product, preferably a final product to which the laser-treated film is intended to be included.

The method may comprise releasing the laser-treated film from the (donor) substrate and transferring the released laser-treated film to another substrate and/or to a product, which may be called a target substrate or a (target) product. A multilayer structure may be obtained or prepared, for example comprising two or more laser-treated films, or at least one laser-treated film, and one or more other films or other substrates.

The material of the laser-treated film shall be attached to the other substrate, or to the product, preferably with a higher adhesion than with the first substrate. Alternatively, the film may be released from the first substrate by using methods lowering the adhesion, such as by heating the layer, by swelling under water, or the like methods which do not damage the film.

If a functional electronic structure or device is made, the layers must be transferred in a certain order, either to another donor substrate (from which the entire structure is then finally transferred to the acceptor) or to the acceptor substrate. In practice, e.g. a component structure can be made either in the correct order (bottom-to-top) or upside down (top-to-bottom). In the latter, the component structure can be made e.g. on top of an encapsulation layer, while in the first, on top of the substrate. The third option is to make the structure partly on e.g. the substrate and partly on top of an encapsulation layer, after which substrate and the encapsulation layer parts are combined. The principle is to avoid deformation of active areas of the device while assembling the structure. That is, the way of stacking is chosen according to the materials used and the structure/device of the component.

If a functional structure is assembled layer by layer or made on e.g. a self-healing elastomer (acceptor substrate), then each transferred layer is first allowed to adhere for some time before the next layer is transferred and self-bonded. Self-bonding may be facilitated by heating the film structure after joining the layers before removing the donor substrate mechanically from the surface of the layer to be bonded.

A liquid metal elastomer layer can usually never be transferred from one substrate to another, thus it must be printed or applied on top of a final layer, which is either transferable to another substrate, or is the final substrate or structural part of the component or device.

Disclosed is a laser-patterned and/or laser-sintered, and/or (laser) electrical conductivity-improved/enhanced/surface -treated, self-healing film, such as a liquid metal film, obtained with the method for patterning self-healing films, with the method for laser sintering self-healing films and/or with the method for enhancing/improving electrical conductivity of a self-healing elastomer film. The preparation method can be detected from the final patterned and/or laser sintered and/or electrical conductivity-improved self-healing film by examining the product with common methods, such as by using microscopic methods to identify the laser processing made by programmable laser processing system and/or the structure of the product, such as seen from a cross-section. For example, it is not possible to obtain similar accurate patterning, depth of the treatment and/or other properties without using laser, which is computer-controlled, i.e. programmed. It is also possible to detect residue and/or debris left onto the films upon complete removal of the film from carrier substrate, for example in hatching. Also, other properties can be detected from the final product, such as conductivity, optical properties, self-healing properties, mechanical properties, electrical properties, deformation properties and the like. A liquid metal elastomer on a surface of other material can be characterized microscopically, such as using SEM to examine the surface of the material, and to characterize the material structure. The products can be disintegrated to monitor the behavior of the material/product. The detected properties can be compared with the properties of a reference product, which may be such as disclosed herein.

The laser-patterned, the laser-sintered and/or the (laser) electrical conductivity-improved self-healing film may have a conductivity of 800 S cm$^{-1}$ or more, such as 1000 S cm$^{-1}$ or more, or 2000 S cm$^{-1}$ or more, such as in the range of 800-14000 S cm$^{-1}$, for example in the range of 1000-10000 S cm$^{-1}$ or 2000-10000 S cm$^{-1}$.

Disclosed is a multi-layer film and/or product or part thereof comprising one or more of the patterned, laser sintered and/or electrical conductivity-improved/-surface-treated self-healing liquid metal elastomer composite films.

Disclosed is an electronic device comprising one or more of the patterned, laser sintered and/or electrical conductivity-improved/surface -treated self-healing liquid metal elastomer composite films, and/or one or more of the multi-layer films disclosed herein.

Disclosed is use of a programmable laser processing system for patterning a self-healing elastomer film, for laser sintering a self-healing elastomer film and/or for improving the electrical conductivity of a self-healing elastomer film with the method.

Laser systems and processing parameters

A suitable programmable laser processing system may be used. The laser processing system comprises one or more controllable laser devices, i.e. laser sources, and one or more programmable control unit(s), i.e. electronic controlling means, configured to operate the laser device(s) and/or the programmable laser processing system, according to a model and/or a program code. The laser device(s) may comprise and/or may be connected to one or more actuators, such as electrical motors, for directing the laser beam(s) provided by the source(s) of laser, such as by using controllable mirrors to direct one or more laser beams to an object, and preferably to move the laser beam(s) in orderly fashion to form patterns to the object. The actuator(s)/motor(s) is/are operatively connected to the programmable control unit. The programmable control unit is arranged to direct the laser beam to the object in a programmed manner. The system may comprise a platform or the like receiving part for receiving the object. The receiving part may be controllably movable by one or more actuators.

A predetermined model in the form of a (computer) program code may be loaded, programmed, formed, and/or specified in the system, i.e. the system may be programmed with the program code, and the system is arranged to control the operation of one or more laser devices/beams to process the target/object with the laser according to the model, such as to form one or more predetermined patterns specified in the model, and/or to use any specific methods for implementing the patterns, cutting and/or any other desired operation with the laser, such as by using hatching.

The program code comprises a predetermined design model of one or more patterns and/or treatments to form the pattern(s) and/or surface treatment(s), which may be provided in a suitable/specified format, which is compatible with the laser processing system. The laser system is programmed with the design model, preferably by providing the model in a program code format, wherein the laser system operates to form the pattern(s) on a target. The model may comprise information to carry out one or more treatments and/or to form layers of patterns, which may be formed on different films, and the model may comprise instructions to treat each separate leys in an individual manner, such as with different laser settings, with different tools and/or with other parameters and/or ways to control the treatment.

The model is provided in an electronic form, such as a file and/or a program code provided to the control unit. The model contains instructions, such as a model or a template of patterns and/or hatches to be formed in the target, and/or to form laser sintering or other treatment on the target, according to which the patterns, hatches, sintering and/or treatment is/are formed to the target by one or more laser beams. The patterning may be two dimensional and/or three dimensional.

A suitable file format is used, which is preferably compatible with common CAD software or the like, and with the laser processing system, and wherein the image/model can be edited and scaled without deterioration of the quality. One preferred file form is DXF, which is based on open source and provides two-dimensional vector graphics in standardized form. DXF also enable preparing several layers, which can be programmed to be implemented in different ways with the laser system software. These features are preferred by the software settings. Other suitable file format include SVG (scalable vector graphics, .svg, .svgz), EPS (.eps, .epsf, .epsi), STL (stereolithography, .stl), and Gerber file (.gbr)

The control unit comprises one or more processors and a memory, which is arranged to be programmed with the model or the like instructions for operating the system to process the target material with the laser according to the programming. The electronic controlling means, including the program code, the memory and the computer program code is configured, with at least one processor, to control the operation of the laser processing system. More specifically, the model may be or provided as a computer program product or a computer program code embodied on a non-transitory computer readable medium, comprising computer program code configured to, when executed on at least one processor of the programmable laser processing system or the control unit, cause the laser processing system to perform the method or part thereof.

A data storage medium may be provided to comprise the program code comprising and/or providing the model. The program code may be prepared separately, such as at a remote location and/or device, or the system may be programmed with a computer or other terminal connected to the system. The program code, i.e. a computer program code or program instructions, may be embodied in a network location, in a computer, in a physical data storage medium or in any other suitable source, which may be local or remote, and/or may be installed to the programmable laser system or to the control unit from such source. The expressions "data storage medium", "computer-readable medium" and the like medium include the sources. The program code is preferably run in a processor of the system and/or the control unit and may be embodied in a memory, such as a non-transitory computer readable memory or medium, of the system and/or the control unit or in an external or remote medium.

The laser processing system may be programmed to form laser sintering, three-dimensional patterning and/or surface treatment on the target/object.

A hatching tool can be used for laser sintering and/or for three-dimensional patterning. The laser processing system may be programmed to form hatch patterns on the target/object, such as the self-healing elastomer film, with a hatching tool, and/or to provide a hatching tool and/or a hatching function, wherein the hatching tool/function is configured to move the laser beam as one line at the time in an orderly fashion to form of a hatched pattern with a plurality of the lines as the predetermined pattern to remove material from the target/object/film on the hatched pattern.

The programmable laser processing system is arranged to receive and/or process a target, such as an object and/or a target object, which can be applied to the system, such as to a receiving portion of the system, which may comprise a planar surface to which a target is to be applied, and which can be processed with the laser device/source of the system. The target may be planar, such as the film or any other applicable product disclosed herein. The laser processing system uses suitable laser wavelength, which may be adjustable, and may be selected according to the properties and/or material(s) of the target/object. Preferably the wavelength is 400 nm or less, such as in the range of 100-400 nm, to avoid thermal damage in materials, and to enable treatment of optically transparent, translucent, and/or reflecting materials. Other properties of the system may be also controllable by the control unit.

One example of a suitable laser processing system is LPKF Protolaser U3, achieving a minimum cutting width of 18 μm with the laser beam width of 15 μm, i.e., maximum theoretical resolution limit is ~1400 DPI. The maximum size for the film that can be fitted into the system is 305 mm x 229 mm, while the working area that can be processed at once is limited to approx. 49.9 mm x 49.9 mm (or 2490.01 m$^2$). When the pattern is larger than 49.9 mm x 49.9 mm, the pattern will be automatically divided into multiple sections of similar size which can be controlled to some degree in the software. Each square will be processed one by one by the laser beam.

The laser processing parameters (frequency, power, jump delay, etc.) and their possible ranges are adjustable. The maximum power in the LPKF Protolaser U3 is frequency limited. Other parameters are also limited simultaneously, e.g., maximum mark speed is 500 mm s$^{-1}$ at 50 kHz frequency.

The laser processing system, such as the LPKF Protolaser U3, may work at wavelength of 355 nm which is generally well-suited for wide range of materials including variety of polymers. This is because the optical transparency of polymers and other materials quickly decreases below 380 nm due to absorbed ultraviolet radiation to the atomic and molecular structure. Particularly, in high molecular weight polymers, the more densely packed polymer chains can increase the UV absorption through interactions between the neighboring polymer chains and/or within the polymer backbone which can improve the cutting of materials. The 355 nm wavelength is also particularly good for reducing the possibility of thermal damage, and for achieving a higher spatial resolution with sharper edges.

Generally, any profile that can be used for partially cutting optically transparent or translucent, soft polymers (Young's modulus $\leq 10^0$ GPa) at visible wavelength (380 - 700 nm) works well for finding the starting profile settings for fine tuning of laser processing parameters for the autonomously self-healing polymers, composites, and blends made of same base material (having poly(dimethylsiloxane)-backbone)). The fine tuning of the profile is typically done mainly by controlling frequency, power, mark speed and number of repetitions. A good example of a commercial film in which laser processing parameters can be used as the starting point is Covestro Platilon® 4201 AU polyurethane (ether) film.

For patterning and/or laser sintering the autonomously self-healing elastomers, jump delay and speed, laser off- and on delay, and tool delay are less important parameters in comparison to frequency, power, mark speed and number of repetitions. However, in fine tuning the lasering profile for a certain material, all parameters may require to be adjusted one by one, and the quality in the films needs to be inspected after the laser processing with the optical microscope, or the like methods. Any sign of thermal damage or microstructural change is indication that the parameters need to be fixed, or if the cutting edges are not sharp.

Typically, the jump delay and jump speed are fixed to 1,000-1,100 μs and 1,000-1,100 mm s$^{-1}$, respectively. The laser off- and on delay to 200-400 μs and 0-100 μs, respectively, and tool delay to 0-100 ms.

Typically, frequency range of 25 kHz to 100 kHz is used for patterning and/or laser sintering. The maximum power with the laser system is then limited to $\leq$ 5.3@25kHz, $\leq$ 5.8 W @ 30 kHz, $\leq$ 5.9 W @ 35 kHz, $\leq$ 6 W @ 40 kHz, $\leq$ 5.7 W @ 50 kHz, $\leq$ 5.2 W @ 60 kHz, $\leq$ 4.655 W @ 70 kHz, $\leq$ 4.1 W @ 80 kHz, $\leq$ 3.65 W @ 90 kHz, and $\leq$ 3.2 W @ 100 kHz. The autonomously self-healing polymers, composites, and blends are laser patterned and//or laser sintered typically at the frequency of 25-100 kHz, preferably 30-80 kHz, and more preferably 35-75 kHz.

Although, the mark speed is also frequency dependent, the mark speed is typically set in the range 0-500 mm s$^{-1}$. As a rule of thumb, lower mark speed is preferred for the two-dimensional patterning, while higher mark speed is preferred for the three-dimensional patterning or laser sintering.

A typical starting profile parameters for two-dimensional patterning may comprise:

- Frequency 40 kHz
- Power 6.0 W
- Jump delay 1,000 μs and jump speed 1,000 mm s$^{-1}$
- Laser off delay 350 μs and laser on delay 50 μs
- Mark delay 400 μs s$^{-1}$ and mark speed 200 mm s$^{-1}$
- Repetitions 5, tool delay 50 ms

The frequency, power, mark delay, and repetitions are usually the first parameters to be adjusted depending on the material and its composition. Generally, the number of repetitions needs be increased when the thickness of the autonomously self-healing elastomer films increases to fully cut through the film. Figure 14 can be used as an approximate of the number of repetitions (x) needed to cut through a film of given thickness (x = e^(((y+486.8)/(297.02))), where y is the film thickness in μm)). Generally, autonomously self-healing elastomer compositions with longer self-healing recovery times (> 1 hour for partial or full recovery of tensile properties) may require less repetitions when the film thicknesses increase over 200 μm as the films are cut through more easily. If the self-healing rate is extremely fast (within minutes or less for partial or full recovery of tensile properties), it can be impossible to cut through thick films. The cuts made with the laser beam are likely self-healing faster than depth of the cut is increasing due to large number of repetitions needed to cut through the film in the first place, and random movement of the laser beam around the pattern. Thus, one location is not cut properly before moving to other part. Because the cut-surfaces are fully in physical contact, self-healing is extremely efficient with autonomously self-healing elastomers that are highly viscous.

Typical profile parameters for laser sintering of ECLME may comprise:

- Frequency 50 kHz
- Power 2.3 W
- Jump delay 1100 μs and jump speed 1000 mm s$^{-1}$
- Laser off delay 350 μs and laser on delay 50 μs
- Mark delay 400 μs s$^{-1}$ and mark speed 400 mm s$^{-1}$
- Repetition 1, tool delay 50 ms

The power should be adjusted depending on the composition of the eutectic mixture. For example, a liquid metal with lower melting point added to the elastomer requires application of lower power to be applied for the laser sintering. For example, for $eGa_{75.5}In_{24.5}$ the power is first set to about 2.3 W, and for $eGa_{69}In_{22}Sn_9$ the power is first set to about 2.1 W, before further adjustments are made. Typically, the laser sintering requires power in the range of 1.6-2.5 W with Ga-based metal alloys mixed with the self-healing elastomer matrix.

Electrical conductivity of ECLMEs (without strain)

As confirmed experimentally, the electrical properties of the liquid metal elastomers are mainly influenced:

- By the metal alloy composition forming the LMMP, and the amount of liquid metal in the relation to the total amount of elastomer components.

  - The choice of self-healing elastomer and its composition does not affect the electric properties of liquid metal elastomer.
  - Generally, a small amount of carbon nanotubes, such as less than 1.0% by weight, does not significantly affect the electrical conductivity assuming also that the volume loading of liquid metal is above the percolation threshold (55 vol.%)
  - Addition of hydroxypropyl cellulose improves the electrical conductivity due to LMMP segregation (above the percolation threshold for LMMP).

- The effect of the film thickness to the electrical conductivity is negligible. For example, 20-100 $\mu$m thickness is sufficient to produce high quality printed films. Thinner layers are not usually possible with the common printing methods without affecting the quality of the films or coatings.
- Printing and/or laser sintering direction influences the final electrical conductivity; either by improving or decreasing it.

  - Depending also on the substrate on which the liquid metal elastomer is made on, e.g., on substrate with poorer wettability, printing along the smallest dimension of pattern (in a case of simplistic line) is not often possible.

- Printing method

  - Generally, LMMP tends to orientate along the printing direction regardless of the method; however, certain methods can be more effective in aligning the LMMP during printing, e.g., using bar coating instead of screen printing.

- Choice of substrate plays a major role in the non-strained electrical conductivity achieved directly after the deposition and laser sintering:

  - On some substrates, the liquid metal elastomer is not electrically conductivity even after the laser sintering, e.g., Reynolds Ecoflex® 00-20 silicone rubber.
  - The electrical conductivity improves by factor of 1.6-1.8 on self-healing elastomers, if compared to conventional non-healable elastomers, e.g., EC7 (780-1620 S cm$^{-1}$) vs. Reynolds Dragon Skin® 10 medium silicone rubber compound (470-880 S cm$^{-1}$)
  - Printing on intermediate layer (on top of the substrate) made of self-healing polymer/elastomer generally improves the electrical conductivity and achieving a conductive layer even on Reynolds Ecoflex® 00-20 silicone rubber is possible.

The products disclosed herein can be obtained with the methods disclosed herein.

One embodiment provides a self-healing electrically conducting elastomer composite 20 in the form of a multiphase film 22 comprising:

- a polymer, and
- 55% or more by volume, such as 55-90% by volume, for example 60-80% by volume, of liquid metals comprising gallium as main phase, such as comprising gallium and indium.

In one embodiment the method comprises treating the obtained self-healing electrically conducting elastomer composite film 22 with laser to remove oxide layer from the surface of the elastomer composite film to enhance the electrical conductivity of the elastomer composite film and/or to form patterns to the elastomer composite film.

In one embodiment the surface of the self-healing electrically conducting elastomer film 22 has been treated with laser, such as has been laser-sintered, to remove oxide layer to enhance the electrical conductivity of the elastomer composite film.

One embodiment provides a self-healing electrically insulating elastomer composite 20 in the form of a multiphase film 22, preferably with high electric polarizability, *i.e.* dielectric, comprising:

- a polymer matrix, and
- 54% or less by volume, such as 5-54% by volume, preferably 45 or less by volume, such as 5-45% by volume, of liquid metals comprising gallium as main phase, such as comprising gallium and indium.

In one embodiment the elastomeric matrix comprises a polyborosiloxane-based polymer and a polydimethylsiloxane-based polymer. The polyborosiloxane-based polymer may represent the soft phase, and the polydimethylsiloxane-based polymer may represent the hard phase.

In one embodiment the elastomer composite film 22 is patterned and/or sintered, such as with one or more methods disclosed herein. The elastomer composite film 22 may be printed, attached and/or deposited onto a substrate.

Choice of solvent, and interaction with CNT/HPC

IPA ($C_5H_8O$) is a preferred solvent due to its high solubility in wide range of polar and non-polar substances. The polarity of the IPA is important as its then capable of interacting with polar functional groups (e.g., carboxyl groups, -COOH) present in the surface of MWCNT-COOH through hydrogen bonding, and other intermolecular forces contributing to formation of a stable solution. When MWCNT-COOHs are dispersed with IPA, the mixture becomes very thick and highly viscous that can be due to following reasons: (1) IPA may not fully prevent agglomeration and/or buddling of CNTs due to van der Waals - forces and $\pi$-$\pi$-interactions present between individual CNTs. (2) More importantly, the use of IPA can facilitate the formation of well-interconnected network or a gel-like structure, where the CNTs with carboxyl groups are cross-linked by the IPA molecules through the hydrogen bonding.

IPA can also interact with the hydroxyl groups in the hydroxypropyl cellulose (HPC) resulting in hydrogen bonding which enables effective dissolution of the cellulose in the solvent. This interaction allows formation of homogenous solution which is then good for coating purposes, film or gel preparation, but does not enable formation of cellulose capsulated LMMPs (similarly to that with water).

Other possible solvents include toluene, dimethylformamide, N,N-dimethylacetamide, and dimethyl sulfoxide.

In comparison to IPA, toluene ($C_6H_5CH_3$) is a non-polar solvent with weaker interactions to polar functional groups. Thus, resulting in lesser aggregation and not as likely to form the hydrogen bonds with MWCNT-COOH leading to lower viscosity in the solution.

The main benefit of toluene is the relatively low boiling point (b.p. 110.6°C) allowing easy enough evaporation during the polymer processing without having the need for high processing temperatures. More importantly, the boiling point of toluene is also not too low (the boiling point of IPA is lower (b.p. 82.3°C)) which enables more controlled evaporation of the solvent from the system. Toluene is also known of having a good solubility to variety of polymers which makes it versatile for dissolving polymer materials, even including organic (semi)conductors at relative high concentrations (> 5 mg/ml). Toluene can effectively reduce the viscosity of high molecular weight poly(dimethylsiloxane)-based polymers making their processing much easier. Toluene has also shown excellent compatibility with the autonomously self-healing elastomers, composites and blends. Thus, it is obvious choice of solvent for the material systems based on the same base material.

It is also possible to mix a high boiling point and low boiling point solvent at specific ratios for more precisely controlled evaporation and microstructure formation during the processing.

Dimethylformamide (DMF) is a polar solvent that can effectively disperse polar functional groups and form stable solution. DMF has a relatively low boiling point (b.p. 153°C), and good solubility for a wide range of organic and inorganic compounds. DMF is also a stable solvent that is relatively inert with other chemicals.

N,N-dimethylacetamide (DMAc) is another polar solvent with a higher boiling point (b.p. 163.1°C and similarly to DMF it is relatively inert and capable of providing a good solubility for wide range of organic and inorganic compounds.

Dimethyl sulfoxide (DMSO) can effectively dissolve both polar and non-polar substances. DMSO has a higher boiling point (b.p. 189°C) than DMF or DMAc (vs b.p. 153°C / 163.1°C), which can make it better if a slower evaporation of solvent is needed for the film processing or additive manufacturing.

Cellulose and cellulose derivatives

Cellulose has linear, fibrous microstructure, where glucose monomers are linked together by the $\beta$ (1→4) glycosidic bonds. Cellulose and derivatives thereof, such as hydroxyethyl cellulose, hydroxypropyl cellulose, and carboxymethyl cellulose, can be used as rheological modifiers in many types of pastes or inks, that, e.g., help to adjust the viscosity of the solution by thickening, and by improving the flow of ink due to their intrinsic shear-tinning behaviour. A higher molecular weight cellulose is made of longer polymer chains that often results in stronger thickening of the solution due to the number of chain entanglements increasing.

In one embodiment the cellulose comprises cellulose derivative, which may be selected from hydroxyethyl cellulose, hydroxypropyl cellulose, carboxymethyl cellulose and any combination thereof. The cellulose derivative may be soluble in water at room temperature and/or at temperatures discussed herein. The cellulose derivative can have an effect to the electrical properties, such as it can enhance the electrical conductivity. In one example the amount of cellulose derivative, such as HPC, in the aqueous mixture is 10-25 wt.%, which was especially found to enhance the conductivity of the final films. In the final films the amount of cellulose derivative may be in the range of 0.10-2.5% by weight, such as 0.5-2.5% by weight or 1.0-2.5% by weight. This however depends on the total amount of liquid metal, the amount of solvent and/or water in relation to elastomer compounds and liquid metal, and/or the amount of added cellulose derivative to the mixture at the end.

Generally, a water is preferred aqueous medium as the cellulose derivatives have high affinity for water due by the large number hydroxyl groups (-OH) which form hydrogen bonds with water molecules (not only limited only to water, but possible also for with other functional groups in the solution). The amphiphilic nature of HPC molecule allows them to interact also with each other through hydrophobic interactions. When dispersed in water, hydrophobic regions of the polymer chains tend to minimize their contact with the water molecules to reduce the free energy of the system. This drives the self-assembly of HPC molecules into well-ordered structures, where the hydrophobic regions are covered from the water and hydrophilic regions are exposed. As evident, the solution with water and cellulose becomes thicker than by replacing the water with other solvent. However, addition of water to the combined mixture (with elastomer components) is generally not preferred, thus controlled amount of HPC/CNT/water-mixture is added at the final step in the process.

HPC can interact with other phases in the system. For example, the polymer chains of HPC can become entangled with each other, and with the LMMPs leading to physical interactions. The hydroxyl groups in HPC can also form hydrogen bonds with the surface oxide layer and carboxyl groups in MWCNT-COOH, thus facilitating adsorption. The presence of HPC can also prevent agglomeration of MWCNT-COOH by providing steric hindrance or electrostatic repulsion between individual CNTs. Thus, HPC acts as a binder that tends to form encapsulation shell around the LMMPs, and therefore also results in stronger segregation of LMMPs in the 3D elastomeric network. This results in interesting electrical property behaviour under mechanical strain with the ECLME and significantly improves the electrical conductivity after laser sintering. For example, the cellulose encapsules around LMMPs can break during stretching, which leads to controlled leakage of LMMP within the ECLME.

### Chemical bonding and interactions

MWCNT-COOH, LMMP, and bonds in the elastomers can provide

- dispersion stability
- excellent leakage resistance
- electro-mechanical stability.

MWCNT-COOH and LM:

The LM/MWCNT-COOH/solvent-dispersion were more stable in comparison to LM/solvent-dispersions. This can be explained by the addition of MWCNT-COOH that can lead to formation of metal-carboxylate bonds that involves both ligand interaction and coordination bond. For example, the carboxylate ion (RCOO-) can act as the ligand, where negative charged oxygen atoms of the RCOO- donates electron pairs to the metal ions, thus forming a coordination complex. -COOH group can dissociate when dissolved in a polar solvent (such as IPA) and form carboxylate ions (-COO-) that coordinate with the metal atoms, positioned on the oxygen-containing functional groups on the surface oxide of LMMP, by forming the metal-carboxylate coordination bonds. Thus, the interaction between MWCNT-COOH and LM stabilizes the dispersion, thus preventing agglomeration and separation during the settling phase.

Reversible cross-links and LM:

The excellent leakage resistance of ECLME relates to the reversible cross-inks (O-H and O-B bonds) in the bimodal elastomer network that can form weak hydrogen bonds with the surface oxide layer of the LMMPs. Thus, significantly improving the adhesion, wetting and stability at the material interfaces. O-B bonds can also possibly donate electron pairs from the oxygen atom to the metal atoms on the surface oxide that forms the coordination complexes. Both types of interactions (i.e., hydrogen and coordination bonding) improve the interaction at the interfaces and can result in the adsorption of the elastomer to surface of LMMPs which contributes to the good leakage resistance. The leakage resistance is extremely critical in small, soft electronics circuits, where the electrical wiring, interconnections, pads, and/or vias are made of soft matter. For example, the leakage of LM under deformation from the microstructure or elastomeric network, can cause electrical shorts in the soft electronics circuits and sensor arrays which can also easily damage electronics components, e.g., due to excessive current flow, and cause malfunction of the sensing device, respectively. The leakage resistance has not been adequately addressed in self-healing composites, especially for more dense electronic wiring and for deformation induced by compression or shear.

MWCNT-COOH and reversible cross-links:

MWCNT-COOH can form hydrogen bonds with reversible cross-links. The presence of carboxyl groups (-COOH) also leads to formation of covalent bonds. For example, -COOH can interact with the hydroxyl group, or boron oxide, through esterification, or by other chemical reactions resulting in formation of ester bonds or other covalent linkages. This contributes by increasing the overall bonding strength and adhesion between the MWCNT-COOH and polymer chain segments containing O-H and O-B groups. For example, the bonding between MWCNT-COOH and the elastomer network increases the dimensional stability and creep resistance of the material, and its elastic recovery with the further consideration of that both the reversible cross-links and MWCNT-COOH can directly interact with the LMMPs.

Effect of CNTs to the self-healing properties:

The addition of homogenously distributed CNTs decreases the self-healing rate while simultaneously improving the dimensional stability and creep resistance of the self-healing elastomeric network(s). The effect is observed in non-electrically conducting self-healing substrate (e.g., EC7), DLME and ECLME which are based on the same base material. Generally, after addition of small amount of CNT (about 0.1-0.4% by weight), the full recovery of the properties after mechanical damage via self-healing can take several days in comparison to just one hour in the ambient conditions.

The changes in the self-healing properties dimensional stability and creep resistance can be explained as following:
Homogenously distributed CNTs create a torturous path for the diffusion of moisture and oxygen molecules, thus increasing diffusion length and reducing permeation rates within the 3D elastomeric network. The high aspect ratio CNTs and entangled network structure leads to improved interfacial bonding as the CNTs can effectively interact with the polymer chains through hydrogen and coordination bonding. Both types of bonding prevent detachment and/or slippage of polymer chains at the interfaces as CNTs can effectively restrict the movement of polymer chains and reduce the diffusion. More importantly the carboxyl groups (-COOH) can provide additional sites for the interaction and the effective cross-linking density increases which results in better integrity of the dynamic cross-links by further limiting their reversible breakage or rearrangement. The stabilization of the dynamic cross-links reduces the overall mobility of polymer chains and decreases polymer chain diffusion within the elastomer network resulting in exceptionally good long-term dimensional stability and creep resistance.

Effect of amphiphilic surfactant for the autonomously self-healing elastomers:

Using an amphiphilic surfactant, such as Triton™ X-100, can have several benefits for the autonomously self-healing elastomer, especially if added in small quantities. However, there are several considerations that first need to be made when the long-term microstructural stability, elasticity, and creep resistance are important.

(i) All surfactants act as plasticizers causing the glass temperatures to decrease; thus, flexibility and mobility of the polymer chain further increases. In amphiphilic surfactants, the hydrophobic and hydrophilic moieties can also disrupt the cross-linking density in the polymer when the surfactants preferentially localize at the interfaces, or within the polymer chains. This can reduce the effective number of cross-links and can weaken the physical integrity of the 3D elastomer network. For example, by forming the weak interfacial region and disrupting the continuity of the microstructure within the elastomer. This results in increased the diffusion of the polymer chains and introduces a high creep and poorer elasticity under large deformations.

(ii) Surfactants are known to undergo a migration or redistribution within 3D elastomer network over time as the surfactant molecules can diffuse along the microstructure. The redistribution of the molecules can disrupt the equilibrium of interactions between polymer chains and cross-links leading to further polymer chain diffusion and dimensional instability.

(iii) The hydroscopic nature of the surfactant can contribute to the plasticizing effect and promote the diffusion polymer chains due to the moisture sensitivity of Si-O:B bonds in the bimodal elastomer. The absorption of moisture and water molecules can induce significant dimensional instability especially if the elastomer is under continuous, dynamic or static mechanical loadings.

Application of the elastomer composites

The present elastomer composites or films prepared from the composites exhibit properties that are considered advantageous, for example for the applications disclosed herein.

The developed DLME and ECLME offer several advantages and benefits that are difficult to achieve with many other types of materials, such as:

- High electrical conductivity (ECLME) at moderate filler volumes

    - up to ~9,500 S cm$^{-1}$, that further increases with tensile strain (close to pure eGaln when strained)

- Large relative permittivity at moderate dielectric losses (DLME)
- Strain-insensitive electrical resistance (i.e., $R/R_0$ close to 1.0 up to ~600% tensile strain with ECLME)
- Ideally, the resistance does not change under tensile strain; however, the requirement for this is that the electrical conductivity increases with stretching. This is often not possible with soft matter as the physical distance between filler particles increases with the tensile strain.
- Excellent elastic deformability for both stretching and compression
- Good adhesion properties to wide range of materials
- Electrical and mechanical self-healing, where the tensile properties, and electrical conductivity with and without tensile strain recover after mechanical damage
- Excellent leakage resistance under deformation

- Excellent patternability at high resolution
- Excellent film forming ability, and compatible with meniscus-guided deposition methods
- Intrinsic softness due to low Young's modulus (in MPa range, or less)
- Notch-insensitivity (when combined with self-healing intermediate layer)
- Can be deposited to any type of substrate and sintered effectively (when combined with self-healing intermediate layer)
- Possibility to use as piezoresistive sensing material in sensor applications (the strain sensitivity/insensitive can be adjusted with composition)
- Good mechanical, electrical and thermal stability, and moisture insensitivity
- Excellent cyclic stability of electrical properties under large deformations

The DLME and ECLME may be based on the bimodal self-healing poly(dimethylsiloxane)-based supramolecular elastomer. Thus, they share many of exceptional properties of the elastomers, such as high levels of elastic deformability, excellent universal adhesion, and (autonomous)self-healing. While the high electrical conductivity, and stable resistance under large tensile strain make them also feasible for wide range of methods and related applications listed herein.

The "soft" as used herein refers to properties of the material, which may be considered soft, such as including flexibility, elasticity and the like properties. Softness and hardness can be used as measures of the resistance to be localized plastic deformation. Hardness and softness may be dependent on the rheological and mechanical properties of materials, including but not limited to Young's modulus, flexibility, elasticity, tensile plasticity, strain, strength, toughness, viscoelasticity, and/or viscosity. Hardness, or hard matter, can be contrasted with softness, or soft matter. The "soft" may also have the general meaning of defining a type or groups of materials or products, such as in "soft electronics". The term "soft" in contexts such as soft electronics, soft components, soft robots, soft sensors, and the like soft devices, distinguishes from conventional devices implemented with conventional, "hard" materials, such as conventional non-soft electronic devices, components, substrates, supports and/or the like.

The present elastomeric composites and/or films and other structures comprising thereof can be used in a variety of applications, such as units, appliances and/or other devices discussed in the following. In general, the expression "device" is used herein to refer to physical applications implementing the present elastomeric composites. Two or more of the applications, appliances, devices, materials or features thereof can be combined where applicable. The applications, appliances, materials and/or devices disclosed herein can be connected to further devices and applications, such as to a controlling means, for example one or more control units electronically connected to the devices, films, applications etc. disclosed herein and/or other suitable units or appliances comprising the elastomeric composites. The controlling means are arranged to receive information from the connected devices, and/or the controlling means are arranged to carry out controlling actions to adjust the operation of the devices, where applicable. The controlling means may be electronically connected to the devices, and/or they can be chemically, electronically and/or mechanically connected at a material interface. Many applications utilize, are, or comprise electronic devices, and/or are connected to electronic devices. The applications may utilize soft materials and/or devices as a part of the system, that are then combined with (conventional) hard materials and/or devices. Such applications can achieve improved functionality and/or performance.

A controlling means can interact with and/or provide human-machine interfaces (HMI), which can create more intuitive and interactive interfaces for controlling devices comprising the present materials or other devices disclosed herein. For example, an interactive human-machine interface (iHMI) enables humans to control and/or interact with hardware and/or system, and to collect feedback information. Prior art iHMI systems based on rigid electronics have constraints in terms of wearability, comfortability, breathability, long-term (bio) compatibility to soft tissues, signal-to-noise ratio (SNR), and aesthetics. The present materials enable overcoming such drawbacks and providing completely new types of interfaces, devices, and applications.

One embodiment provides an electronic device comprising the self-healing electrically conducting or dielectric elastomer composites, films and/or other structures comprising thereof, such as disclosed herein, preferably printed, attached and/or deposited onto a substrate. Structures can be also obtained by additive manufacturing.

One example provides the present elastomer composites for thermal cooling and heating, e.g., in wearable resistive heaters, heat sinks. For example, a planar printed conductor structure may be provided on the surface of another material or substrate as a resistive heating element. Electric current is conducted through the resistive structure and the loss of electrical energy causes heating of the resistive element and its surroundings. In an example, such heating element or heater comprises an elastomeric substrate comprising a sintered printed liquid metal elastomer pattern on the surface thereof.

A heat sink may comprise a 3D structure, wherein area is increased structurally to obtain cooling by transfer of thermal energy between two or more medium. One example comprises a structure comprising a plurality and/or a series of fins of the like elevated structures, which are partly made from the liquid metal elastomer. Such structures can be prepared from two or more pieces, which are bound together afterwards, or which are obtained by additive manufacturing.

One example provides the present elastomer composites as or in soft, elastic, strain-insensitive electrical wiring, interconnections, pads, vias for flexible electronics, printed electronics, stretchable electronics, soft electronics and/or self-healing electronics. Flexible electronics are circuits and electronic components that can retain their function while being bent. Whereas flexible electronics can be bent, stretchable electronics can be elongated. Thus, stretchable electronics can be used in a wider application space while providing increased durability. Stretchable electronics can, in principle, conform to the skin or other biological tissue or be incorporated in new form factors, such as textiles and wearable electronics. Soft electronics include stretchable electronics, but the materials are also soft.

The soft electronics, connectors, wirings, and/or components thereof can be provided as patterned films and/or areas in multilayer structures, as attached on a surface of another material/substrate. They may be present in so called 2D geometric form, but they can be also formed as 3D forms comprising overlapping layers. The layers can be 3D printed or obtained by combining separate films or layers. For example, a via or a lead-through between two layers can be implemented with the liquid metals by filling an aperture with the present elastomer composite. Typically, a round hole as a via is used in electronics, but it may also have another shape. The thickness of the via may be defined by the thickness of an intermediate layer, such as 0.1-1000 $\mu$m for common substrate thicknesses. The area of the via may be anything in the square micrometer, square millimeter or even square centimeter range.

For interconnections, typically a more complex stretchable patterns have been used to neglect effect of tensile strain to the electrical conductivity and/or resistance of a wire: Some examples are Von Koch-curve, Peano curve, Hilbert curve, Moore curve, Vicsek fractal, Greek cross. These basic patterns can be further modified in order to achieve a desired level of deformability and strain insensitivity for the interconnections. However, with the present liquid metal elastomers there is no need to use complex patterns, because the resistance increase is negligible (i.e., is not sensitive to the stretching in this context). In practice, the interconnection may be a straight line. Usually, it is desired to avoid large angles in the electrical wiring for other reasons when making, for example, an electronic circuit layout. In such case the electrical wires may be skewed instead of 90 degrees angles. With the present conductive elastomers, the resistance does not change even under large stretching (i.e., $R/R_0 \sim 1.0$), which can considerably simplify designing of stretchable devices and circuits as the deformation of the electrical wires does not need to be considered to a similar degree than in most other solutions. This also enables fabrication of denser electronics, as the geometry, length and/or shape of the electrically conductive parts plays minor role.

One example provides the present elastomer composites as or in an electronic skin (e-skin) product. Electronic skin refers to flexible, stretchable and/or self-healing electronics or products comprising thereof, that are able to mimic the sensory capabilities and functionalities of human or animal skin. This class of materials, or products, may comprise or exhibit physical, thermal, chemical or environmental sensing abilities that may be intended to reproduce, mimic and/or surpass the capabilities of human skin in their ability to respond and/or adapt to environmental changes or external stimulus, such as changes in temperature, humidity, vibration and/or pressure. Self-healing abilities in electronic skin are critical to potential applications of electronic skin in fields such as soft robotics.

Electronic skin may also refer to wearable skin-interfaced/on-skin, or implantable systems, which is/are to be applied onto organisms. Such material structure, or product, can act as or provide skin-interfaced electronics (skintronics) and/or other functionalities, such as disclosed herein. These materials, and other applicable materials and products disclosed herein, may represent a bioelectronic device, that can convert biological signals, such as physical, physiological, and metabolic signals, into measurable electrical signals. Such materials and devices can be used for example for health monitoring and/or for monitoring one or more features of skin and/or body.

One class or type of such devices are epidermal electronic devices, which can conform to the skin, providing a seamless interface for health monitoring and sensing applications. They comprise a class of integrated electronic systems that are ultrathin, soft, and lightweight. With the present materials they can be implemented in suitable thicknesses, breathability, softness, flexiblity, and areal mass densities matched to the interface at the epidermis. Epidermal electronic devices can be mounted to epidermis leading to conformal electrical and mechanical contact and adequate adhesion based on van der Waals interactions alone is possible (if ultrathin), and they can provide feel insensitive contact to the skin, which is mechanically invisible to the user. They can be used in medical or sports applications and/or to realize human-machine interface.

Another class of technology and devices includes those related to biomedical engineering. Such devices can be used in implants or wearable devices that monitor health and deliver therapy. Implantable electronics made with the present materials can be used for example in devices capable of recording electrophysiological signals and/or for stimulating muscles and nerves, and which can be used throughout clinical medicine for various of purposes. Examples of such devices include sensor systems, such as those used for monitoring glucose. Glucose sensors can be implanted in subcutaneous tissues and determine agents or concentrations thereof from interstitial fluid.

The devices disclosed herein can be used in healthcare monitoring and athletic performance improvement. In one example stretchable electronics are integrated into wearable garments or patches for continuous health and/or fitness tracking/monitoring. For example, an ultrathin, compliant skin-like sensor and/or actuator technology can be pliably adhered onto the epidermis to provide continuous, accurate multisensory characterizations that are unavailable with other methods. Wearable systems comprising the present elastomer composite can monitor muscle activity and/or electrical activity of body, store data and deliver feedback for improvement for various purposes including therapy. Examples of such systems include physiological sensors, non-volatile memory and drug-release actuators. For example, a soft and deformable piezoresistive force sensor array can be obtained by first printing and laser sintering an electrically conductive liquid metal elastomer interconnections onto self-healing elastomer substrate, and then by transfer-printing a laser-patterned piezoresistive sensing element from a donor substrate onto the previous layered structure to connect the sensing array with the external measurement circuitry through the stretchable strain-insensitive ECLME interconnections.

One example provides the present elastomer composites as or in soft, strain-insensitive electrical probes or wires for connecting soft components and devices to external measurement circuitry, or to computing (without high contact resistance at the interface). A probe may be a 3D dimensional body with an electrically conducting tip, which may be connected to a measuring device or electronics at the other end. The shape and/or size of the probe depends on intended use. One example provides a 3D printed piece with an electrically conductive film integrated into it, or a patterned planar film/-layered films, which would be folded into a suitable shape along the cuts, which provides a 3D dimensional probe out of the material. The folded structure can then be integrated into another 3D structure or used as such. For example, with an external measuring device and the soft probe, it is possible to measure electrical signals from the surface of fragile things/objects and at the same time get good mechanical and electrical contact with the surface without breaking it.

A soft connection/cable can be made of a soft substrate with a patterned liquid metal elastomer film on top. This may provide a structure similar to a common FFC/FPC cable, but with the difference that it is made of self-healing materials, in which case it would have an built in adhesive at the surface of the cable. In such case it is not necessary to fix the cable separately. Such structure can adhere to, and work between both rigid electronics and a soft device, and between two soft or rigid devices, when the adhesive properties are suitable.

One example provides the present elastomer composites as or in soft, strain-insensitive conductive adhesives. Depending on the purpose of the adhesive, it would be used as a "glue", e.g. for attaching surface-mountable components to other conductive structures or parts of the device, such as for resistors, capacitors, IC circuits, etc. Therefore, it can be used for "soldering", i.e. if there were heat-sensitive materials between which an electrical connection should be formed, then this can be made of the liquid metal elastomer. In practice the adhesives may be provided as planar films having a variable thickness.

It would also be possible to simultaneously use it as a cooling element, and at the same time mechanically and electrically bond the component, when presumably the liquid metal elastomer could possibly have good thermal conductivity.

The present elastomer composites can be used in sensors and/or devices or parts thereof capable of sensing and/or monitoring one or more stimulus and/or properties, and/or in devices or parts contributing to sensing. Soft sensors may include soft sensor component(s) capable of measuring mechanical, thermal, chemical, and/or environmental stimulus including but not limited to changes of tensile, shear, compressive forces, mechanical vibration, temperature, concentration of gases, and humidity. The sensors may measure or detect one or more stimulus, for example, through changes of resistance, capacitance, inductance, voltage, current, magnetic and/or electric field, shift in frequency and/or phase of electromagnetic wave, optical and/or acoustic loss, or combinations thereof. The measurements can be fed into a connected electrical control system. i.e. controlling means.

One example provides the present elastomer composites as or in piezoresistive sensing layers in soft sensor components, such as with or without further functionalization. These may be or comprise planar patterned films that can either be attached to a planar substrate or to a substrate pre-/post-formed into a 3D shape. Therefore, the function of such piezoresistive membrane would then also be dependent on the working mechanism, type of structure or substrate it is integrated into. The piezoresistivity with liquid metal elastomer may be based on a change of deformation of the elastomer matrix by external stress. Thus, the location and shape of that piezoresistive sensing part shall also be considered according to what stimulus would be measured, and what the properties of the materials are, e.g. coefficient of thermal expansion, Poisson's ratio, swelling ratio, etc. For example, piezoresistive humidity, temperature and strain sensors would have a different structure also depending on their intended final use. The sensor elements made of patterned film(s) could then also form a matrix of the elements or sensors, if more measurement points per area would be desired. In this case, their patterned areas should be designed in consideration of the measurement resolution, and the electrical wiring needed to connect the piezoresistive sensors to the electronics.

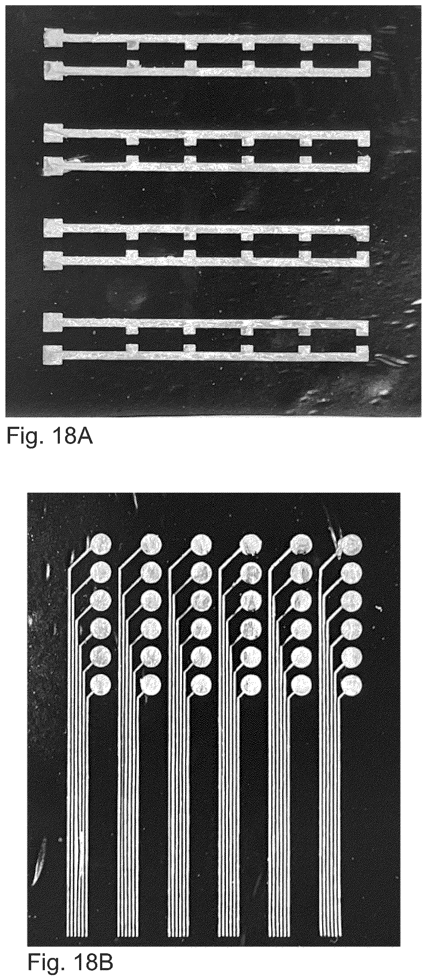

One example provides the present elastomer composites as or in strain-insensitive bioelectrodes, for low/high density biopotential measurements. Bioelectrodes may be round thin films which size is determined according to how good measurement resolution is required. Figure 18B, as an example, shows one printed bioelectrode matrix with part of the electrical wiring for connecting to the electronics.

The bioelectrode usually requires two adjacent electrodes, the voltage difference between which is measured. If it is an electrode matrix, then e.g. two adjacent electrodes form a pair. The density and location of the electrodes in the matrix and in relation to the target to be measured can be determined, for example, according to where on the body the bioelectrode matrix is connected. In addition, an additional ground electrode is needed, which reduces e.g. measurement noise at low frequencies. The ground electrode can be located outside the electrode matrix as a separate electrode on the body.

One example provides the present elastomer composites as or in soft, strain-insensitive electrodes and terminals, such as for soft electronics components including but not limited to organic or electroluminescent displays, solar cells, transistors, photodiodes, sensors, resistors, capacitors, and/or as or in soft, stretchable and/or self-healing batteries as both positive and negative electrode (cathode and anode). These may comprise patterned films, having patterns, shape, size and location in electronic structures dependent on the type and purpose of the device/structure. The thicknesses of the conductive layers/areas may be defined by the limits of the materials. Suitable thickness may be in the range of 20-40 $\mu$m.

The shape and number of electrodes is completely dependent on the structure, operation and type of a component. For example, a capacitor requires a different electrode structure than a transistor or a display. However, with a liquid metal elastomer, there is no need to consider the resistance change caused by stretching in the shape / location of the pattern, thus the shape of the electrodes can be more simplistic than in standard non-flexible electronics.

Displays usually have a dense matrix of electrodes that interact with emissive materials and make up the pixels of the screen. Terminals are used to connect the screen to the rest of the electronics, for driving function of individual pixels, etc. In practice, the present composites may be provided as film-like conductive layers that are in contact with the emissive materials.

In photodiodes, such as shown in Figure 30, the present composites can be used in anodes, cathodes and/or terminals. The size and shape depend on structure and operating principle, but practically comprise film-like structures.

Sensors usually have two electrodes or terminals, in the case of typical the structure and operation principle. More advanced sensor structures can also have more electrodes if it is desired to measure many different stimuli and/or to combine different measurement methods into a single component. For example, three, four or more electrodes can be employed in one sensor.

Capacitors can have several electrodes if, for example, a multilayer capacitor is made with dielectrics and electrodes on top of each other. In addition, the terminals that connect the capacitor to other things can be made from the present composites. That is, the number of layers, the thickness and the surface area of the membrane would affect the capacitance, and the dielectric properties of the material that is sandwiched between the electrodes, i.e. the permittivity of the dielectric.

For batteries, a 3D structure may be in the shape of a regular battery, assuming that all materials are stretchable, and that such structure can be employed as a part of electronics design. Such a structure may comprise, for example, a large membrane structure where the necessary layers are assembled on top of each other, and the membrane structure is rolled into a smaller space and enclosed. In this example, there is one positive and one negative electrode, as well as two electrodes as terminals, from which contact can be made. In a planar structure, the number of electrodes may be higher. Further, if the performance of other active materials of the battery would decrease during stretching, it shall be taken into account in the shape / geometry of the component, even if the materials are otherwise stretchable

One example provides the present elastomer composites as or in soft, stretchable, wearable and/or on-body integrated antennas including but not limited to dipoles, loops, coils, patch antennas, phase shifting coaxial transmission lines, monopoles, reconfigurable antennas and filters. In practice, these may be substantially planar conductive and patterned structures, where the limitations of the thickness of the layers come from the materials and their manufacturing methods. These structures may be provided on a flat surface. For example, the shape / size of such resonator shall be designed to be suitable for the frequency range in question, also taking into account the electrical properties of the materials.

One example provides the present elastomer composites as, in or for other electromagnetic devices such as mirrors, diffraction gratings, frequency selective surface, plasmonics, or radiation shielding. The mirrors may be or comprise patterned film-like reflective structure that allow interaction with the received electromagnetic waves by controlling their direction, phase and polarization. Plasmonic structures and devices comprise periodic patterned structures that can be used for optical manipulation. One example provides a surface grating made of elastomer, with varying grooves and ridges, which causes a controlled reflection of the light. In practice, there should be a three-dimensional structure, where either each layer would be patterned before lamination, or the laminated structure would be patterned into shape afterwards

One example provides the present elastomer composites as or in soft robots that are controlled with magnetic field, such as when magnetic fillers are introduced to the elastomer. Soft robots can provide natural movements and capabilities for safe interaction with humans. Soft robots may also include soft sensors comprising the present elastomer composites.

In embodiments the electronic device is or comprises one or more of an antenna, a sensor, a measurement circuitry, a piezoresistive sensing layer, an electrode, such as a bioelectrode, a heating element, an electromagnetic device, soft robot, printable electronics, stretchable electronics, soft electronics, self-healing electronics and wearable electronics. Preferably the mentioned device parts are made of, or comprise, the present elastomer composite(s).

**Examples**

Example 1: Liquid metals without fillers

Liquid metal alloys comprising $EGa_{0.69}In_{0.22}Sn_{0.09}$ and $EGa_{0.755}In_{0.245}$ mixtures were used for preparing the self-healing electrically conducting or dielectric elastomer composites. It was noted that the composition of the eutectic mixture has an impact to the temperature wherein the metal alloy is present in a liquid form.

The volume of the liquid metal in the elastomer composite was varied in the range of 5-90% by volume. This has an impact to the electrical and dielectric properties of the elastomer composite. It was found that when the volume of liquid metals remained at 45% or less, the elastomer composite was electrically insulative. With increased volume of liquid metal, the elastomer composite exhibited good electrical conductivity. It was found out that about 55% or more by volume produced electrically conductive composite, which found many uses in various applications.

The eutectic mixtures were ultrasonicated in a solvent to obtain nano/microparticles, as can be seen in SEM image of Figure 6. It was found out that the formed microparticles enabled enhanced blending with the elastomer components, as a thin oxide layer of about 2-20 nm is formed on the surface of the particles. The surface oxide layer facilitated the mixing of the particles to other materials, such as polymers. The particle size could be controlled and adjusted by changing the composition of the mixture and ultrasonication parameters. With the control over the ultrasonication parameters affecting the size of LMMP, properties of the final material could be further adjusted.

The average particle size (diameter) obtained in the ultrasound treatment was between 100 nm to 30 micrometers, depending on the composition of the mixture and the parameters of the ultrasound treatment. In the ultrasound treatment parameters such as power, amplitude and sonication time could be controlled, wherein for example a longer sonication time produced more homogenous particle distribution and smaller average particles size, especially when the power and amplitude were unchanged. Increasing the amount of liquid metals compared to the amount of the solvent and other components could broaden particle size distribution, if the ultrasonication parameters were unchanged. A longer sonication time was required to obtain a desired particle size distribution. In general, the smaller particle size enables better mixing with the other components, and more homogenous liquid metal composite, which was found advantageous for the laser sintering once above the percolation threshold.

The used solvent was selected according to need, such as to completely cover the liquid metal mixture in a narrow glass vial. The shape and cross-sectional area of the glass vial had also a specific impact, depending on the area of the tip of the ultrasound mixer. The particle formation was optimal when the area of the tip was close to the cross-sectional area of the glass vial.

More solvent was added during the ultrasound treatment, if necessary. However, the amount of unevaporated solvent could have an impact to the viscosity of the final mixture and shall be taken into account in the preparation of the final products by methods such as 3D printing, inject printing, tape casting etc., which all require a different viscosity.

In some cases, the solvent was allowed to evaporate completely so that liquid metal particle powder was obtained without solvent. However, when selecting the solvent, it was found to be important to enable a good liquid metal particle formation and to enable compatibility with the elastomer components. Different solvents were tested, and isopropanol and toluene were found to be especially suitable for the present purposes. Of these two, isopropanol was found to produce better results for the formation of the liquid metal particles.

After forming the liquid metal particle mixture or powder, which may be considered as Mixture 1, it could be mixed with the elastomer components. Sylgard™ 184 silicone elastomer kit was partly used for forming the elastomers, the kit comprising Components A and B. Component A comprises a siloxane base and Component B a siloxane crosslinker.

Boron trioxide ($B_2O_3$) nanoparticles were mixed with Component A. The components were mixed by grinding in mortar with pestle to form Mixture 2 (M2). PDMS-OH was added to the Mixture M1 (M1; containing LMMP), and M1 with Triton™ X-100 was added after this to the M2. As a final step Component B was added to combined mixture of M1 and M2, to crosslink the elastomer composites. As a result, a dark brown paste was formed, which was mouldable or printable depending on the viscosity of the final mixture. The viscosity could be controlled by the amount of solvent, and by the compositions of the liquid metal particle mixture/powder, and elastomer matrix.

The elastomer composite paste was formed into films with varying thicknesses.

Example 2: Liquid metals with carbon nanotubes

The liquid metals were provided as explained in Example 1.

Carbon nanotubes of different types were tested, including single walled or multiwalled carbon nanotubes. In one example the carbon nanotubes were COOH-functionalized.

Carbon nanotubes were added to the mixture of liquid metals and solvent, and the mixture was ultrasonicated as example in Example 1.

It was found out that single walled carbon nanotubes can provide, in general, a better electrical conductivity (if below the percolation threshold of the liquid metal composite) but are significantly more expensive. While the multiwalled carbon nanotubes have lower electrical conductivity, they still could enhance the connectivity and distribution of the LMMPs within the elastomer matrix, which is a major purpose of the present method.

As can be seen in the SEM images of Figures 7 and 8, the addition of a small amount of carbon nanotubes prevents the agglomeration of liquid metal particles at large volume loadings, thus resulting in better distribution of the LMMPs in the composite and formation of more homogenous composite.

After forming the liquid metal particle mixture or powder comprising carbon nanotubes (Mixture 1), the elastomer composites were prepared as explained in Example 1

The elastomer composite paste was formed into films.

Example 3: Liquid metals with carbon nanotubes and hydroxypropyl cellulose

Elastomer composites were prepared in general as explained in Example 2, but adding also hydroxypropyl cellulose as a further filler. Other cellulose derivatives were also tested in an analogous manner.

The hydroxypropyl cellulose (HPC) was mixed with deionized water. HPC could be dissolved in water, but also in organic solvents. The amount of HPC with respect to the used deionized water defines i.e. the viscosity of the mixture. The viscosity was relatively high already when the amount of HPC was close to 20% by weight. After mixing the HPC with deionized water, a desired amount of carbon nanotubes was added, and the mixing was continued. Tested amounts of carbon nanotubes were in the range of 0.5-5.0% by weight.

Liquid metals particles were first mixed with the solvent used to obtain Mixture 1, and the elastomer composites were prepared as explained in Examples 1 and 2.

Films were prepared from the obtained elastomer composite paste with varying thicknesses. The microstructure and properties of the films significantly differentiated from the films prepared in Examples 1 and 2. As e seen from the SEM image (Figure 9), there are no visible liquid metal particles on the surface of the film in larger amounts. It was observed that the formed microstructure of the composite film, wherein the liquid metal particles are encapsulated within the cellulose matrix, is advantageous for a subsequent method step, wherein the surface of the film is then treated with a laser.

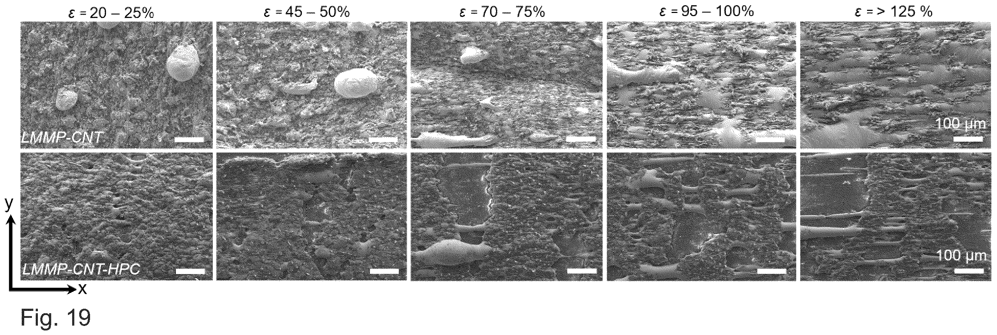

Stretchable self-healing elastomer composites were obtained from Examples 1-3. For example, the SEM images of Figure 19 demonstrate the change of the microstructure of the composite with over 125% uniaxial stretching for LMMP-CNT and LMMP-CNT-HPC. However substantially higher stretchability was obtained, as explained in the specification.

Example 4: Mixing methods 1-4

The liquid metal nano/microparticle (LMMP) paste was mixed with the elastomer components as shown by the four different methods.

The LMMP paste comprised solvent and LM, with either CNT, cellulose, or both CNT and cellulose, and the obtained elastomer composites were denoted as $\mu$LM-CNT, $\mu$LM-HPC, $\mu$LM-CNT-HPC (or as LMMP-CNT, LMMP-HPC, LMMP-CNT-HPC).

The mixing process of Methods 1-3 (Figures 2-4) comprised the following.

    1. After preparation of LMMP paste with a probe ultrasonication, the PDMS-OH component was added to a glass vial where the LMMP paste was mixed with lab spatula, to form a homogenous mixture 1 (M1).

    2. Boron trioxide nanoparticles ($B_2O_3$ NPs) were mixed with component A of Dow Corning Sylgard™ 184 by grinding in mortar with pestle to form mixture 2 (M2). The mixing was continued until homogenous paste with uniform color was formed.

    3. M1 was added to M2, and the mixture was further grinded in mortar with pestle to form homogenous paste.

    4. If needed, Triton™ X-100 was added to the mixture and mixing was continued. The amount of Triton™ X-100 was calculated in relation to the amount of elastomer components (step 1), and it was in the range of 0.1-13% by weight. It was found out that preferably it shall be in the range of 0.1-6% by weight, and more preferably in the range of 0.1-2.5% by weight.

The mixing process of Method 4 (Figure 5) comprised the following

    1. After preparation of LMMP paste with the probe ultrasonication, the PDMS-OH component was added to a glass vial where the LMMP paste was mixed with a lab spatula to form a homogenous mixture 1 (M1).

2. Boron trioxide nanoparticles ($B_2O_3$ NPs) were mixed with component A of Dow Corning Sylgard™ 184 by grinding in mortar with pestle to form mixture 2 (M2). The mixing was continued until homogenous paste with uniform color was formed.

3. M1 was added to M2, and the mixture was further grinded in mortar with pestle to form homogenous paste.

4. Mixture 3 (M3) was formed by probe ultrasonicating solvent and HPC, and additionally CNT. After ultrasonication M3 was added to the mixture made of M1 and M2.

5. If needed, Triton™ X-100 was added to the mixture and the mixing was continued. The amount of the amphiphilic surfactant was calculated in relation to the amount of elastomer components (step 1), and it was in the range of 0.1-13% by weight. It was found out that preferably it shall be in the range of 0.1-6% by weight, and more preferably it may be in the range of 0.1-2.5% by weight.

6. Component B of Dow Corning Sylgard™ 184 was added to the mixture above and the mixing was continued. The final mixture was referred to as mixture 4 (M4).

Outcome of Methods 1, 2, 3 or 4 was a homogenous elastomer composite paste, that was used in additive manufacturing or film formation.

Example 5: Surface treatment of the films

As the elastomer composites obtained from Examples 1-4 were not electrically conductive as such, the films must be further processed to achieve high electrical conductivity. In practice all the composites were highly resistive or poorly electrically conducting, independently of the liquid metal or filler content, or phase separation degree in the composite, as the liquid metal particles have an oxide layer on the surfaces thereof preventing the flow of electrons and physical contact of the inner core of the particles. When the films were processed with the present methods it was possible to obtain highly electrically conductive composites (similarly to pure liquid metal).

Films obtained from Example 2 having a liquid metal loading of 70% or more by volume without other fillers or additives were made conductive with one or more of the following methods:

1) The liquid metal elastomer film was formed into a cord by rolling a planar film onto a roll, wherein the cord will become electrically conductive at the inner surface and at the ends of the cord.

2) The surface of the liquid metal elastomer film was scratched or drawn with a pen or the like tool, which mechanically damages the surface.

3) The liquid metal elastomer film was treated with a laser to remove material and form patterns. The film had an HPC and LM loading of 75% by volume, thus making the film especially favourable for laser treatment.

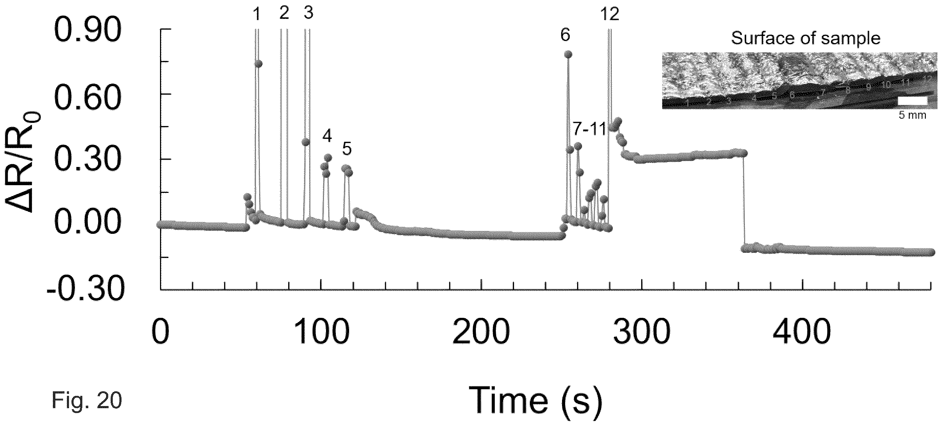

Change in resistance of films after different treatments was determined. Figure 20 shows relative change in resistance ($\Delta R/R_0$) as a function of time when the sample has been cut repeatedly 12 times. $\Delta R = R - R_0$, wherein R is the resistance of the conductor and $R_0$ is the original resistance of a pristine conductor (before measurement).

Figure 21 shows average $R/R_0$ measured as a function of time at A) a room temperature (RT) and B) at 70°C after the lasering the liquid metal elastomers. The liquid metal elastomers were printed onto a self-healing elastomer substrate. The shadowed area shows the standard deviation, and the black dots show the average (n=4).

Figure 22 shows $R/R_0$ measured as a function of uniaxial stretching. The printed conductors are denoted as follows: in a) w/ S = with a surfactant, w/o S = without a surfactant, enc-(w/o S) = encapsulated and without a surfactant, and in B) P=pristine and the times 24/48/72 h refer to the self-healing time from the point of time where the sample was completely cut through on specific location. The photos show pristine sample under stretching (the left, scale bar 25 mm) and self-healed sample which has been cut and then healed (right, scale bar= 0.3 mm). The liquid metal elastomers were printed onto a self-healing elastomer substrate.

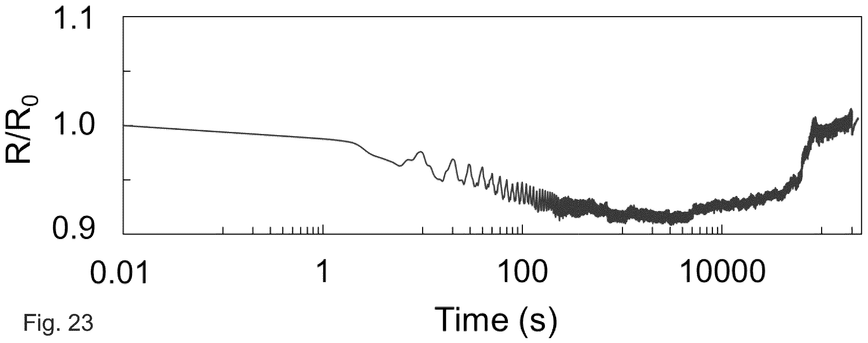

Figure 23 shows $R/R_0$ measured as a function of time (>200 000 s), when the sample was initially stretched from 0% to 100%, then cycled between 57% and 100% uniaxial tensile strain for 20 000 repetitions, and finally by the stretching was released. The sample comprises a liquid metal elastomer printed onto a self-healing elastomer substrate.

Example 6: Printing on a substrate and electrical conductivity

The liquid metal elastomers were printed on different substrates.

Figure 10 shows an example of liquid metal elastomer printed on a self-healing substrate, wherein also the elements of the structure are shown separately.

Figure 11 shows different liquid metal elastomer compositions (LM-CNT, LM-CNT-HPC (water), LM-CNT-HPC (toluene)), printed on the Dragon Skin elastomer.

It was found out that effect of the film thickness to the electrical conductivity is minor. However, 20-100 $\mu$m thickness was found sufficient to produce high quality printed patterns, or films/coatings/layers with good electrical conductivity.

It was found out that printing and/or laser sintering direction influences the final electrical conductivity on ordinary (non-self-healing) substrate; either by improving or decreasing it. The electrical conductivity also depends on the substrate on which the liquid metal elastomer is made on. For example, printing along the smallest dimension of pattern (in the case of simplistic line) is not possible on substrate with poorer wettability (unless the wettability is improved, e.g., with surface modifications).

It was found out that on some soft substrates, the liquid metal elastomer is not electrically conductivity even after laser sintering, such as Reynolds Ecoflex® 00-20 silicone rubber. The electrical conductivity improves by factor of 1.6-1.8 on self-healing elastomers, if compared to conventional non-healable elastomers, e.g., EC7 (780-1620 S cm$^{-1}$) vs. Reynolds Dragon Skin® 10 medium silicone rubber compound (470-880 S cm$^{-1}$). Printing on intermediate layer (placed on top of the substrate) made of self-healing elastomer generally improves the electrical conductivity and achieving a conductive layer even on Reynolds Ecoflex® 00-20 silicone rubber is then possible.

As shown in Figure 17 A-D, the electrical conductivities of laser sintered traces vertically printed and hatched on Dragon Skin™-elastomer increases approximately from $3.4 \cdot 10^{-3}$ S/m to 876 S cm$^{-1}$ with the volume of LM increasing from 55 to 65 vol.% The properties are measured as a mean +/- STD for 10 samples.

The dimensions and geometry of the printed traces were fixed in all tests. Typical trace dimensions were 49.0 x 5.0 (mm) (length x width), and the thickness of the traces were defined from the optical microscopy images. After printing and laser sintering, the traces were approximate 25-50 $\mu$m in thickness (depending on the substrate and elastomer composition).

The values for horizontal printed traces are less ($1.1 \cdot 10^{-3}$ S/m to 475 S cm$^{-1}$). These electrical conductivity values for the ECLME elastomers are without application of tensile strain (i.e., in relaxed state). Interestingly, the electrical conductivities increase to $781 \pm 235$ - $1613 \pm 485$ S cm$^{-1}$ when ECLME are printed on self-healing elastomer (EC7) substrate (increase by a factor 1.84 on average).

Generally, the increase of the electrical conductivity with the volume loading of LM (after laser sintering) can be explained by the common percolation theory:

$$\sigma = \sigma_0(\varphi - \varphi_c)^n,$$

where $\sigma_0$ is the electrical conductivity of the pure liquid metal ($3.4 \cdot 10^6$ Sm$^{-1}$), $\varphi$ is the volume fraction of the filler (e.g., eGaIn) in the composite, $\varphi_c$ is the percolation threshold, and $n$ is the percolation exponent. Based on the measurement results, the percolation threshold is 55 vol.%, and with the percolation exponent of 1.6, the theoretical prediction fits well to the experimental data using the percolation theory. As shown, the electrical conductivity of the ECLME are dominated by LM at or above the percolation threshold. Increasing the amount of MWCNT-COOH did not increase the electrical conductivity of the ECLME. The electrical conductivities were $876 \pm 210$, $629 \pm 70$ and $876 \pm 209$ S cm$^{-1}$ for 0.75, 1.50, and 2.25 vol.% of CNT@65 vol.% LM, respectively.

The electrical conductivities of the ECLME elastomers are highly dependent on the type of elastomeric substrate on which they are casted on. Also, use of cellulose during mixing significantly increases the electrical conductivities as the cellulose encapsulates the LMMP and the segregation increases in the elastomer matrix.

The choice of self-healing elastomer and its composition does not affect the electrical properties of liquid metal elastomer. It was found out that the amount of carbon nanotubes does not improve the electrical conductivity assuming the volume loading of liquid metal is above the percolation threshold (55 vol.%)

In comparison, on Reynolds Vytaflex™ elastomer, the electrical conductivities of ECLME with 65 vol.% LM and 0.75 vol.% MWCNT-COOH were $470 \pm 117$ - $1187 \pm 237$ S cm$^{-1}$ (which were comparable to that observed in Reynolds Dragon Skin™ elastomer). By using a non-conductive self-healing layer (EC7) as intermediate layer between Reynolds Vytaflex™ elastomer and ECLME, the electrical conductivity increased up to $2417 \pm 388$ - $2535 \pm 671$ S cm$^{-1}$ (by a factor up to ~2.13).

Interestingly, the printed ECLME traces were not electrically conductive after the laser sintering on Reynolds Ecoflex™ elastomer. By using a non-conductive self-healing elastomer as intermediate layer, it was possible to achieve electrically conductive ECLME traces also on the Ecoflex™ elastomer. The electrical conductivities were in the range of $129 \pm 39$ - $1154 \pm 150$ S cm$^{-1}$ which were significantly lower than when made on Reynolds Dragon Skin™ or Vytaflex™ elastomers.

The electrical conductivities increased up to $3000 \pm 1751$ - $4688 \pm 1983$ S cm$^{-1}$ on Reynolds Dragon Skin™-elastomer after the laser sintering if hydroxypropyl cellulose is used as a part of the mixing process (method 4), when 1 gram of MWCNT-COOH/HPC/water dispersion is added to the other components, where the amount of HPC in relation to water is 20 wt.%, and the amount of MWCNT-COOH is 2 wt.% in relation to the HPC and water. The amount of CNT and HPC added to other components could be then controlled by controlling the amount of mixture added with other components.

If the amount of HPC was increased, the viscosity increased significantly after 20 wt.% The laser sintering improved the electrical conductivity by over factor of $10^8$ (i.e., the films are highly resistive/non-conductive before sintering). This enabled also preparation of continuous LM films, where only certain areas of the films were activated to be electrically conductive by the laser sintering to be electrically conductive. Generally, the higher the resistivity of the composite is before lasering, the better the electrical conductivity is after the sintering, which could be strongly related to the particle segregation.

With the use of non-conductive, self-healing substrate (EC7) as an intermediate layer between the ECLME elastomer and Reynolds Dragon Skin™-elastomer, the electrical conductivities were up to 871 ± 210 - 2220 ± 508 S cm⁻¹. Thus, the electrical conductivities increased by a factor up to 2.55 by only adding a non-electrically conductive self-healing elastomer layer in between the Dragon Skin™-elastomer and ECLME.

In comparison, the electrical conductivities with HPC-based ECLME (0.25 g of HPC/CNT/water solution instead of 1 g (same ratios than above)) were:

- 6657 ± 2186 S cm⁻¹ on Reynolds Dragon Skin™ elastomer (improvement by a factor up to 1.42 with less amount of CNT/HPC water)
- 4584 ± 1998 S cm⁻¹ on self-healing elastomer (EC7)
- 6619 ± 1274 S cm⁻¹ on Reynolds Ecoflex™ elastomer with EC7
- 7089 ± 2495 S cm⁻¹ on Reynolds Dragon Skin™ with EC7
- 3811 ± 1477 S cm⁻¹ on Reynolds Vytaflex™ elastomer with EC7

The highest measured (non-strained) electrical conductivity was 9473 S cm⁻¹ on Reynolds Dragon Skin™ elastomer for ECLME with HPC. The surface of Reynolds Ecoflex™ elastomer is extremely rough which is why the intermediate layer is important to achieve electrically conductive ECLME.

Thermogravimetric analyses of liquid metal elastomers were carried out, and the results are presented in Figure 24. The compositions are denoted as follows: EC7 = elastomer (without any fillers). EC7-LM65-CNT0.75 = liquid metal elastomer with 65 vol.% liquid metal and 0.75 wt.% MWCNT-COOH. EC7-LM65-HPC-CNT = liquid metal elastomer with 65 vol.% liquid metal, when 20 wt.% HPC in deionized water mixed with small amount of MWCNT-COOH is also added. EC7-LM55-CNT0.75 = same as above, but 55 vol.% liquid metal EC7-LM5, LM45, LM45-CNT0.75 = 5 vol.% liquid metal, 45 vol.% liquid metal, and 45 vol.% liquid metal with 0.75 wt.% MWCNT-COOH. TGA was conducted with NETZSCH STA 449F3 Jupiter over temperature range of 30-900°C in nitrogen atmosphere with heating rate of 10 °C min⁻'. The data was collected on the second heating process after eliminating the thermal history.

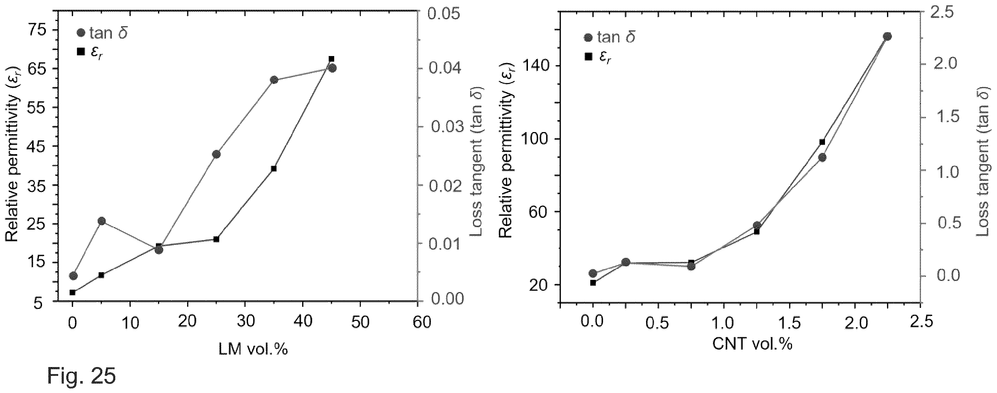

Figure 25 shows dielectric properties of liquid metal elastomers. Relative permittivity and loss tangent measured at frequency of 1 MHz when plotted as a function of liquid metal and CNT volume loading. The amount of liquid metal was fixed to 25 vol.% when the amount of CNT was varied.

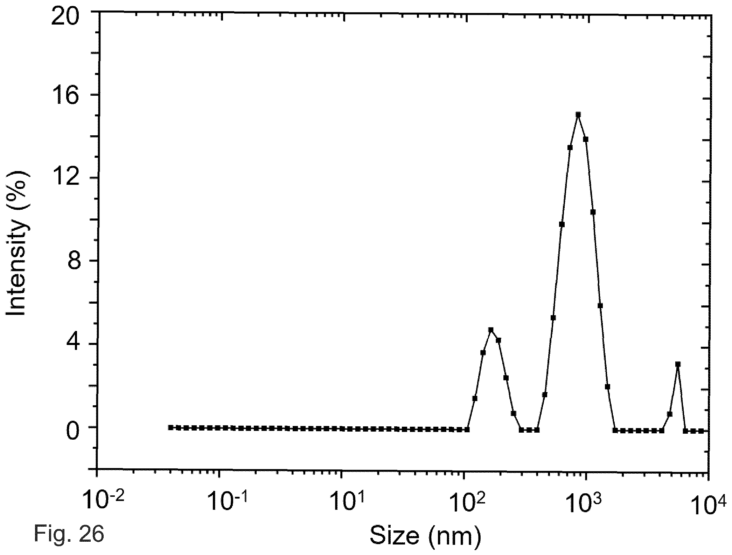

Figure 26 shows particle size analysis. The particle size distribution was measured with Zetasizer Nano ZS for the liquid metal mixture diluted in a solvent.

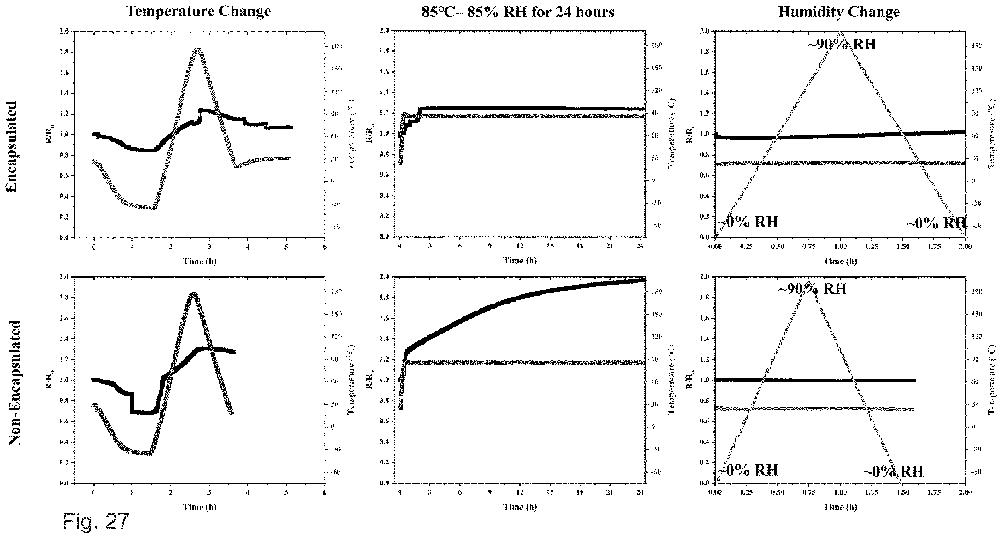

Figure 27 shows resistance measurements of liquid metal elastomers in the environmental chamber. $R/R_0$ plotted as a function of time for encapsulated and non-encapsulated EC7-LM65-CNT0.75 conductors on EC7 self-healing elastomer (65 vol.% liquid metal and 0.75 wt.% of MWCNT-COOH):

- when first cooled from RT (25 °C) to -50 °C, then heated to 180 °C, and finally cooled back to 30 °C.
- when the temperature and relative humidity was first increased to 85 °C and 85%, respectively, and then kept for 24 hours
- when temperature was kept at RT, and the relative humidity was increased from 0 to 90%

Figure 28 shows tensile properties of liquid metal elastomers. Stress-strain curves for pristine EC7-LM45-CNT elastomers (45 vol.% liquid metal) when the amount of MWCNT-COOH was varied from 0.25 to 2.25 vol.%.

Figure 29 shows tensile properties of liquid metal elastomers. Stress-strain curves for pristine and self-healed EC7-LM45-CNT elastomers (45 vol.% liquid metal) when the amount of CNT was varied from 0.25 to 2.25 vol.%.

Figure 30 shows a self-healing display made with surface mountable light emitting diodes.

Figure 31 shows $\Delta R/R_0$ measured as a function of uniaxial tensile strain for EC7-LM-CNT elastomer composites as the volume of liquid metal was increased from 55 to 65 vol.%. The printing and lasering directions are indicated with the abbreviations W, VH, HV, HH, where V indicates vertical, and H indicates horizontal. The first letter indicates the printing direction.

Example 7: Use of hatching tool for laser sintering and/ or for three-dimensional patterning

A specific hatching tool in LPKF Protolaser U3 laser processing system was used for both two- and three-dimensional patterning of the autonomously self-healing elastomers.

Self-healing liquid metal composite films were prepared on a donor substrate, cured by heating at 70°C for 30 minutes and provided to LPKF Protolaser U3 laser processing system and processed with the hatching tool. Unnecessary portions and debris from the laser-processed films were removed mechanically.

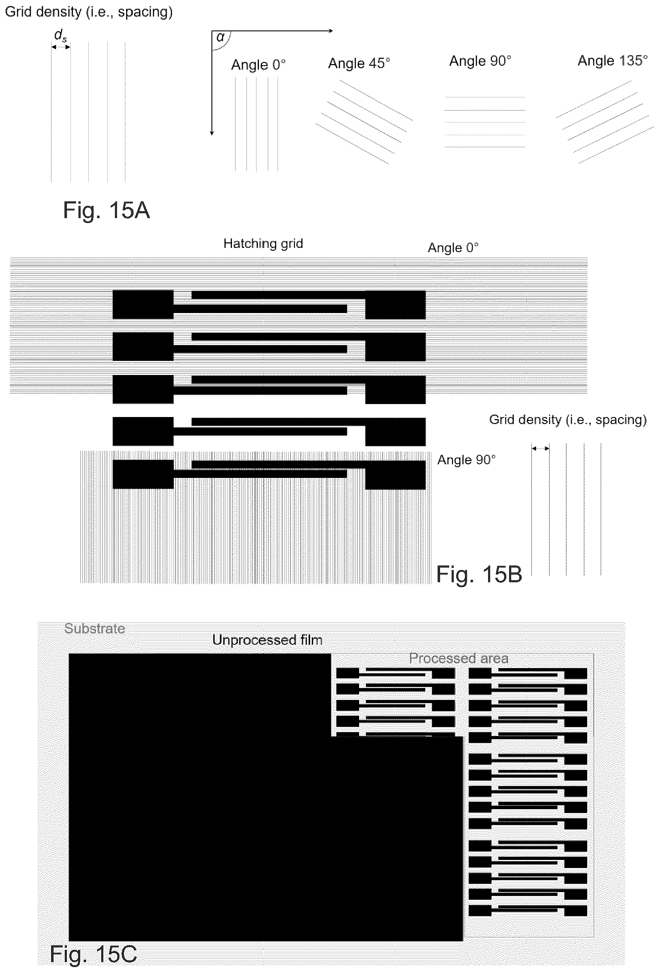

The tool forms automatically a grid inside the patterned area (Figures 15A-C), on which the line density can be further adjusted (i.e., spacing in the grid), and the orientation of the grid in relation to the pattern (by adjusting the angle). Now, the advantage of the hatching tool is that when the film is processed with the laser beam, the beams move from one line to another in orderly fashion. This is the main difference to the use of cutting or drilling tools, where the beam movement cannot be controlled and is completely random. Thus, the hatching tool is extremely effective for engraving the surface of the autonomously self-healing materials for achieving three-dimensional patterns or achieving laser sintering of ECLME films.

The hatching tool could be also used for complete removal of material in order to make two-dimensional patterns to the continuous films. However, controlling the quality and fidelity of the patterns was more difficult, and the result was highly dependent on the thickness of the films. Upon complete removal of material from the films, the hatching tool easily caused thermal damage which resulted in melting and decomposition. Thus, accumulation of residue and debris on the patterned areas is likely to contaminate the surface. This could be reduced to a certain degree by carefully controlling the laser processing parameters, but small amount of residue was always left onto the films upon complete removal of the film from carrier substrate.

The considerable limitation of the LPKF Protolaser U3 is that if the patterned and/or laser sintered area is larger than 49.9 mm in any dimension, the patternable area will be automatically divided into multiple sections that are equal in size. These sections will be then processed one by one by hatching tool. This can lead to significant issues with the laser sintered ECLME film that require complete sintering of the pattern as there can be small gaps between individual sections which are not properly sintered. This slightly increases the total resistance of the conductive pattern. However, the problem can be avoided, for example, if the soft electronics wiring layout is designed in a way that takes into account this limitation, or if the laser system allows larger area to be processed at once.

Generally, use of cutting or drilling tools for laser sintering or three-dimensional patterning is not suggested as the beam moves randomly around the film. This can lead to difficulties in achieving good quality three-dimensional patterns and effective laser sintering of the self-healing liquid metal elastomer composites.

Example 8: Two-dimensional patterning with hatching, cutting, or drilling tool

The two-dimensional patterning was possible with any of the tools available in the laser system (cutting, drilling, or hatching). However, cutting or drilling tools were found generally more suitable for two-dimensional patterning. Figure 16 shows an example of two-dimensional patterning with a cutting tool. Figure 18A and B show photographs of liquid metal elastomer patterns printed onto a self-healing substrate with a shadow mask. Figure 18A shows a simple design for testing function of LEDs in stretching.

After cutting the films, the areas of the films that are not needed were removed. This could be easily done by peeling the elastic autonomously self-healing elastomer films along the cut lines. This caused clean detachment of the films from both the patterned area of the film and the carrier substrate without any residue. The peeling and stretching of the films did not work if the materials were not elastic enough, and/or if they were too viscous for the removal, or if the adhesion to the carrier substrate was too strong. Thus, using a carrier substrate which is not adhering well to the materials was found essential when patterned films are cleaned afterwards, and transferred to another substrate from the donor/carrier substrate. Generally, non-silicone coated polyethylene terephthalate (PET) film works as a carrier substrate if the autonomously self-healing elastomers contained any amount of Triton™ X-100, and/or if the viscous nature of the materials was reduced by the composition to reduce the speed of self-healing (e.g., by reducing amount of $B_2O_3$ NPs, incorporation of carbon nanotubes). In other cases, DuPont™ Tedlar® polyvinyl fluoride release films (or similar) with excellent anti-stick properties could be used to avoid autonomously self-healing elastomer adhesion (if the layers are transferred afterwards).

Example 9: Preparation of multilayer structures

Self-healing, electrically conducting liquid metal composite films were prepared on an acceptor substrate, then cured by heating at 70°C for at least 30 minutes and provided to LPKF Protolaser U3 laser processing system. The patterned ECLME films were laser sintered and formed the contact pads and electrical wiring for connecting the sensor array to electronics. A self-healing piezoresistive blend film was prepared on a donor substrate and then patterned to form the sensing layers of the sensors. Unnecessary portions and debris from the laser-processed films were removed mechanically.

The second blend films were combined with the first film by releasing the laser-patterned film from its donor substrate and transferring the blend film on top of the second laser-patterned ECLME film, wherein the conductive parts of the film were connected to the electronics with FPC cable to connect the sensors. A multilayered sensor structure was obtained, which could be connected to a control unit and applied on skin or onto a textile to form wearable electronics.

As the layers are compatible with each other (i.e. they were based in same or similar chemical matrices or structure) they can be easily permanently attached to each other. One or more further layers could be added to the sensor array structure with the same principle, and even more complex functionalities could be obtained by adding one or more separate film structures on different acceptor substrate, or by adding more layers on top of the sensor array with suitable patterned films.

## Claims

1. A method for patterning a self-healing elastomer film, and/or for laser sintering and/or for improving electrical conductivity of a self-healing elastomer film, the method comprising

    - providing a programmable laser processing system,
    - providing a predetermined design model in a program code format for forming one or more patterns and/or treatments to program the laser processing system with the design model to cause the laser system to form the one or more patterns, sintering(s) and/or surface treatment(s) to an object when operated,
    - providing a self-healing elastomer film on a substrate,
    - at least partly curing, such as heating and/or crosslinking, the self-healing elastomer film, before processing with the laser, to obtain at least partly cured film,
    - providing the at least partly cured film to the laser processing system as the object,
    - treating the at least partly cured film with the laser processing system to partly or completely remove, such as evaporate and/or sublimate, solid elastomeric material from predetermined areas with the laser to form one or more patterns, sintering(s) and/or surface treatment(s) defined by the design model to the self-healing elastomer film, and/or to laser sinter and/or to remove oxide layer from a surface of the film to improve electrical conductivity of the self-healing elastomer film.

2. The method of claim 1 wherein the laser processing system is programmed to form hatch patterns on the self-healing elastomer film with a hatching tool, wherein the hatching tool is configured to move the laser beam as one line at the time in an orderly fashion to form of a hatched pattern with a plurality of the lines as the predetermined pattern to remove material from the film on the hatched pattern.

3. The method of claim 1 or 2, wherein the self-healing elastomer film comprises a self-healing liquid metal elastomer composite film, preferably wherein the method is a method for laser sintering and/or for improving electrical conductivity of a self-healing liquid metal elastomer composite film.

4. The method of any of preceding claims, wherein the self-healing elastomer film comprises an elastomeric matrix comprising a polyborosiloxane-based polymer and a polydimethylsiloxane-based polymer.

5. The method of any of preceding claims, wherein the self-healing elastomeric film comprises a self-healing electrically conducting elastomer composite film (22), such as a multiphase film, comprising:

    - an elastomer matrix, preferably comprising a polymer blend with one or more electrically insulating phase(s) having a phase-separated structure with localized heterogeneity, and
    - 55% or more by volume, such as 55-90% by volume, for example 60-90% by volume, of liquid metals comprising gallium as main phase, such as comprising gallium and indium, for example comprising a eutectic gallium-indium mixture in a Ga:In ratio by weight of 68.3-99.0:1.0-31.7.

6. The method of any of preceding claims, wherein the self-healing elastomer film provided for laser treatment is non-patterned or pre-patterned by printing.

7. The method of any of preceding claims, wherein the thickness of the self-healing elastomer film provided for laser treatment is in the range of 1-1000 $\mu$m, such as in the range of 5-100 $\mu$m.

8. The method of any of preceding claims, wherein the substrate is selected from a donor substrate, an acceptor substrate, or a part of a final product where to the self-healing elastomer is prepared for, such as wherein the donor substrate is a release substrate used for transferring the processed film to another substrate and/or a final product, and/or wherein the acceptor substrate comprises a self-healing elastomer and/or wherein the acceptor substrate is a part of the final product.

9. The method of any of preceding claims, comprising removing unnecessary portions from the laser-processed material, such as during laser treatment and/or after laser treatment, for example, by mechanically removing the unnecessary portions.

10. The method of any of preceding claims, comprising releasing the laser-treated film from the substrate and transferring the released and laser-treated film to another substrate and/or to a product, such as to obtain a multilayer structure, for example, comprising two or more laser-treated films.

11. A patterned, laser sintered and/or electrical conductivity-improved self-healing film obtained with the method of any of preceding claims, such as a laser sintered and/or an electrical conductivity-improved self-healing liquid metal elastomer composite film.

12. The patterned, laser sintered and/or electrical conductivity-improved self-healing liquid metal elastomer film of claim 11 having an electrical conductivity of 800 S cm$^{-1}$ or more, such as in the range of 800-14000 S cm$^{-1}$.

13. A multi-layer film comprising one or more of the patterned, laser sintered and/or electrical conductivity-improved self-healing elastomer films of claim 11 or 12.

14. An electrical device comprising one or more of the patterned, laser sintered and/or electrical conductivity-improved self-healing liquid metal elastomer films of claim 11 or 12, or one or more of the multi-layer films of claim 13.

15. Use of a programmable laser processing system for patterning a self-healing elastomer film, for laser sintering a self-healing elastomer film and/or for improving electrical conductivity of a self-healing elastomer film with the method of any of claims 1-10, preferably to obtain the patterned, laser sintered and/or electrical conductivity-improved self-healing liquid metal elastomer film of claim 11 or 12.

Fig. 1

Fig. 2

Fig. 3

Fig. 4

Fig. 5

| 10 μm | EHT = 15.00 kV | Signal A = SE2 | Date :29 Nov 2023 | ZEISS |
|---|---|---|---|---|
| | WD = 9.5 mm | Mag = 5.00 K X | 40p-pristine-04.tif | |

Fig. 6

| 100 μm | EHT = 15.00 kV | Signal A = SE2 | Date :29 Nov 2023 | ZEISS |
|---|---|---|---|---|
| | WD = 8.9 mm | Mag = 250 X | 60p-CNT-film-02.tif | |

Fig. 7

| 100 µm | EHT = 15.00 kV | Signal A = SE2 | Date :29 Nov 2023 | |
|---|---|---|---|---|
| | WD = 8.9 mm | Mag = 250 X | 60p-pristine-film-01.tif | ZEISS |

Fig. 8

| 100 µm | EHT = 15.00 kV | Signal A = SE2 | Date :29 Nov 2023 | |
|---|---|---|---|---|
| | WD = 8.8 mm | Mag = 500 X | 50p-HPC--film-06.tif | ZEISS |

Fig. 9

Fig. 10

Fig. 11

Fig. 12

Fig. 13

Fig. 14A    Frequency (kHz)     B   Number of repetitions

$y = 297.02\ln(x) - 486.8$

Grid density (i.e., spacing)

$d_s$

$\alpha$

Angle 0°    Angle 45°    Angle 90°    Angle 135°

## Fig. 15A

Hatching grid    Angle 0°

Grid density (i.e., spacing)

Angle 90°

## Fig. 15B

Substrate

Unprocessed film

Processed area

## Fig. 15C

Fig. 16

0.75 vol.% CNT

A

65.0 vol.% LM

C

Fig. 17

Fig. 18A

Fig. 18B

Fig. 19

Fig. 20

Fig. 21

Fig. 22

Fig. 23

Fig. 24

Fig. 25

Fig. 26

Fig. 27

Fig. 28

Fig. 29

Fig. 30

Fig. 31

Europäisches
Patentamt

European
Patent Office

Office européen
des brevets

## EUROPEAN SEARCH REPORT

**Application Number**

EP 24 19 7471

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | KAVEH ALIZADEH: "Robust and Multifunctional Liquid-Metal Embedded Elastomers for Ultrastretchable Electronics: a Short Review", ARXIV.ORG, CORNELL UNIVERSITY LIBRARY, 201 OLIN LIBRARY CORNELL UNIVERSITY ITHACA, NY 14853, 15 April 2021 (2021-04-15), XP081938686, | 1-3,5-15 | INV. H05K1/02 |
| Y | * Sections 5.6, 6, 6.1 * * figures 16-19 * & MARKVICKA ERIC J ET AL: "An autonomously electrically self-healing liquid metal-elastomer composite for robust soft-matter robotics and electronics", NATURE MATERIALS, NATURE PUBLISHING GROUP UK, LONDON, vol. 17, no. 7, 21 May 2018 (2018-05-21), pages 618-624, XP036533553, ISSN: 1476-1122, DOI: 10.1038/S41563-018-0084-7 [retrieved on 2018-05-21] * page 618, column 2, paragraph 2 * * last page, Methods/Fabrication * ----- | 4 | |
| Y | WANG HENGHUI ET AL: "A Self-Healing Substrate for Liquid-Metal Based Wearable Sensor", 2024 25TH INTERNATIONAL CONFERENCE ON ELECTRONIC PACKAGING TECHNOLOGY (ICEPT), IEEE, 7 August 2024 (2024-08-07), pages 1-5, XP034705156, DOI: 10.1109/ICEPT63120.2024.10668410 [retrieved on 2024-09-23] * page 1, last paragraph * * page 3, column 1, last paragraph - column 2, paragraph 1 * ----- -/-- | 4 | **TECHNICAL FIELDS SEARCHED (IPC)**<br><br>H05K |

The present search report has been drawn up for all claims

| Place of search | Date of completion of the search | Examiner |
|---|---|---|
| The Hague | 18 February 2025 | Dardel, Blaise |

EPO FORM 1503 03.82 (P04C01)

**EP 4 704 494 A1**

Europäisches
Patentamt

European
Patent Office

Office européen
des brevets

**EUROPEAN SEARCH REPORT**

**Application Number**

**EP 24 19 7471**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | JINWOO MA ET AL: "Shaping a Soft Future: Patterning Liquid Metals", ADVANCED MATERIALS, VCH PUBLISHERS, DE, vol. 35, no. 19, 9 March 2023 (2023-03-09), page n/a, XP072501639, ISSN: 0935-9648, DOI: 10.1002/ADMA.202205196 * sections 3.6.6, 4.3.1 * ----- | 1-15 | |
| A | ZHANG, YINGYUE ET AL.: "Chameleon-inspired tunable multi-layered infrared-modulating system via stretchable liquid metal microdroplets in elastomer film", NATURE COMMUNICATIONS, vol. 15, no. 1, 26 June 2024 (2024-06-26), pages 1-13, XP002813014, London DOI: https://doi.org/10.1038/s41467-024-49849-y * figure 5 * * pages 9-10, 12 * ----- | 1-15 | |

TECHNICAL FIELDS SEARCHED (IPC)

The present search report has been drawn up for all claims

| Place of search | Date of completion of the search | Examiner |
|---|---|---|
| The Hague | 18 February 2025 | Dardel, Blaise |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

 

& : member of the same patent family, corresponding document

EPO FORM 1503 03.82 (P04C01)